(19) Europäisches Patentamt
European Patent Office
Office européen des brevets

(11) EP 4 372 014 A1

(12) EUROPEAN PATENT APPLICATION
published in accordance with Art. 153(4) EPC

(43) Date of publication:
**22.05.2024 Bulletin 2024/21**

(21) Application number: **22842080.8**

(22) Date of filing: **11.07.2022**

(51) International Patent Classification (IPC):
***C08F 12/02*** (2006.01) ***C08F 20/18*** (2006.01)
***G03F 7/038*** (2006.01) ***G03F 7/039*** (2006.01)
***G03F 7/20*** (2006.01)

(52) Cooperative Patent Classification (CPC):
**C08F 12/02; C08F 20/18; G03F 7/038; G03F 7/039; G03F 7/20**

(86) International application number:
**PCT/JP2022/027257**

(87) International publication number:
**WO 2023/286736 (19.01.2023 Gazette 2023/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **14.07.2021 JP 2021116453**

(71) Applicant: **FUJIFILM Corporation**
**Tokyo 106-8620 (JP)**

(72) Inventors:
- **MARUMO Kazuhiro**
  **Haibara-gun, Shizuoka 421-0396 (JP)**
- **TAKAHASHI Satomi**
  **Haibara-gun, Shizuoka 421-0396 (JP)**
- **ISHIJI Yohei**
  **Haibara-gun, Shizuoka 421-0396 (JP)**
- **SHIRAKAWA Michihiro**
  **Haibara-gun, Shizuoka 421-0396 (JP)**
- **GOTO Akiyoshi**
  **Haibara-gun, Shizuoka 421-0396 (JP)**

(74) Representative: **HGF**
**HGF Limited**
**1 City Walk**
**Leeds LS11 9DX (GB)**

# (54) PATTERN FORMATION METHOD AND METHOD FOR PRODUCING ELECTRONIC DEVICE

(57) The present invention provides a pattern forming method that enables the formation of a pattern excellent in resolution and evenness and a method for producing an electronic device. The pattern forming method according to the present invention includes a resist film-forming step of forming a resist film using an actinic ray-sensitive or radiation-sensitive resin composition that undergoes an increase in the degree of solubility in an organic solvent due to action of exposure, acid, base, or heating, an exposure step of exposing the resist film, and a developing step of developing the exposed resist film with a developer including an organic solvent. The organic solvent includes an ester-based solvent having 6 or less carbon atoms and a hydrocarbon-based solvent.

EP 4 372 014 A1

## Description

## BACKGROUND OF THE INVENTION

1. Field of the Invention

The present invention relates to a pattern forming method and a method for producing an electronic device.

2. Description of the Related Art

Since the advent of a resist for KrF excimer laser (wavelength 248 nm), a pattern forming method utilizing chemical amplification has been used in order to compensate for a decrease in sensitivity due to light absorption. For example, in a positive chemical amplification method, first, a photoacid generator included in regions to be exposed is decomposed by light irradiation to generate acid. Subsequently, in a process of baking after exposure (PEB: Post Exposure Bake) or the like, for example, an alkali-insoluble group of a resin included in an actinic ray-sensitive or radiation-sensitive resin composition is changed, by the catalytic action of the generated acid, to an alkali-soluble group to change the solubility in a developer. Development is then performed using, for example, a basic aqueous solution. Thus, exposed regions are removed to obtain a desired pattern.

In order to miniaturize semiconductor elements, the wavelengths of exposure light sources have been shortened and the numerical apertures (NAs) of projection lenses have been increased, and currently, exposure apparatuses using ArF excimer laser having a wavelength of 193 nm as light sources have been developed. Furthermore, in recent years, pattern forming methods using extreme ultraviolet rays (EUV light: Extreme Ultraviolet) and an electron beam (EB: Electron Beam) as light sources are also being studied.

Under such circumstances, many pattern forming methods using an actinic ray-sensitive or radiation-sensitive resin composition have been proposed.

For example, WO2017/002737A discloses a positive pattern forming method including a step (1) of forming a film using an actinic ray-sensitive or radiation-sensitive resin composition that includes a predetermined component and undergoes an increase in the degree of solubility in organic solvents due to action of exposure, a step (2) of exposing the film, and a step (3) of, after the exposure, performing development with a developer including an organic solvent in this order.

## SUMMARY OF THE INVENTION

The inventors of the present invention have studied the pattern forming method described in WO2017/002737A and have found that it is difficult to achieve both resolution and evenness of a pattern to be formed. The "evenness of a pattern" means that, in a pattern obtained by performing development while rotating a substrate having an exposed resist film, the variation between a pattern width of a central portion of the resist film and a pattern width of an outer peripheral portion of the resist film is small.

Accordingly, an object of the present invention is to provide a pattern forming method that enables the formation of a pattern excellent in resolution and evenness.

Another object of the present invention is to provide a method for producing an electronic device, the method using the pattern forming method.

As a result of intensive studies to achieve the above obj ects, the inventors of the present invention have found that the following configurations enable achievement of the above-described objects.

[1] A pattern forming method including a resist film-forming step of forming a resist film using an actinic ray-sensitive or radiation-sensitive resin composition that undergoes an increase in a degree of solubility in an organic solvent due to action of exposure, acid, base, or heating;

an exposure step of exposing the resist film; and
a developing step of developing the exposed resist film with a developer including an organic solvent,
wherein the organic solvent includes an ester-based solvent having 6 or less carbon atoms and a hydrocarbon-based solvent.

[2] The pattern forming method according to [1], wherein the hydrocarbon-based solvent has 9 to 11 carbon atoms.
[3] The pattern forming method according to [1] or [2], wherein the hydrocarbon-based solvent includes at least one selected from the group consisting of nonane, decane, and undecane.
[4] The pattern forming method according to any one of [1] to [3], wherein the composition satisfies a requirement

C1 or a requirement C2 below.

Requirement C1: The composition includes a resin Z1 having a group that decreases polarity due to action of exposure, acid, base, or heating.
Requirement C2: The composition includes a resin Z2 having a polar group, and a compound that reacts with the polar group due to action of exposure, acid, base, or heating.

[5] The pattern forming method according to any one of [1] to [3], wherein the composition satisfies a requirement X or a requirement Y below.

Requirement X: The composition includes a resin X1 that undergoes a decrease in molecular weight caused by scission of a main chain due to action of exposure, acid, base, or heating and satisfies at least one of requirements A1 to A3 below.

Requirement A1: The resin X1 has a group that decreases polarity due to action of exposure, acid, base, or heating.
Requirement A2: The resin X1 has an interactive group that forms an interaction with an onium salt compound and that is released from the interaction due to action of exposure, acid, base, or heating, and the composition further includes an onium salt compound.
Requirement A3: The resin X1 has a polar group, and the composition further includes a compound that reacts with the polar group due to action of exposure, acid, base, or heating.

Requirement Y: The composition includes a resin Y1 that undergoes a decrease in molecular weight caused by scission of a main chain due to action of exposure, acid, base, or heating and a resin Y2 other than the resin Y1 and satisfies at least one of requirements B1 to B3 below.

Requirement B1: The resin Y2 has a group that decreases polarity due to action of exposure, acid, base, or heating.
Requirement B2: The resin Y2 has an interactive group that forms an interaction with an onium salt compound and that is released from the interaction due to action of exposure, acid, base, or heating, and the composition further includes an onium salt compound.
Requirement B3: The resin Y2 has a polar group, and the composition further includes a compound that reacts with the polar group due to action of exposure, acid, base, or heating.

[6] The pattern forming method according to [5], wherein the group that decreases polarity is a group that decreases polarity due to action of acid.
[7] The pattern forming method according to [6], wherein the group that decreases polarity is a functional group represented by Formula (KD1) described later, a monovalent functional group formed by removing one hydrogen atom that one or more of $R^{d5}$ to $R^{d10}$ in a compound represented by Formula (KD2) described later have, or a monovalent functional group formed by removing one hydrogen atom that a ring member atom has in any of a ring formed by bonding $R^{d6}$ and $R^{d7}$ together and a ring formed by bonding $R^{d8}$ and $R^{d9}$ together in the compound represented by Formula (KD2) described later.
[8] The pattern forming method according to [6], wherein the group that decreases polarity is an acid-decomposable group having a structure in which a polar group is protected with a protective group that leaves due to action of acid, and a logP of the acid-decomposable group is smaller than a logP of the polar group.
[9] The pattern forming method according to [5], wherein the interactive group is one or more functional groups selected from the group consisting of a phenolic hydroxy group, a carboxyl group, a sulfonic group, an amide group, and a sulfonamide group.
[10] The pattern forming method according to [5], wherein the polar group is one or more functional groups selected from the group consisting of an alcoholic hydroxy group, a phenolic hydroxy group, and a carboxyl group.
[11] The pattern forming method according to [10], wherein the compound that reacts with the polar group is a compound selected from the group consisting of a tertiary alcohol, a tertiary ether, an epoxide, a vinyl ether, an olefin, a benzyl ether, benzyl alcohol, and a carboxylic acid.
[12] The pattern forming method according to [5], wherein the group that decreases polarity is an onium salt group that is decomposed due to action of exposure, the onium salt group being selected from the group consisting of a group represented by Formula (O1) described later and a group represented by Formula (O2) described later.
[13] The pattern forming method according to any one of [5] to [12], wherein the resin X1 includes a repeating unit represented by Formula (XP) described later and a repeating unit represented by Formula (XQ) described later.

[14] The pattern forming method according to any one of [5] to [12], wherein the resin X1 includes a moiety represented by Formula (XR0) described later in a main chain structure.

[15] The pattern forming method according to [14], wherein the resin X1 includes a repeating unit represented by Formula (XR) described later.

[16] The pattern forming method according to any one of [5] to [12], wherein the resin X1 includes a repeating unit represented by Formula (XS) described later.

[17] A method for producing an electronic device, the method including the pattern forming method according to any one of [1] to [16].

The present invention can provide a pattern forming method that enables the formation of a pattern excellent in resolution and evenness.

In addition, the present invention can provide a method for producing an electronic device, the method using the pattern forming method.

## DESCRIPTION OF THE PREFERRED EMBODIMENTS

The present invention will be described in detail below.

The constituent features described below may be described based on representative exemplary embodiments of the present invention; however the present invention is not limited to such exemplary embodiments.

With respect to expressions of groups (atomic groups) in the present specification, unless otherwise specified, an expression without the term of substituted or unsubstituted encompasses groups having no substituent and also groups having a substituent. For example, "alkyl group" encompasses not only an alkyl group having no substituent (unsubstituted alkyl group) but also an alkyl group having a substituent (substituted alkyl group). In the present specification, "organic group" refers to a group including at least one carbon atom.

The substituent is preferably a monovalent substituent unless otherwise specified.

In the present specification, "actinic ray" or "radiation" means, for example, an emission-line spectrum of a mercury lamp, far ultraviolet rays represented by an excimer laser, extreme ultraviolet rays (EUV light: Extreme Ultraviolet), X-rays, or an electron beam (EB: Electron Beam). In the present specification, "light" means an actinic ray or a radiation.

In the present specification, "exposure" includes, unless otherwise specified, not only exposure with, for example, an emission-line spectrum of a mercury lamp, far ultraviolet rays represented by an excimer laser, extreme ultraviolet rays, X-rays, or EUV light but also patterning with an electron beam or a corpuscular beam such as an ion beam.

In the present specification, a range of numerical values expressed with "to" mean a range that includes a numerical value before "to" as a lower limit value and a numerical value after "to" as an upper limit value.

The bonding direction of a divalent group expressed in the present specification is not limited unless otherwise specified. For example, in a compound represented by a formula "X-Y-Z" where Y is -COO-, Y may be -CO-O- or -O-CO-. Furthermore, the compound may be "X-CO-O-Z" or "X-O-CO-Z".

In the present specification, (meth) acrylate represents acrylate and methacrylate, and (meth) acryl represents acryl and methacryl.

In the present specification, a weight-average molecular weight (Mw), a number-average molecular weight (Mn), and a dispersity (hereinafter, also referred to as a "molecular weight distribution") (Mw/Mn) of a resin are defined as polystyrene equivalent values determined, using a GPC (Gel Permeation Chromatography) apparatus (HLC-8120GPC, manufactured by Tosoh Corporation), by GPC measurement (solvent: tetrahydrofuran, amount of flow (amount of sample injected): 10 μL, column: TSK gel Multipore HXL-M (manufactured by Tosoh Corporation), column temperature: 40°C, flow rate: 1.0 mL/min, detector: differential refractive index detector (Refractive Index Detector)).

In the present specification, the acid dissociation constant (pKa) represents pKa in an aqueous solution, and specifically, is a value determined by calculation using the following software package 1 on the basis of the Hammett's substituent constants and the database of values in publicly known documents. All the values of pKa described in the present specification are values determined by calculation using this software package.

Software package 1: Advanced Chemistry Development (ACD/Labs) Software V8.14 for Solaris (1994-2007 ACD/Labs)

Alternatively, pKa can also be determined by a molecular orbital calculation method. A specific method thereof may be a method of achieving the determination by calculating $H^+$ dissociation free energy in an aqueous solution on the basis of a thermodynamic cycle. With regard to the method of calculating $H^+$ dissociation free energy, the calculation can be performed by, for example, DFT (density functional theory); however, various other methods have been reported in documents etc., and the method is not limited to this. Note that there are a plurality of pieces of software capable of performing DFT; for example, Gaussian 16 may be used.

As described above, pKa in the present specification refers to a value determined by calculation using the software package 1 on the basis of the Hammett's substituent constants and the database of values in publicly known documents; however, when pKa cannot be calculated by this method, a value determined using Gaussian 16 on the basis of DFT (density functional theory) is employed.

In addition, as described above, pKa in the present specification refers to "pKa in an aqueous solution"; however, when pKa in an aqueous solution cannot be calculated, "pKa in a dimethyl sulfoxide (DMSO) solution" is employed.

In the present specification, examples of halogen atoms include a fluorine atom, a chlorine atom, a bromine atom, and an iodine atom.

In the present specification, "solid content" means a component forming a resist film and does not include solvents. Even when a component has the form of liquid, the component is regarded as a solid content as long as it is a component forming the resist film.

A values of logP (octanol/water partition coefficient) given in the present specification is a value calculated using ChemBioDraw Ultra (Version16.0.14) unless otherwise specified. Pattern Forming Method

A pattern forming method includes a resist film-forming step of forming a resist film using an actinic ray-sensitive or radiation-sensitive resin composition (hereinafter, also referred to as a "resist composition") that undergoes an increase in the degree of solubility in an organic solvent due to action of exposure, acid, base, or heating;

an exposure step of exposing the resist film; and
a developing step of developing the exposed resist film with a developer including an organic solvent,
in which the organic solvent includes an ester-based solvent having 6 or less carbon atoms and a hydrocarbon-based solvent.

Hereinafter, the developer including an ester-based solvent having 6 or less carbon atoms and a hydrocarbon-based solvent is also referred to as a "specific developer".

The mechanism by which a pattern formed by the pattern forming method has excellent resolution and excellent evenness is not necessarily clear, but the inventors of the present invention presume as follows.

A feature of the pattern forming method according to the present invention lies in the use of the specific developer. The specific developer includes predetermined two or more organic solvents. It is presumed that since the predetermined two or more organic solvents are included, the swelling of the resulting pattern is suppressed to improve resolution, and the variation in the drying rate of the developer is suppressed to obtain a pattern having excellent evenness.

Hereinafter, providing a better effect of at least one of resolution or evenness is also referred to as "providing a better effect of the present invention".

The pattern forming method preferably includes the resist film-forming step, the exposure step, and the developing step in this order. The pattern forming method may include other steps described later in addition to the above steps.

Each step in the pattern forming method will be described in detail below.

Resist Film-Forming Step

The resist film-forming step is a step of forming a resist film using a resist composition.

The method for forming a resist film using a resist composition is, for example, a method of applying a resist composition onto a substrate. The resist composition is as described below.

The method of applying the resist composition onto a substrate may be, for example, a method in which the resist composition is applied onto a substrate (for example, silicon or the like) used in the manufacture of a semiconductor device such as an integrated circuit using a device such as a spinner or a coater.

The coating method is preferably spin coating using a spinner. The rotational speed during spin coating is preferably 1,000 to 3,000 rpm.

The substrate coated with the resist composition may be dried to form a resist film.

The drying method may be, for example, a method of performing heating. The heating may be performed using means included in a publicly known exposure apparatus and/or a publicly known developing apparatus, or may be performed using a hot plate.

The heating temperature is preferably 80°C to 150°C, more preferably 80°C to 140°C, still more preferably 80°C to 130°C. The heating time is preferably 30 to 1,000 seconds, more preferably 30 to 800 seconds, still more preferably 40 to 600 seconds. The heating may be performed once or twice or more.

The thickness of the resist film is preferably 10 to 90 nm, more preferably 10 to 65 nm, still more preferably 15 to 50 nm from the viewpoint that a fine pattern with higher accuracy can be formed.

In addition, an underlying film (for example, an inorganic film, an organic film, or an antireflection film) may be formed between the substrate and the resist film.

An underlying film-forming composition preferably includes a publicly known organic material or a publicly

known inorganic material.

The thickness of the underlying film is preferably 10 to 90 nm, more preferably 10 to 50 nm, still more preferably 10 to 30 nm.

Examples of the underlying film-forming composition include AL412 (manufactured by Brewer Science, Inc.) and SHB series (for example, SHB-A940, manufactured by Shin-Etsu Chemical Co., Ltd.).

A topcoat may be formed on a surface of the resist film on a side opposite from the substrate using a topcoat composition.

Preferably, the topcoat composition does not mix with the resist film and can be uniformly applied to the surface of the resist film on the side opposite from the substrate.

The topcoat composition preferably includes a resin, an additive, and a solvent.

Examples of the method for forming a topcoat include publicly known methods for forming a topcoat, and specific examples thereof include methods for forming a topcoat described in paragraphs [0072] to [0082] of JP2014-059543A.

The method for forming a topcoat preferably includes forming a topcoat including a basic compound described in JP2013-061648A on the surface of the resist film on the side opposite from the substrate. Examples of the basic compound also include basic compounds described in WO2017/002737A.

It is also preferable that the topcoat include a compound having at least one selected from the group consisting of -O-, -S-, a hydroxy group, a thiol group, -CO-, and -COO-.

Exposure Step

The exposure step is a step of exposing the resist film.

The exposure step is preferably a step of performing pattern exposure through a photo mask.

The photo mask may be, for example, a publicly known photo mask. The photo mask may be in contact with the resist film.

Examples of exposure light for exposing the resist film include infrared light, visible light, ultraviolet light, far ultraviolet light, extreme ultraviolet light (EUV), X-rays, and electron beams.

The exposure light preferably has a wavelength of 250 nm or less, more preferably has a wavelength of 220 nm or less, and still more preferably has a wavelength of 1 to 200 nm. Specifically, KrF excimer laser (wavelength 248 nm), ArF excimer laser (wavelength 193 nm), $F_2$ excimer laser (wavelength 157 nm), X-rays, EUV (wavelength 13 nm), or an electron beam is preferred, KrF excimer laser, ArF excimer laser, EUV, or an electron beam is more preferred, and EUV or an electron beam is still more preferred.

The exposure dose is not particularly limited as long as the degree of solubility of the exposed resist film in an organic solvent is increased.

The exposure method in the exposure step may be liquid immersion exposure.

The exposure step may be performed once or twice or more.

After the exposure step, post exposure bake (PEB) may be performed before the developing step described below.

The heating temperature of the post exposure bake is preferably 80°C to 150°C, more preferably 80°C to 140°C, still more preferably 80°C to 130°C. The heating time is preferably 10 to 1,000 seconds, more preferably 10 to 180 seconds, still more preferably 30 to 120 seconds.

The post exposure bake may be performed using means included in a publicly known exposure apparatus and/or developing apparatus, or may be performed using a hot plate. The post exposure bake may be performed once or twice or more.

Developing Step

The developing step is a step of developing the exposed resist film with a specific developer.

Specific Developer

The specific developer includes an ester-based solvent having 6 or less carbon atoms and a hydrocarbon-based solvent.

It is also preferable that the specific developer be composed only of an ester-based solvent having 6 or less carbon atoms and a hydrocarbon-based solvent.

Ester-Based Solvent Having 6 or Less Carbon Atoms

The specific developer includes an ester-based solvent having 6 or less carbon atoms.

The number of carbon atoms of the ester-based solvent having 6 or less carbon atoms is 6 or less. The lower limit is preferably 1 or more, more preferably 3 or more, still more preferably 5 or more.

Probably, in the case of using an ester-based solvent having 6 or less carbon atoms, the difference in boiling point from the hydrocarbon-based solvent included in the specific developer is larger than that in the case of using an ester-based solvent having 7 or more carbon atoms, and variation in the solvent ratio in the developer in a drying process becomes small, and therefore, the evenness of the pattern is excellent.

The ester-based solvent having 6 or less carbon atoms may have an alkyl group.

The alkyl group may be linear, branched, or cyclic and is preferably linear. The number of carbon atoms of the alkyl group is preferably 1 to 4.

The ester-based solvent having 6 or less carbon atoms has a heteroatom. The heteroatom is, for example, an oxygen atom, and it is preferable to have only an oxygen atom as the heteroatom.

The number of heteroatoms contained in the ester-based solvent having 6 or less carbon atoms is preferably 2 to 6, more preferably 2. The ester-based solvent having 6 or less carbon atoms may have one or two or more -COO- and preferably has only one -COO-.

Examples of ester-based solvents having 6 or less carbon atoms include butyl acetate, isobutyl acetate, methyl acetate, ethyl acetate, propyl acetate, isopropyl acetate, propylene glycol monomethyl ether acetate, ethylene glycol monoethyl ether acetate, methyl formate, ethyl formate, butyl formate, propyl formate, ethyl lactate, butyl lactate, propyl lactate, methyl 2-hydroxyisobutyrate, ethyl butyrate, and ethyl propionate. Butyl acetate or isobutyl acetate is preferred, and butyl acetate is more preferred.

Boiling points (NBP: normal boiling points) of ester-based solvents having 6 or less carbon atoms are preferably 100°C to 200°C, more preferably 100°C to 150°C, still more preferably 110°C to 130°C.

Such ester-based solvents having 6 or less carbon atoms may be used alone or in combination of two or more thereof.

The content of the ester-based solvent having 6 or less carbon atoms is more than 0 mass% and less than 100 mass%, preferably 50 to 99 mass%, more preferably 70 to 95 mass% relative to the total mass of the specific developer.

Hydrocarbon-Based Solvent

The specific developer includes a hydrocarbon-based solvent.

Examples of hydrocarbon-based solvents include an aliphatic hydrocarbon-based solvent and an aromatic hydrocarbon-based solvent. The aliphatic hydrocarbon-based solvent may be a saturated aliphatic hydrocarbon-based solvent or an unsaturated aliphatic hydrocarbon-based solvent, and is preferably a saturated aliphatic hydrocarbon-based solvent.

The number of carbon atoms of the hydrocarbon-based solvent is preferably 3 to 20, more preferably 8 to 12, still more preferably 9 to 11.

The aliphatic hydrocarbon-based solvent may be linear, branched, or cyclic, and is preferably linear. The aromatic hydrocarbon-based solvent may be monocyclic or polycyclic.

Examples of hydrocarbon-based solvents include saturated aliphatic hydrocarbon-based solvents such as pentane, hexane, octane, nonane, decane, undecane, dodecane, hexadecane, 2,2,4-trimethylpentane, and 2,2,3-trimethylhexane; and aromatic hydrocarbon-based solvents such as mesitylene, cumene, pseudocumene, 1,2,4,5-tetramethylbenzene, p-cymene, toluene, xylene, ethylbenzene, propylbenzene, 1-methylpropylbenzene, 2-methylpropylbenzene, dimethylbenzene, diethylbenzene, ethylmethylbenzene, trimethylbenzene, ethyldimethylbenzene, and dipropylbenzene.

The hydrocarbon-based solvent preferably includes a saturated aliphatic hydrocarbon-based solvent, more preferably includes at least one selected from the group consisting of octane, nonane, decane, undecane, and dodecane, and still more preferably includes at least one selected from the group consisting of nonane, decane, and undecane.

Boiling points (NBP: normal boiling points) of hydrocarbon-based solvents are preferably 100°C to 260°C, more preferably 120°C to 240°C, still more preferably 140°C to 220°C.

Such hydrocarbon-based solvents may be used alone or in combination of two or more thereof.

The content of the hydrocarbon-based solvent is more than 0 mass% and less than 100 mass%, preferably 1 to 50 mass%, more preferably 5 to 30 mass% relative to the total mass of the specific developer.

The mass ratio of the content of the ester-based solvent having 6 or less carbon atoms to the content of the hydrocarbon-based solvent (content of ester-based solvent having 6 or less carbon atoms/content of hydrocarbon-based solvent) is preferably 1 to 50, more preferably 3 to 20, still more preferably 7 to 15.

The total content of the ester-based solvent having 6 or less carbon atoms and the hydrocarbon-based solvent is preferably 10 to 100 mass%, more preferably 80 to 100 mass%, still more preferably 95 to 100 mass% relative to the total mass of the specific developer. Other Components

The specific developer may include other components in addition to the above components.

Examples of the other components include publicly known organic solvents other than those described above and publicly known surfactants.

The content of the surfactant is preferably 0.001 to 5 mass%, more preferably 0.005 to 2 mass%, still more preferably 0.01 to 0.5 mass% relative to the total mass of the specific developer.

Developing Method

The developing method may be, for example, a publicly known developing method.

Specific examples thereof include a method of immersing an exposed resist film for a predetermined time in a tank filled with the specific developer (dipping method), a method of puddling the specific developer over a surface of an exposed resist film using surface tension and allowing the specific developer to stand for a predetermined time to perform development (puddling method), a method of spraying the specific developer onto a surface of an exposed resist film (spraying method), and a method of continuously ejecting the specific developer over a substrate having an exposed resist film and rotating at a constant rate, while scanning a nozzle through which the specific developer is ejected at a constant rate (dynamic dispensing method).

After the developing step, a step of stopping the development using a solvent other than the specific developer may be performed.

The development time is preferably 10 to 300 seconds, more preferably 20 to 120 seconds.

The temperature of the specific developer during development is preferably 0°C to 50°C, more preferably 15°C to 35°C.

Other Steps

The pattern forming method may include other steps in addition to the above-described steps.

The other step may be, for example, a rinsing step.

Rinsing Step

The pattern forming method preferably includes, after the developing step, a rinsing step of performing washing with a rinsing liquid.

The rinsing liquid may be, for example, a publicly known organic solvent. The rinsing liquid may be the specific developer.

The rinsing liquid preferably includes at least one selected from the group consisting of a hydrocarbon-based solvent, a ketone-based solvent, an ester-based solvent, an alcohol-based solvent, an amide-based solvent, and an ether-based solvent.

Examples of the rinsing method include the dipping method, the puddling method, the spraying method, and the dynamic dispensing method in the developing method.

The pattern forming method may include a heating step (post bake) after the rinsing step. Through the heating step, the specific developer and the rinsing liquid remaining between patterns and inside patterns can be removed, and roughening of surfaces of the patterns can be suppressed.

The heating temperature in the heating step is preferably 40°C to 250°C, more preferably 80°C to 200°C. The heating time is preferably 10 to 180 seconds, more preferably 30 to 120 seconds.

Etching Step

The pattern forming method may include an etching step of etching the substrate using the formed pattern as a mask.

The etching method may be, for example, a publicly known etching method. Specific examples thereof include the methods described in Proceedings of International Society for Optics and Photonics (Proc. of SPIE), Vol. 6924, 692420 (2008), "Chapter 4 Etching" of "Semiconductor Process Textbook, 4th edition, issued in 2007, publisher: SEMI Japan", and JP2009-267112A.

Purification Step

The pattern forming method may include a purification step of purifying the resist composition, the specific developer, and/or various other components (for example, a rinsing liquid, an antireflection film-forming composition, and a topcoat-forming composition) used in the pattern forming method.
The purification method may be, for example, a publicly known purification method, and a method of filtration using a filter or a purification method using an adsorbing material is preferred.
The pore size of the filter is preferably less than 100 nm, more preferably 10 nm or less, still more preferably 5 nm or less. The lower limit is often 0.01 nm or more.
The material of the filter is preferably polytetrafluoroethylene, polyethylene, or nylon. The filter may be made of a composite material obtained by combining the above filter material and an ion exchange medium. The filter used may be a filter washed with an organic solvent in advance.
In the method of filtration using a filter, a plurality of types of filters may be connected in series or in parallel and used. When a plurality of types of filters are used, filters having different pore sizes and/or made of different materials may be used in combination. The substance to be purified may be filtered once or twice or more. In a method in which filtration is performed twice or more, the filtration may be performed while circulating.
In the method using an adsorbing material, only an adsorbing material may be used, or the above-described filter and an adsorbing material may be used in combination.
The adsorbing material may be a publicly known adsorbing material, and specific examples thereof include inorganic adsorbing materials such as silica gel and zeolite, and organic adsorbing materials such as activated carbon.
In the production of the resist composition, for example, it is preferable that each component such as a resin which can be included in the resist composition be dissolved in an organic solvent, and the resulting solution be then filtered while being circulated using a plurality of filters made of different materials. Specifically, it is preferable that a polyethylene filter having a pore size of 50 nm, a nylon filter having a pore size of 10 nm, and a polyethylene filter having a pore size of 3 nm be connected in order, and circulation filtration be performed 10 times or more.
The pressure difference between the filters is preferably small. Specifically, the pressure difference between the filters is preferably 0.1 MPa or less, more preferably 0.05 MPa or less, still more preferably 0.01 MPa or less. The lower limit is often more than 0 MPa.
The pressure difference between the filter and a filling nozzle is also preferably small. Specifically, the pressure difference is preferably 0.5 MPa or less, more preferably 0.2 MPa or less, still more preferably 0.1 MPa or less. The lower limit is often more than 0 MPa.
After the resist composition is filtered through a filter, the resist composition is preferably filled into a clean container. From the viewpoint of suppressing deterioration with time, the container filled with the resist composition is preferably stored under refrigeration. The time from the completion of filling of the resist composition into the container to the start of storage under refrigeration is preferably short. Specifically, the time is preferably within 24 hours, more preferably within 16 hours, still more preferably within 12 hours, particularly preferably within 10 hours.
The temperature during storage under refrigeration is preferably 0°C to 15°C, more preferably 0°C to 10°C, still more preferably 0°C to 5°C.
Preferably, the resist composition, the specific developer, and the other components do not include impurities.
Examples of impurities include metal impurities. Specific examples thereof include Na, K, Ca, Fe, Cu, Mg, Al, Li, Cr, Ni, Sn, Ag, As, Au, Ba, Cd, Co, Pb, Ti, V, W, and Zn.
The content of impurities in the resist composition relative to the total mass of the resist composition, the content of impurities in the specific developer relative to the total mass of the specific developer, or the content of impurities in another component relative to the total mass of the other component (for example, the content of impurities in a rinsing liquid relative to the total mass of the rinsing liquid) is preferably 1 mass ppm or less, more preferably 10 mass ppb or less, still more preferably 100 mass ppt or less, particularly preferably 10 mass ppt or less, most preferably 1 mass ppt or less. The lower limit is often 0 mass ppt or more.
The method for determining the impurities may be, for example, a publicly known measurement method such as ICP-MS (ICP mass spectrometry).
Examples of the method of reducing the content of impurities include the method of filtration using a filter, a method of selecting, as raw materials constituting various materials, raw materials having a low content of impurities, and a method of performing distillation under conditions in which contamination is minimized by, for example, lining the interior of apparatuses with Teflon (registered trademark).
Liquids including an organic solvent, such as the specific developer and the rinsing liquid, may include a conductive compound from the viewpoint of preventing failure of a chemical liquid pipe and various parts (such as a filter, an O-ring, and a tube) caused by electrostatic charging and electrostatic discharging.
The conductive compound is, for example, methanol. From the viewpoint of maintaining the developing performance or the rinsing performance, the content of the conductive compound in the specific developer relative to the

total mass of the specific developer, or the content of the conductive compound in the rinsing liquid relative to the total mass of the rinsing liquid is preferably 10 mass% or less, more preferably 5 mass% or less. The lower limit is often 0.01 mass% or more.

Examples of the chemical liquid pipe include various pipes made of SUS (stainless steel) or a material coated with polyethylene, polypropylene, or a fluororesin (such as polytetrafluoroethylene or a perfluoroalkoxy resin) subjected to antistatic treatment.

Examples of the filter and the O-ring include those made of a material coated with polyethylene, polypropylene, or a fluororesin (such as polytetrafluoroethylene or a perfluoroalkoxy resin) subjected to antistatic treatment.

Resist Composition

The resist composition is a composition that undergoes an increase in the degree of solubility in an organic solvent due to action of exposure, acid, base, or heating.

The resist composition is typically a positive resist composition and is a resist composition for organic solvent development. The resist composition is typically a chemically amplified resist composition.

A preferred embodiment of the resist composition is, for example, a resist composition satisfying a requirement X, a requirement Y, or a requirement Z.

The resist composition satisfying the requirement X includes a resin X1 that undergoes a decrease in molecular weight caused by scission of a main chain due to action of exposure, acid, base, or heating (hereinafter, also referred to as a "resin X1") and satisfies at least one of requirements A1 to A3 below.

Requirement A1: The resin X1 has a group that decreases polarity due to action of exposure, acid, base, or heating (hereinafter, also referred to as a "polarity-decreasing group").

Requirement A2: The resin X1 has an interactive group that forms an interaction with an onium salt compound and that is released from the interaction due to action of exposure, acid, base, or heating (hereinafter, also referred to as an "interactive group"), and the resist composition further includes an onium salt compound.

Requirement A3: The resin X1 has a polar group, and the resist composition further includes a compound that reacts with the polar group due to action of exposure, acid, base, or heating (hereinafter, also referred to as a "capping agent").

Requirement Y: The resist composition includes a resin Y1 that undergoes a decrease in molecular weight caused by scission of a main chain due to action of exposure, acid, base, or heating and a resin Y2 other than the resin Y1 and satisfies at least one of requirements B1 to B3 below.

Requirement B1: The resin Y2 has a group that decreases polarity due to action of exposure, acid, base, or heating (polarity-decreasing group).

Requirement B2: The resin Y2 has an interactive group that forms an interaction with an onium salt compound and that is released from the interaction due to action of exposure, acid, base, or heating (interactive group), and the resist composition further includes an onium salt compound.

Requirement B3: The resin Y2 has a polar group, and the resist composition further includes a compound that reacts with the polar group due to action of exposure, acid, base, or heating (capping agent).

The resist composition satisfying the requirement Y differs from the above-described resist composition satisfying the requirement X in that the resist composition satisfying the requirement Y includes the resin Y1 and the resin Y2 instead of the resin X1. Examples of components (and contents thereof) other than the resin Y1 and the resin Y2 that can be included in the resist composition satisfying the requirement Y include the same components (and contents thereof) as those in the requirement X, and preferred embodiments are also the same.

Note that when the resin Y2 has a polarity-decreasing group, the resin Y2 may have, before the action of exposure, acid, base, or heating, both the polarity-decreasing group and a group after the decrease in polarity, the group being generated from the polarity-decreasing group by the action of exposure, acid, base, or heating.

Requirement Z: The resist composition satisfies a requirement C1 or a requirement C2 below.

Requirement C1: The resist composition includes a resin Z1 having a group that decreases polarity due to action of exposure, acid, base, or heating (polarity-decreasing group).

Requirement C2: The resist composition includes a resin Z2 having a polar group, and a compound that reacts with the polar group due to action of exposure, acid, base, or heating (capping agent).

The resist composition satisfying the requirement Z may also include embodiments (Embodiments A to D) below.

(Embodiment A) Resist Composition Satisfying Any One of Requirements C 1 1 to C14 below

Requirement C11: The resist composition includes a resin Z11 having a group that decreases polarity due to action

of exposure, acid, base, or heating and an interactive group that forms an interaction with an onium salt compound and that is released from the interaction due to action of exposure, acid, base, or heating, and
an onium salt compound.
Requirement C12: The resist composition includes a resin Z12 having a polar group and an interactive group that forms an interaction with an onium salt compound and that is released from the interaction due to action of exposure, acid, base, or heating,

a compound that reacts with the polar group due to action of exposure, acid, base, or heating (capping agent), and
an onium salt compound.

Requirement C13: The resist composition includes a resin Z1 having a group that decreases polarity due to action of exposure, acid, base, or heating,

a resin Y11 having an interactive group that forms an interaction with an onium salt compound and that is released from the interaction due to action of exposure, acid, base, or heating, and
an onium salt compound.

Requirement C14: The resist composition includes a resin Z2 having a polar group,

a compound that reacts with the polar group due to action of exposure, acid, base, or heating (capping agent),
a resin Y11 having an interactive group that forms an interaction with an onium salt compound and that is released from the interaction due to action of exposure, acid, base, or heating, and
an onium salt compound.

(Embodiment B) Resist Composition Satisfying Any One of Requirements C21 to C23 below

Requirement C21: The resist composition includes a resin Z21 having a group that decreases polarity due to action of exposure, acid, base, or heating and an onium salt group that is decomposed due to action of exposure.
Requirement C22: The resist composition includes a resin Z22 having a polar group and an onium salt group that is decomposed due to action of exposure, and a compound that reacts with the polar group due to action of exposure, acid, base, or heating (capping agent).
Requirement C23: The resist composition satisfies a requirement C1 or a requirement C2 below and includes a resin Y21 having an onium salt group that is decomposed due to action of exposure.
Requirement C1: The resist composition includes a resin Z1 having a group that decreases polarity due to action of exposure, acid, base, or heating.
Requirement C2: The resist composition includes a resin Z2 having a polar group, and a compound that reacts with the polar group due to action of exposure, acid, base, or heating (capping agent).

(Embodiment C) Resist Composition Satisfying Requirement C1 or Requirement C2 below and Including Resin Y31 That Undergoes Decrease in Molecular Weight Due to Action of Exposure, Acid, Base, or Heating

Requirement C1: The resist composition includes a resin Z1 having a group that decreases polarity due to action of exposure, acid, base, or heating.
Requirement C2: The resist composition includes a resin Z2 having a polar group, and a compound that reacts with the polar group due to action of exposure, acid, base, or heating (capping agent).

(Embodiment D) Resist Composition Satisfying Any One of Requirements C41 to C45 below

Requirement C41: The resist composition includes a resin Z41 having a group that decreases polarity due to action of exposure, acid, base, or heating and a reactive group A, and

a crosslinking agent having a reactive group B that reacts with the reactive group A, and
a bond formed by the reactive group A and the reactive group B is broken by action of exposure, acid, base, or heating.

Requirement C42: The resist composition includes a resin Z42 having a group that decreases polarity due to action

of exposure, acid, base, or heating, a reactive group A, and a reactive group B that reacts with the reactive group A, and a bond formed by the reactive group A and the reactive group B is broken by action of exposure, acid, base, or heating.
Requirement C43: The resist composition includes a resin Z43 having a polar group and a reactive group A,

a compound that reacts with the polar group due to action of exposure, acid, base, or heating (capping agent), and
a crosslinking agent having a reactive group B that reacts with the reactive group A, and
a bond formed by the reactive group A and the reactive group B is broken by action of exposure, acid, base, or heating.

Requirement C44: The resist composition is a composition including a resin Z44 having a polar group, a reactive group A, and a reactive group B that reacts with the reactive groups A, and

a compound that reacts with the polar group due to action of exposure, acid, base, or heating (capping agent), and
a bond formed by the reactive group A and the reactive group B is broken by action of exposure, acid, base, or heating.

Requirement C45: The resist composition satisfies a requirement C1 or a requirement C2 below and satisfies a requirement C46 or a requirement C47 below.

Requirement C1: The resist composition includes a resin Z1 having a group that decreases polarity due to action of exposure, acid, base, or heating.
Requirement C2: The resist composition includes a resin Z2 having a polar group, and a compound that reacts with the polar group due to action of exposure, acid, base, or heating (capping agent).

Requirement C46: The resist composition includes a resin Y41 having a reactive group A, and

a crosslinking agent having a reactive group B that reacts with the reactive group A, and
a bond formed by the reactive group A and the reactive group B is broken by action of exposure, acid, base, or heating.

Requirement C47: The resist composition includes a resin Y42 having a reactive group A and a reactive group B that reacts with the reactive group A, and
a bond formed by the reactive group A and the reactive group B is broken by action of exposure, acid, base, or heating.

Hereinafter, components that can be included in the resist composition will be described in detail.

Resin

Groups and repeating units that can be included in a resin will be described in detail below.
The resin preferably includes two or more, more preferably includes three or more, and still more preferably includes three selected from the group consisting of groups which will be described later and repeating units which will be described later. Specifically, the resin preferably includes two or more, more preferably includes three or more, and still more preferably includes three selected from the group consisting of a polarity-decreasing group, an interactive group, a polar group, a reactive group A, a reactive group B, and a block or repeating unit that undergoes a decrease in molecular weight caused by scission of the main chain due to action of exposure, acid, base, or heating (preferably the group consisting of a polarity-decreasing group, an interactive group, and a block or repeating unit that undergoes a decrease in molecular weight caused by scission of the main chain due to action of exposure, acid, base, or heating).

Polarity-Decreasing Group

The polarity-decreasing group refers to a group that decreases polarity due to action of exposure, acid, base, or heating, as described above.
Whether or not a group corresponds to the polarity-decreasing group can be determined by determining logP (octanol/water partition coefficient) based on the chemical structures before and after being subjected to the action of exposure, acid, base, or heating, and determining whether or not there is an increase in logP after being subjected to the action of exposure, acid, base, or heating.
Herein, logP is an index indicating properties of hydrophilicity and hydrophobicity of a chemical structure and may be referred to as a hydrophilicity-hydrophobicity parameter. The logP can be calculated using, for example, Chem-

BioDraw Ultra (Version16.0.14).

A mechanism in which the polarity-decreasing group decreases polarity due to action of exposure, acid, base, or heating is not particularly limited. Examples of the mechanism of a decrease in polarity include the following.

· A mechanism in which polarity is decreased by an elimination reaction due to action of acid, represented by Formula (K1) below

· A mechanism in which polarity is decreased by an elimination reaction caused by a cyclization reaction due to action of acid, represented by Formula (K2) below

· A mechanism in which the polarity-decreasing group is an onium salt group that is decomposed due to action of exposure, and polarity is decreased by the decomposition due to exposure

· A mechanism in which polarity-decreasing group is an acid-decomposable group having a structure provided by protecting a polar group with a protective group that leaves due to action of acid, and the polar group generated after acid decomposition is more hydrophobic than the acid-decomposable group before acid decomposition

The mechanisms will be described below.

Mechanism in Which Polarity Is Decreased by Elimination Reaction Due to Action of Acid, Represented by Formula (K1), and Mechanism in Which Polarity Is Decreased by Elimination Reaction Caused by Cyclization Reaction Due to Action of Acid, Represented by Formula (K2)

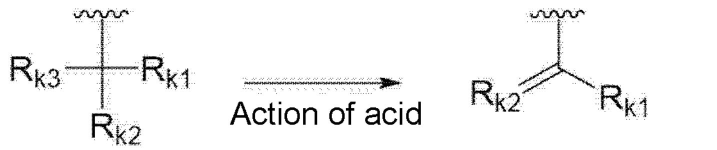


(K1)

In the mechanism represented by Formula (K1) above, $R_{k1}$ and $R_{k2}$ represent an organic group including a hydrogen atom. Specifically, $R_{k1}$ and $R_{k2}$ are each preferably an organic group including a hydrogen atom that is added to $R_{k3}$ due to action of acid to cause it to leave as $R_{k3}H$. $R_{k1}$ and $R_{k2}$ are preferably each independently an alkyl group (which may be linear, branched, or cyclic) or an aryl group, and at least one of $R_{k1}$ or $R_{k2}$ is more preferably an alkyl group.

The number of carbon atoms of the alkyl group is preferably 1 to 20, more preferably 1 to 12, still more preferably 1 to 6. The aryl group is preferably a phenyl group.

$R_{k1}$ and $R_{k2}$ may be bonded together to form an alicyclic ring. The number of ring member atoms of the alicyclic ring is not particularly limited, but is, for example, 5 to 7.

$R_{k3}$ is preferably a group that can leave as $R_{k3}H$ upon addition of a hydrogen atom due to action of acid, and specifically, more preferably a group that can leave as $R_{k3}H$ upon addition of a hydrogen atom that leaves from $R_{k1}$ and $R_{k2}$ due to action of acid. $R_{k3}$ is preferably, for example, a hydroxy group (-OH), an alkoxy group ($-OR^S$), an ester group ($-OCOR^S$), or a carbonate group ($-OCOOR^S$). $R^S$ above represents an organic group and is preferably an alkyl group. The number of carbon atoms of the alkyl group is preferably 1 to 20, more preferably 1 to 12, still more preferably 1 to 6.

In a resin having the polarity-decreasing group, one of $R_{k1}$ and $R_{k2}$ may be bonded to another atom in the resin to form a ring structure.

Note that, in one form of the polarity-decreasing group in the mechanism represented by Formula (K1) above, the polarity-decreasing group may correspond to a reactive group A or a reactive group B described later.

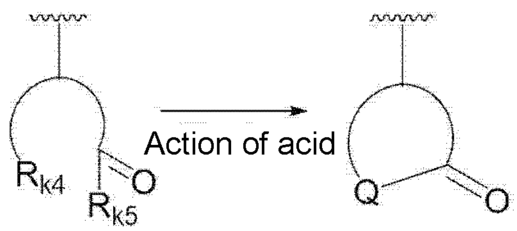


(K2)

In the mechanism represented by Formula (K2) above, $R_{k4}$ represents $-OR^T$, $-NR^TR^U$, or $-SR^T$. $R^T$ represents a hydrogen atom or an organic group that leaves due to action of acid. $R^U$ represents a hydrogen atom or an organic group.

In Formula (K2), Q represents -O-, $-NR^U-$, or -S- remaining from the $R_{k4}$ group after a cyclization reaction.

$R_{k5}$ is not particularly limited as long as it is a group that can leave as $R_{k5}H$ upon addition of a hydrogen atom. Examples thereof include a hydroxy group (-OH), an alkoxy group ($-OR^V$), a substituted or unsubstituted amino group ($-NH_2$, $-NHR^W$, or $-NR^WR^X$ (where $R^W$ and $R^X$ represent an organic group, provided that, in the case of $NR^WR^X$, either

one of $R^W$ and $R^X$ represents an organic group that can leave in the cyclization reaction).

When $R_{k4}$ is, for example, -OH and is a phenolic hydroxy group, it also corresponds to an interactive group or a polar group. When $R_{k4}$ is, for example, -OH and is an alcoholic hydroxy group, it also corresponds to a polar group. When $R_{k5}$ is, for example, -OH, $-NH_2$, $-NHR^W$, or - $NR^WR^X$, the group represented by -CO-$R_{k5}$ clearly shown in Formula (K2) also correspond to an interactive group (in the cases of a carboxyl group and an amide group) or a polar group (in the case of a carboxyl group).

The organic group that leaves due to action of acid and represented by $R^T$ above is preferably an alkyl group (which may be linear, branched or cyclic) or an aryl group. The number of carbon atoms of the alkyl group is preferably 1 to 20, more preferably 1 to 12, still more preferably 1 to 6. The aryl group is preferably a phenyl group. The alkyl group and the aryl group may further have a substituent.

The organic group represented by $R^U$ above is not particularly limited, but is preferably an alkyl group (which may be linear, branched, or cyclic) or an aryl group. The number of carbon atoms of the alkyl group is preferably 1 to 20, more preferably 1 to 12, still more preferably 1 to 6. The aryl group is preferably a phenyl group. The alkyl group and the aryl group may further have a substituent.

$R^V$ above represents an organic group that can leave in the cyclization reaction and is more preferably an alkyl group (which may be linear, branched, or cyclic) or an aryl group. The number of carbon atoms of the alkyl group is preferably 1 to 20, more preferably 1 to 12, still more preferably 1 to 6. The aryl group is preferably a phenyl group. The alkyl group and the aryl group may further have a substituent.

The organic groups represented by $R^W$ and $R^X$ are not particularly limited, but are each preferably an alkyl group (which may be linear, branched, or cyclic) or an aryl group. The number of carbon atoms of the alkyl group is preferably 1 to 20, more preferably 1 to 12, still more preferably 1 to 6. The aryl group is preferably a phenyl group. The alkyl group and the aryl group may further have a substituent. The alkyl groups and the aryl group also correspond to the organic groups that can leave in the cyclization reaction.

A specific example of the polarity-decreasing group that decreases polarity due to the mechanism represented by Formula (K1) above is a functional group represented by Formula (KD1) below.

Specific examples of the polarity-decreasing group that decreases polarity due to the mechanism represented by Formula (K2) above include a monovalent functional group formed by removing one hydrogen atom that one or more of $R^{d5}$ to $R^{d10}$ in a compound represented by Formula (KD2) below have, and a monovalent functional group formed by removing one hydrogen atom that a ring member atom has in any of a ring formed by bonding $R^{d6}$ and $R^{d7}$ together and a ring formed by bonding $R^{d8}$ and $R^{d9}$ together in the compound represented by Formula (KD2) below.

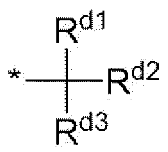
(KD1)

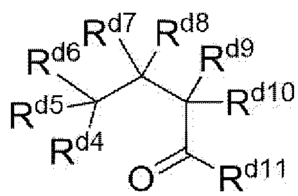
(KD2)

In Formula (KD1) above, $R^{d1}$, $R^{d2}$, and $R^{d3}$ have the same definitions and preferred embodiments as in $R_{k1}$, $R_{k2}$, and $R_{k3}$, respectively, in Formula (K1) above. In Formula (KD1), * represents a bonding site.

In Formula (KD2) above, $R^{d4}$ and $R^{d11}$ have the same definitions and preferred embodiments as in $R_{k4}$ and $R_{k5}$, respectively, in Formula (K2) above.

$R^{d5}$ to $R^{d10}$ each independently represent a hydrogen atom or a substituent. The substituent is not particularly limited and may be, for example, a halogen atom, an alkyl group (which may be linear, branched, or cyclic), or an alkoxy group (which may be linear, branched, or cyclic). The number of carbon atoms of the alkyl group and the alkyl group moiety in the alkoxy group is, for example, preferably 1 to 10, preferably 1 to 6. The alkyl group and the alkoxy group may further have a substituent.

In addition, $R^{d6}$ and $R^{d7}$ or $R^{d8}$ and $R^{d9}$ may be bonded together to form a ring. The ring formed by bonding $R^{d6}$ and $R^{d7}$ together and the ring formed by bonding $R^{d8}$ and $R^{d9}$ together are not particularly limited, and may be an alicyclic ring or an aromatic ring, but is preferably an aromatic ring. The aromatic ring is preferably, for example, a benzene ring. When $R^{d6}$ and $R^{d7}$ are bonded together to form an aromatic ring (for example, a benzene ring), $R^{d5}$ and

$R^{d8}$ each serve as a direct bond. When $R^{d8}$ and $R^{d9}$ are bonded together to form an aromatic ring (for example, a benzene ring), $R^{d7}$ and $R^{d10}$ each serve as a direct bond.

However, in the compound represented by Formula (KD2) above, at least one of $R^{d5}$ to $R^{d10}$ represents a hydrogen atom, or $R^{d6}$ and $R^{d7}$ are bonded together to form a ring or $R^{d8}$ and $R^{d9}$ are bonded together to form a ring, and an atom that constitutes the ring has one or more hydrogen atoms.

It is also preferable that the polarity-decreasing group that decreases polarity due to the mechanism represented by Formula (K2) above be a group represented by Formula (KD2-1) below.

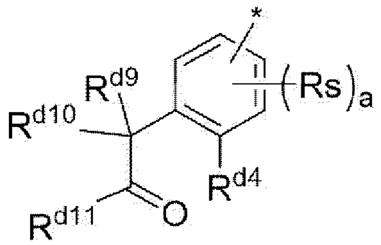

(KD2-1)

In Formula (KD2-1), $R^{d4}$ and $R^{d9}$ to $R^{d11}$ have the same definitions and preferred embodiments as in $R^{d4}$ and $R^{d9}$ to $R^{d11}$, respectively, in Formula (KD2).

Rs represents a substituent. The substituent is not particularly limited and may be, for example, a halogen atom, an alkyl group, or an alkoxy group. The number of carbon atoms of the alkyl group and the alkyl group moiety in the alkoxy group is, for example, preferably 1 to 10, preferably 1 to 6.

a represents an integer of 0 to 3.

* represents a bonding site.

Mechanism in Which Polarity-Decreasing Group Is Onium Salt Group That Is Decomposed Due to Action of Exposure, and Polarity Is Decreased by Decomposition Due to Exposure

An onium salt group that is decomposed due to action of exposure will be described below.

The onium salt group is a group having an onium salt structure (a group having a moiety having an ion pair of a cation and an anion) and is preferably a group having a moiety represented by "$X^{n-}$ $nM^{+}$" (where n represents, for example, an integer of 1 to 3 and preferably represents 1 or 2). $M^+$ represents a moiety including a positively charged atom or atomic group, and $X^{n-}$ represents a moiety including a negatively charged atom or atomic group. The anion in the onium salt group is preferably a non-nucleophilic anion (an anion having a very low ability to cause a nucleophilic reaction).

In particular, the onium salt group is more preferably a group selected from the group consisting of a group represented by Formula (O1) below and a group represented by Formula (O2) below.

$*-X_A^{n-}\ nM_A^+$ Formula (O1)

$*-M_B^+\ X_B^-$ Formula (O2)

In Formula (O1), $X_A^{n-}$ represents a monovalent anionic group having a charge number of n. $Ma^+$ represents an organic cation, n represents 1 or 2. * represents a bonding site.

In Formula (O2), $M_B^+$ represents a monovalent organic cationic group. $X_B^-$ represents an anion.

The anions represented by $X_A^{n-}$ and $X_B^-$ are each preferably a non-nucleophilic anion (an anion having a very low ability to cause a nucleophilic reaction). * represents a bonding site.

The group represented by Formula (O1) and the group represented by Formula (O2) will be described in detail below.

In Formula (O1), $X_A^{n-}$ represents a monovalent anionic group having a charge number of n (where n is 1 or 2).

The monovalent anionic group having a charge number of n (where n is 1 or 2) and represented by $X_A^{n-}$ is not particularly limited, but is preferably, for example, a group selected from the group consisting of groups represented by Formulae (B-1) to (B-15) below. The group represented by any one of Formulae (B-1) to (B-14) below corresponds to a monovalent anionic group having a charge number of 1, and the group represented by Formula (B-15) below corresponds to a monovalent anionic group having a charge number of 2.

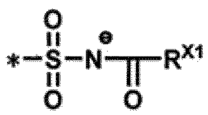

B-1

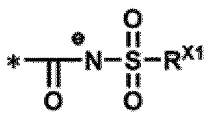

B-2

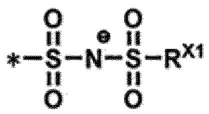

B-3

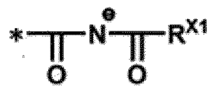

B-4

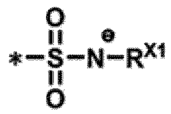

B-5

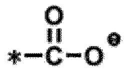

B-6

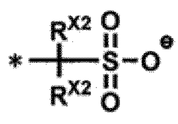

B-7

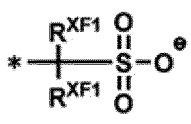

B-8

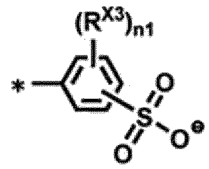

B-9

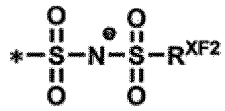

B-10

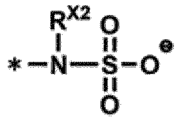

B-11

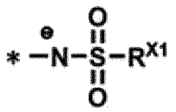

B-12

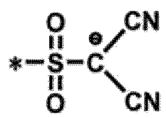

B-13

*-O⁻ Formula (B-14)

In Formulae (B-1) to (B-14), * represents a bonding site.

In Formulae (B-1) to (B-5) and Formula (B-12), each $R^{X1}$ independently represents a monovalent organic group.

In Formula (B-7) and Formula (B-11), $R^{X2}$'s each independently represent a hydrogen atom or a substituent other than a fluorine atom and a perfluoroalkyl group. Two $R^{X2}$'s in Formula (B-7) may be the same or different.

In Formula (B-8), $R^{XF1}$'s represent a hydrogen atom, a fluorine atom, or a perfluoroalkyl group. However, at least one of two $R^{XF1}$'s represents a fluorine atom or a perfluoroalkyl group. Two $R^{XF1}$'s in Formula (B-8) may be the same or different.

In Formula (B-9), $R^{X3}$ represents a hydrogen atom, a halogen atom, or a monovalent organic group. n1 represents an integer of 0 to 4. When n1 represents an integer of 2 to 4, a plurality of $R^{X3}$'s may be the same or different.

In Formula (B-10), $R^{XF2}$ represents a fluorine atom or a perfluoroalkyl group.

The partner bonded to the bonding site represented by * in Formula (B-14) is preferably a phenylene group that may have a substituent. Examples of the substituent that the phenylene group may have include halogen atoms.

In Formulae (B-1) to (B-5) and Formula (B-12), each $R^{X1}$ independently represents a monovalent organic group.

$R^{X1}$ is preferably an alkyl group (which may be linear or branched and preferably has 1 to 15 carbon atoms), a cycloalkyl group (which may be monocyclic or polycyclic and preferably has 3 to 20 carbon atoms), or an aryl group (which may be monocyclic or polycyclic and preferably has 6 to 20 carbon atoms). The above group represented by $R^{X1}$ may have a substituent.

In $R^{X1}$ in Formula (B-5), the atom directly bonded to N- is also preferably neither a carbon atom in -CO- nor a sulfur atom in $-SO_2-$.

The cycloalkyl group in $R^{X1}$ may be monocyclic or polycyclic.

Examples of the cycloalkyl group in $R^{X1}$ include a norbornyl group and an adamantyl group.

The substituent that the cycloalkyl group in $R^{X1}$ may have is not particularly limited, but is preferably an alkyl group (which may be linear or branched and preferably has 1 to 5 carbon atoms). One or more of carbon atoms which are ring member atoms of the cycloalkyl group in $R^{X1}$ may be replaced by carbonyl carbon atoms. The number of carbon atoms of the alkyl group in $R^{X1}$ is preferably 1 to 10, more preferably 1 to 5.

The substituent that the alkyl group in $R^{X1}$ may have is not particularly limited, but is preferably, for example, a cycloalkyl group, a fluorine atom, or a cyano group.

Examples of the cycloalkyl group serving as the substituent are also the same as the cycloalkyl groups described in the case where $R^{X1}$ is a cycloalkyl group.

When the alkyl group in $R^{X1}$ has a fluorine atom serving as the substituent, the alkyl group may be a perfluoroalkyl group.

In addition, one or more $-CH_2-$ of the alkyl group in $R^{X1}$ may be substituted with carbonyl groups.

The aryl group in $R^{X1}$ is preferably a benzene ring group.

The substituent that the aryl group in $R^{X1}$ may have is not particularly limited, but is preferably an alkyl group, a fluorine atom, or a cyano group. Examples of the alkyl group serving as the substituent are also the same as the alkyl groups described in the case where $R^{X1}$ is an alkyl group.

In Formulae (B-7) and (B-11), each $R^{X2}$ independently represents a hydrogen atom or a substituent other than a fluorine atom and a perfluoroalkyl group. Two $R^{X2}$'s in Formula (B-7) may be the same or different.

The substituent that is other than a fluorine atom and a perfluoroalkyl group and represented by $R^{X2}$ is preferably an alkyl group other than a perfluoroalkyl group, or a cycloalkyl group.

Examples of the alkyl group include alkyl groups excluding perfluoroalkyl groups from the alkyl groups described in the case where $R^{X1}$ is an alkyl group. The alkyl group preferably does not have a fluorine atom.

Examples of the cycloalkyl group include the cycloalkyl groups described in the case where $R^{X1}$ is a cycloalkyl group. The cycloalkyl group preferably does not have a fluorine atom.

In Formula (B-8), $R^{XF1}$'s represent a hydrogen atom, a fluorine atom, or a perfluoroalkyl group. However, at least one of the plurality of $R^{XF1}$'s represents a fluorine atom or a perfluoroalkyl group. Two $R^{XF1}$'s in Formula (B-8) may be the same or different. The number of carbon atoms of the perfluoroalkyl group represented by $R^{XF1}$ is preferably 1 to 15, more preferably 1 to 10, still more preferably 1 to 6.

In Formula (B-9), $R^{X3}$ represents a hydrogen atom, a halogen atom, or a monovalent organic group. Examples of the halogen atom serving as $R^{X3}$ include a fluorine atom, a chlorine atom, a bromine atom, and an iodine atom. In particular, a fluorine atom is preferred.

The monovalent organic group serving as $R^{X3}$ is the same as the monovalent organic group described as $R^{X1}$.

n1 represents an integer of 0 to 4.

n1 is preferably an integer of 0 to 2, preferably 0 or 1. When n1 represents an integer of 2 to 4, a plurality of $R^{X3}$'s may be the same or different.

In Formula (B-10), $R^{XF2}$ represents a fluorine atom or a perfluoroalkyl group.

The number of carbon atoms of the perfluoroalkyl group represented by $R^{XF2}$ is preferably 1 to 15, more preferably 1 to 10, still more preferably 1 to 6.

$$*\text{-}B_{M1}\text{-}L_M\text{-}B_{M2} \qquad \text{Formula (B-15)}$$

In Formula (B-15), $B_{M1}$ represents a divalent anionic group represented by any one of Formulae (BB-1) to (BB-4) below. $L_M$ represents a single bond or a divalent linking group. $B_{M2}$ represents a group selected from the group consisting of Formula (B-1) to Formula (B-14) described above. In Formula (B-15) and Formulae (BB-1) to (BB-4), * represents a bonding site.

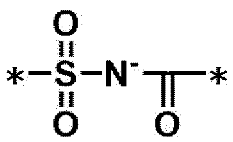
BB-1
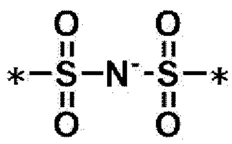
BB-2
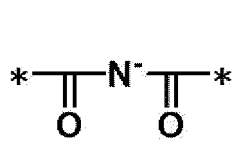
BB-3
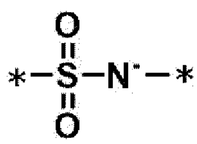
BB-4

Examples of the divalent linking group represented by $L_M$ include, but are not particularly limited to, -CO-, -NR-, -CO-, -O-, -S-, -SO-, $-SO_2-$, an alkylene group (which preferably has 1 to 6 carbon atoms and may be linear or branched), a cycloalkylene group (preferably having 3 to 15 carbon atoms), an alkenylene group (preferably having 2 to 6 carbon atoms), a divalent aliphatic heterocyclic group (preferably a five- to ten-membered ring, more preferably a five- to seven-membered ring, still more preferably a five- or six-membered ring having at least one N atom, O atom, S atom, or Se atom in the ring structure), a divalent aromatic heterocyclic group (preferably a five- to ten-membered ring, more preferably a five- to seven-membered ring, still more preferably a five- or six-membered ring having at least one N atom, O atom, S atom, or Se atom in the ring structure), a divalent aromatic hydrocarbon ring group (preferably a six- to ten-membered ring, more preferably a six-membered ring), and a divalent linking group provided by combining a plurality of these. R above is, for example, a hydrogen atom or a monovalent organic group. The monovalent organic group is not particularly limited, but is preferably, for example, an alkyl group (preferably having 1 to 6 carbon atoms).

The alkylene group, the cycloalkylene group, the alkenylene group, the divalent aliphatic heterocyclic group, the divalent aromatic heterocyclic group, and the divalent aromatic hydrocarbon ring group may have a substituent. The substituent is, for example, a halogen atom (preferably a fluorine atom).

The divalent linking group represented by $L_M$ is particularly preferably an alkylene group. The alkylene group is preferably substituted with a fluorine atom and may be a perfluoro group.

The organic cation represented by $M_A^+$ in Formula (O1) is preferably an organic cation represented by Formula (ZaI) (cation (ZaI)) or an organic cation represented by Formula (ZaII) (cation (ZaII)).

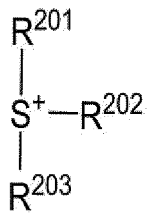

(ZaI)

$$R^{204}-I^{+}-R^{205} \quad \text{(ZaII)}$$

In Formula (ZaI) above,

$R^{201}$, $R^{202}$, and $R^{203}$ each independently represent an organic group.

The number of carbon atoms of the organic group serving as $R^{201}$, $R^{202}$, or $R^{203}$ is usually 1 to 30, preferably 1 to 20. Furthermore, two of $R^{201}$ to $R^{203}$ may be bonded together to form a ring structure, and the ring may include an oxygen atom, a sulfur atom, an ester group, an amide group, or a carbonyl group. Examples of the group formed by bonding two of $R^{201}$ to $R^{203}$ together include alkylene groups (such as a butylene group and a pentylene group) and $-CH_2-CH_2-O-CH_2-CH_2-$.

In Formula (ZaI), preferred embodiments of the organic cation include, as described later, cation (ZaI-1), cation (ZaI-2), an organic cation represented by Formula (ZaI-3b) (cation (ZaI-3b)), and an organic cation represented by Formula (ZaI-4b) (cation (ZaI-4b)).

First, cation (ZaI-1) will be described.

Cation (ZaI-1) is an arylsulfonium cation represented by Formula (ZaI) above where at least one of $R^{201}$ to $R^{203}$ is an aryl group.

In the arylsulfonium cation, all of $R_{201}$ to $R_{203}$ may be aryl groups, or some of $R_{201}$ to $R_{203}$ may be an aryl group and the remainder may be an alkyl group or a cycloalkyl group.

Alternatively, one of $R_{201}$ to $R_{203}$ may be an aryl group and the other two of $R^{201}$ to $R^{203}$ may be bonded together to form a ring structure, and the ring may include an oxygen atom, a sulfur atom, an ester group, an amide group, or a carbonyl group. Examples of the group formed by bonding two of $R^{201}$ to $R^{203}$ include alkylene groups in which one or more methylene groups may be substituted with an oxygen atom, a sulfur atom, an ester group, an amide group, and/or a carbonyl group (such as a butylene group, a pentylene group, and $-CH_2-CH_2-O-CH_2-CH_2-$).

Examples of the arylsulfonium cation include triarylsulfonium cations, diarylalkylsulfonium cations, aryldialkylsulfonium cations, diarylcycloalkylsulfonium cations, and aryldicycloalkylsulfonium cations.

The aryl group included in the arylsulfonium cation is preferably a phenyl group or a naphthyl group, more preferably a phenyl group. The aryl group may be an aryl group having a heterocyclic structure having, for example, an oxygen atom, a nitrogen atom, or a sulfur atom. Examples of the heterocyclic structure include a pyrrole residue, a furan residue, a thiophene residue, an indole residue, a benzofuran residue, and a benzothiophene residue. When the arylsulfonium cation has two or more aryl groups, the two or more aryl groups may be the same or different.

The alkyl group or the cycloalkyl group that the arylsulfonium cation optionally has is preferably a linear alkyl group having 1 to 15 carbon atoms, a branched alkyl group having 3 to 15 carbon atoms, or a cycloalkyl group having 3 to 15 carbon atoms, more preferably, for example, a methyl group, an ethyl group, a propyl group, a n-butyl group, a sec-butyl group, a t-butyl group, a cyclopropyl group, a cyclobutyl group, or a cyclohexyl group.

Substituents that the aryl group, the alkyl group, and the cycloalkyl group in $R^{201}$ to $R^{203}$ may have are preferably each independently an alkyl group (having, for example, 1 to 15 carbon atoms), a cycloalkyl group (having, for example, 3 to 15 carbon atoms), an aryl group (having, for example, 6 to 14 carbon atoms), an alkoxy group (having, for example, 1 to 15 carbon atoms), a cycloalkylalkoxy group (having, for example, 1 to 15 carbon atoms), a halogen atom (for example, fluorine or iodine), a hydroxy group, a carboxyl group, an ester group, a sulfinyl group, a sulfonyl group, an alkylthio group, or a phenylthio group.

The substituents each may further have a substituent, if possible. For example, the alkyl group also preferably has a halogen atom as a substituent to serve as an alkyl halide group such as a trifluoromethyl group.

In addition, it is also preferable that any combination of the above substituents form an acid-decomposable group. Examples of the acid-decomposable group include the same acid-decomposable groups as those described as examples of the polarity-decreasing group.

Next, cation (ZaI-2) will be described.

Cation (ZaI-2) is a cation represented by Formula (ZaI) where $R^{201}$ to $R^{203}$ each independently represent an organic group having no aromatic ring. Here, the aromatic ring also encompasses aromatic rings including heteroatoms.

In $R^{201}$ to $R^{203}$, the organic group having no aromatic ring generally has 1 to 30 carbon atoms and preferably has 1 to 20 carbon atoms.

$R^{201}$ to $R^{203}$ are preferably each independently an alkyl group, a cycloalkyl group, an allyl group, or a vinyl group, more preferably a linear or branched 2-oxoalkyl group, a 2-oxocycloalkyl group, or an alkoxycarbonylmethyl group, still more preferably a linear or branched 2-oxoalkyl group.

The alkyl group and the cycloalkyl group in $R^{201}$ to $R^{203}$ may be, for example, a linear alkyl group having 1 to 10 carbon atoms or a branched alkyl group having 3 to 10 carbon atoms (such as a methyl group, an ethyl group, a propyl group, a butyl group, or a pentyl group), and a cycloalkyl group having 3 to 10 carbon atoms (such as a cyclopentyl group, a cyclohexyl group, or a norbornyl group).

$R^{201}$ to $R^{203}$ may be further substituted with a halogen atom, an alkoxy group (having, for example, 1 to 5 carbon atoms), a hydroxy group, a cyano group, or a nitro group.

In addition, it is also preferable that substituents in $R^{201}$ to $R^{203}$ each independently form an acid-decomposable group as a result of any combination of the substituents.

Next, cation (ZaI-3b) will be described.

Cation (ZaI-3b) is a cation represented by Formula (ZaI-3b) below.

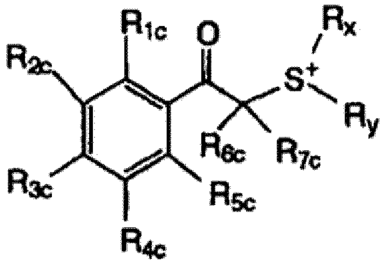

(ZaI-3b)

In Formula (ZaI-3b),

$R_{1c}$ to $R_{5c}$ each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxy group, a nitro group, an alkylthio group, or an arylthio group.

$R_{6c}$ and $R_{7c}$ each independently represent a hydrogen atom, an alkyl group (such as a t-butyl group), a cycloalkyl group, a halogen atom, a cyano group, or an aryl group.

$R_x$ and $R_y$ each independently represent an alkyl group, a cycloalkyl group, a 2-oxoalkyl group, a 2-oxocycloalkyl group, an alkoxycarbonylalkyl group, an allyl group, or a vinyl group.

In addition, it is also preferable that substituents in $R_{1c}$ to $R_{7c}$ and $R_x$ and $R_y$ each independently form an acid-decomposable group as a result of any combination of the substituents.

Any two or more of $R_{1c}$ to $R_{5c}$, $R_{5c}$ and $R_{6c}$, $R_{6c}$ and $R_{7c}$, $R_{5c}$ and $R_x$, and $R_x$ and $R_y$ may be individually bonded together to form rings, and these rings may each independently include an oxygen atom, a sulfur atom, a ketone group, an ester bond, or an amide bond.

The rings each may be an aromatic or non-aromatic hydrocarbon ring, an aromatic or non-aromatic heterocycle, or a polycyclic fused ring formed by a combination of two or more of these rings. The ring may be a three- to ten-membered ring, and is preferably a four- to eight-membered ring, more preferably a five- or six-membered ring.

Examples of the groups formed by bonding together any two or more of $R_{1c}$ to $R_{5c}$, $R_{6c}$ and $R_{7c}$, and $R_x$ and $R_y$ include alkylene groups such as a butylene group and a pentylene group. A methylene group in such an alkylene group may be substituted with a heteroatom such as an oxygen atom.

The groups formed by bonding together $R_{5c}$ and $R_{6c}$, and $R_{5c}$ and $R_x$ are each preferably a single bond or an alkylene group. Examples of the alkylene group include a methylene group and an ethylene group.

$R_{1c}$ to $R_{5c}$, $R_{6c}$, $R_{7c}$, $R_x$, $R_y$, and the rings formed by individually bonding together any two or more of $R_{1c}$ to $R_{5c}$, $R_{5c}$ and $R_{6c}$, $R_{6c}$ and $R_{7c}$, $R_{5c}$ and $R_x$, and $R_x$ and $R_y$ may have a substituent.

Next, cation (ZaI-4b) will be described.

Cation (ZaI-4b) is a cation represented by Formula (ZaI-4b) below.

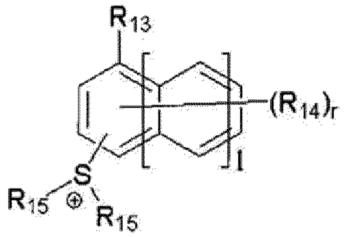

(ZaI-4b)

In Formula (ZaI-4b),
l represents an integer of 0 to 2.

r represents an integer of 0 to 8.

$R_{13}$ represents a hydrogen atom, a halogen atom (for example, a fluorine atom or an iodine atom), a hydroxy group, an alkyl group, an alkyl halide group, an alkoxy group, a carboxyl group, an alkoxycarbonyl group, or a group having a cycloalkyl group (which may be a cycloalkyl group itself or a group including a cycloalkyl group as a part thereof). These groups may have a substituent.

$R_{14}$ represents a hydroxy group, a halogen atom (for example, a fluorine atom or an iodine atom), an alkyl group, an alkyl halide group, an alkoxy group, an alkoxycarbonyl group, an alkylcarbonyl group, an alkylsulfonyl group, a cycloalkylsulfonyl group, or a group having a cycloalkyl group (which may be a cycloalkyl group itself or a group including a cycloalkyl group as a part thereof). These groups may have a substituent. When a plurality of $R_{14}$'s are present, the plurality of $R_{14}$'s each independently represent the above-mentioned group, for example, a hydroxy group.

$R_{15}$'s each independently represent an alkyl group, a cycloalkyl group, or a naphthyl group. Two $R_{15}$'s may be bonded together to form a ring. When two $R_{15}$'s are bonded together to form a ring, the ring skeleton may include a heteroatom such as an oxygen atom or a nitrogen atom. In one embodiment, two $R_{15}$'s are preferably alkylene groups and bonded together to form a ring structure. Note that the alkyl group, the cycloalkyl group, the naphthyl group, and the ring formed by bonding two $R_{15}$'s together may have a substituent.

In Formula (ZaI-4b), the alkyl groups in $R_{13}$, $R_{14}$, and $R_{15}$'s are preferably linear or branched. The number of carbon atoms of such an alkyl group is preferably 1 to 10. The alkyl group is more preferably, for example, a methyl group, an ethyl group, a n-butyl group, or a t-butyl group.

In addition, it is also preferable that substituents in $R_{13}$ to $R_{15}$'s and $R_x$ and $R_y$ each independently form an acid-decomposable group as a result of any combination of the substituents.

Next, Formula (ZaII) will be described.

In Formula (ZaII), $R^{204}$ and $R^{205}$ each independently represent an aryl group, an alkyl group, or a cycloalkyl group.

The aryl group in $R^{204}$ and $R^{205}$ is preferably a phenyl group or a naphthyl group, more preferably a phenyl group. The aryl group in $R^{204}$ and $R^{205}$ may be an aryl group having a heterocycle having an oxygen atom, a nitrogen atom, a sulfur atom, or the like. Examples of the skeleton of the aryl group having a heterocycle include pyrrole, furan, thiophene, indole, benzofuran, and benzothiophene.

The alkyl group and the cycloalkyl group in $R^{204}$ and $R^{205}$ are preferably a linear alkyl group having 1 to 10 carbon atoms or a branched alkyl group having 3 to 10 carbon atoms (for example, a methyl group, an ethyl group, a propyl group, a butyl group, or a pentyl group), or a cycloalkyl group having 3 to 10 carbon atoms (for example, a cyclopentyl group, a cyclohexyl group, or a norbornyl group).

The aryl group, the alkyl group, and the cycloalkyl group in $R^{204}$ and $R^{205}$ may each independently have a substituent. Examples of the substituent that the aryl group, the alkyl group, and the cycloalkyl group in $R^{204}$ and $R^{205}$ may have include alkyl groups (having, for example, 1 to 15 carbon atoms), cycloalkyl groups (having, for example, 3 to 15 carbon atoms), aryl groups (having, for example, 6 to 15 carbon atoms), alkoxy groups (having, for example, 1 to 15 carbon atoms), halogen atoms, a hydroxy group, and a phenylthio group. In addition, it is also preferable that substituents in $R^{204}$ and $R^{205}$ each independently form an acid-decomposable group as a result of any combination of the substituents.

The monovalent organic cationic group represented by $M_B^+$ in Formula (O2) is particularly preferably an organic cationic group represented by Formula (ZBI) below or an organic cationic group represented by Formula (ZBII) below.

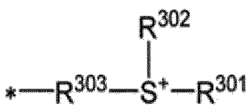

(ZBI)

$$*-R^{305}-I^{+}-R^{304} \quad \text{(ZBII)}$$

In Formula (ZBI) above, $R^{301}$ and $R^{302}$ each independently represent an organic group. The number of carbon atoms of the organic group serving as $R^{301}$ or $R^{302}$ is usually 1 to 30, preferably 1 to 20. $R^{303}$ represents a divalent linking group.

Two of $R^{301}$ to $R^{303}$ may be bonded together to form a ring structure, and the ring may include an oxygen atom, a sulfur atom, an ester group, an amide group, or a carbonyl group. Examples of the group formed by bonding two of $R^{301}$ to $R^{303}$ together include alkylene groups (such as a butylene group and a pentylene group) and $-CH_2-CH_2-O-CH_2-CH_2-$.

The organic group serving as $R^{301}$ and $R^{302}$ is not particularly limited, but is preferably an alkyl group, a cycloalkyl group, or an aryl group.

The aryl group is preferably a phenyl group or a naphthyl group, more preferably a phenyl group. The aryl group may be an aryl group having a heterocyclic structure having, for example, an oxygen atom, a nitrogen atom, or a sulfur atom. Examples of the heterocyclic structure include a pyrrole residue, a furan residue, a thiophene residue, an indole residue, a benzofuran residue, and a benzothiophene residue.

The alkyl group or the cycloalkyl group is preferably a linear alkyl group having 1 to 15 carbon atoms, a branched alkyl group having 3 to 15 carbon atoms, or a cycloalkyl group having 3 to 15 carbon atoms, and examples thereof include a methyl group, an ethyl group, a propyl group, a n-butyl group, a sec-butyl group, a t-butyl group, a cyclopropyl group, a cyclobutyl group, and a cyclohexyl group.

Substituents that the aryl group, the alkyl group, and the cycloalkyl group in $R^{301}$ and $R^{302}$ may have may each independently be an alkyl group (having, for example, 1 to 15 carbon atoms), a cycloalkyl group (having, for example, 3 to 15 carbon atoms), an aryl group (having, for example, 6 to 14 carbon atoms), an alkoxy group (having, for example, 1 to 15 carbon atoms), a cycloalkylalkoxy group (having, for example, 1 to 15 carbon atoms), a halogen atom, a hydroxy group, or a phenylthio group.

The divalent linking group serving as $R^{303}$ is not particularly limited, but preferably represents an alkylene group, a cycloalkylene group, an aromatic group, or a group provided by combining two or more of these.

The alkylene group may be linear or branched, and preferably has 1 to 20 carbon atoms, more preferably 1 to 10 carbon atoms.

The cycloalkylene group may be monocyclic or polycyclic, and preferably has 3 to 20 carbon atoms, more preferably 3 to 10 carbon atoms.

The aromatic group is a divalent aromatic group, preferably an aromatic group having 6 to 20 carbon atoms, more preferably an aromatic group having 6 to 15 carbon atoms.

The aromatic ring constituting the aromatic group is not particularly limited, but may be, for example, an aromatic ring having 6 to 20 carbon atoms, and specific examples thereof include a benzene ring, a naphthalene ring, an anthracene ring, and a thiophene ring. A benzene ring or a naphthalene ring is preferred, and a benzene ring is more preferred.

The alkylene group, the cycloalkylene group, and the aromatic group may further have a substituent.

In Formula (ZBII) above, $R^{304}$ represents an aryl group, an alkyl group, or a cycloalkyl group. $R^{305}$ represents a divalent linking group.

The aryl group in $R^{304}$ is preferably a phenyl group or a naphthyl group, more preferably a phenyl group. The aryl group in $R^{304}$ may be an aryl group having a heterocycle having an oxygen atom, a nitrogen atom, a sulfur atom, or the like. Examples of the skeleton of the aryl group having a heterocycle include pyrrole, furan, thiophene, indole, benzofuran, and benzothiophene.

The alkyl group and the cycloalkyl group in $R^{304}$ are preferably a linear alkyl group having 1 to 10 carbon atoms or a branched alkyl group having 3 to 10 carbon atoms (such as a methyl group, an ethyl group, a propyl group, a butyl group, or a pentyl group), or a cycloalkyl group having 3 to 10 carbon atoms (such as a cyclopentyl group, a cyclohexyl group, or a norbornyl group).

The aryl group, the alkyl group, and the cycloalkyl group in $R^{304}$ may each independently have a substituent. Examples of the substituent that the aryl group, the alkyl group, and the cycloalkyl group in $R^{304}$ may have include alkyl groups (having, for example, 1 to 15 carbon atoms), cycloalkyl groups (having, for example, 3 to 15 carbon atoms), aryl group (having, for example, 6 to 15 carbon atoms), alkoxy groups (having, for example, 1 to 15 carbons), halogen atoms, a hydroxy group, and a phenylthio group.

The divalent linking group serving as $R^{305}$ is not particularly limited, but preferably represents an alkylene group, a cycloalkylene group, an aromatic group, or a group provided by combining two or more of these.

The alkylene group may be linear or branched, and preferably has 1 to 20 carbon atoms, more preferably 1 to 10 carbon atoms.

The cycloalkylene group may be monocyclic or polycyclic, and preferably has 3 to 20 carbon atoms, more preferably 3 to 10 carbon atoms.

The aromatic group is a divalent aromatic group, preferably an aromatic group having 6 to 20 carbon atoms, more preferably an aromatic group having 6 to 15 carbon atoms.

The aromatic ring constituting the aromatic group is not particularly limited, but may be, for example, an aromatic ring having 6 to 20 carbon atoms, and specific examples thereof include a benzene ring, a naphthalene ring, an anthracene ring, and a thiophene ring. The aromatic ring constituting the aromatic group is preferably a benzene ring or a naphthalene ring, more preferably a benzene ring.

The alkylene group, the cycloalkylene group, and the aromatic group may further have a substituent.

The organic anion represented by $X_B^-$ in Formula (O2) is preferably a non-nucleophilic anion (an anion having a very low ability to cause a nucleophilic reaction).

Examples of the non-nucleophilic anion include sulfonate anions (such as aliphatic sulfonate anions, aromatic sulfonate anions, and a camphorsulfonate anion), carboxylate anions (such as aliphatic carboxylate anions, aromatic carboxylate anions, and aralkyl carboxylate anions), sulfonylimide anions, bis(alkylsulfonyl)imide anions, and tris(alkylsulfonyl)methide anions.

The aliphatic moieties in the aliphatic sulfonate anions and the aliphatic carboxylate anions may each be an alkyl group or a cycloalkyl group, and is preferably a linear or branched alkyl group having 1 to 30 carbon atoms, or a cycloalkyl group having 3 to 30 carbon atoms.

The alkyl group may be, for example, a fluoroalkyl group (which may or may not have a substituent other than a fluorine atom, and may be a perfluoroalkyl group).

The aryl groups in the aromatic sulfonate anions and the aromatic carboxylate anions are each preferably an aryl group having 6 to 14 carbon atoms, and examples thereof include a phenyl group, a tolyl group, and a naphthyl group.

The above-mentioned alkyl group, cycloalkyl group, and aryl group may have a substituent. Specific examples of the substituent include, but are not particularly limited to, a nitro group, halogen atoms such as a fluorine atom and a chlorine atom, a carboxy group, a hydroxy group, an amino group, a cyano group, alkoxy groups (preferably having 1 to 15 carbon atoms), alkyl groups (preferably having 1 to 10 carbon atoms), cycloalkyl groups (preferably having 3 to 15 carbon atoms), aryl groups (preferably having 6 to 14 carbon atoms), alkoxycarbonyl groups (preferably having 2 to 7 carbon atoms), acyl groups (preferably having 2 to 12 carbon atoms), alkoxycarbonyloxy groups (preferably having 2 to 7 carbon atoms), alkylthio groups (preferably having 1 to 15 carbon atoms), alkylsulfonyl groups (preferably having 1 to 15 carbon atoms), alkyliminosulfonyl groups (preferably having 1 to 15 carbon atoms), and aryloxysulfonyl groups (preferably having 6 to 20 carbon atoms).

The aralkyl groups in the aralkyl carboxylate anions are each preferably an aralkyl group having 7 to 14 carbon atoms, and examples thereof include a benzyl group, a phenethyl group, a naphthylmethyl group, a naphthylethyl group, and a naphthylbutyl group.

An example of the sulfonylimide anions is a saccharin anion.

The alkyl groups in the bis(alkylsulfonyl)imide anions and the tris(alkylsulfonyl)methide anions are preferably alkyl groups having 1 to 5 carbon atoms. A substituent of such an alkyl group may be a halogen atom, an alkyl group substituted with a halogen atom, an alkoxy group, an alkylthio group, an alkyloxysulfonyl group, an aryloxysulfonyl group, or a cycloalkylaryloxysulfonyl group, and is preferably a fluorine atom or an alkyl group substituted with a fluorine atom.

The alkyl groups in such a bis(alkylsulfonyl)imide anion may be bonded together to form a ring structure. This increases the acid strength.

The non-nucleophilic anion is preferably an aliphatic sulfonate anion in which at least the $\alpha$ position of sulfonic acid is substituted with a fluorine atom, an aromatic sulfonate anion substituted with a fluorine atom or a group having a fluorine atom, a bis(alkylsulfonyl)imide anion in which the alkyl groups are substituted with fluorine atoms, or a tris(alkylsulfonyl)methide anion in which the alkyl groups are substituted with fluorine atoms.

The organic anion represented by $X_B^-$ in Formula (O2) is also preferably, for example, an organic anion represented by Formula (DA) below.

$$\overset{\ominus}{A_{31}}-L_{a1}-R_{a1} \quad \text{(DA)}$$

In Formula (DA), $A^{31-}$ represents an anionic group. $R_{a1}$ represents a hydrogen atom or a monovalent organic group. $L_{a1}$ represents a single bond or a divalent linking group.

$A^{31-}$ represents an anionic group. The anionic group represented by $A^{31-}$ is not particularly limited, but is preferably, for example, a group selected from the group consisting of groups represented by Formulae (B-1) to (B-14) above.

The monovalent organic group in $R_{a1}$ is not particularly limited, but generally has 1 to 30 carbon atoms, preferably 1 to 20 carbon atoms.

$R_{a1}$ is preferably an alkyl group, a cycloalkyl group, or an aryl group.

The alkyl group may be linear or branched, and is preferably an alkyl group having 1 to 20 carbon atoms, more preferably an alkyl group having 1 to 15 carbon atoms, still more preferably an alkyl group having 1 to 10 carbon atoms.

The cycloalkyl group may be monocyclic or polycyclic, and is preferably a cycloalkyl group having 3 to 20 carbon atoms, more preferably a cycloalkyl group having 3 to 15 carbon atoms, still more preferably a cycloalkyl group having 3 to 10 carbon atoms.

The aryl group may be monocyclic or polycyclic, and is preferably an aryl group having 6 to 20 carbon atoms, more preferably an aryl group having 6 to 15 carbon atoms, still more preferably an aryl group having 6 to 10 carbon atoms.

The cycloalkyl group may include a heteroatom as a ring member atom.

The heteroatom is not particularly limited, and may be, for example, a nitrogen atom or an oxygen atom.

The cycloalkyl group may include a carbonyl bond (>C=O) as a ring member atom.

The alkyl group, the cycloalkyl group, and the aryl group may further have a substituent.

The divalent linking group serving as $L_{a1}$ is not particularly limited, but represents an alkylene group, a cycloalkylene group, an aromatic group, -O-, -CO-, -COO-, or a group provided by combining two or more of these.

The alkylene group may be linear or branched, and preferably has 1 to 20 carbon atoms, more preferably 1 to 10 carbon atoms.

The cycloalkylene group may be monocyclic or polycyclic, and preferably has 3 to 20 carbon atoms, more preferably 3 to 10 carbon atoms.

The aromatic group is a divalent aromatic group, preferably an aromatic group having 6 to 20 carbon atoms, more preferably an aromatic group having 6 to 15 carbon atoms.

The aromatic ring constituting the aromatic group is not particularly limited, but may be, for example, an aromatic ring having 6 to 20 carbon atoms, and specific examples thereof include a benzene ring, a naphthalene ring, an anthracene ring, and a thiophene ring. The aromatic ring constituting the aromatic group is preferably a benzene ring or a naphthalene ring, more preferably a benzene ring.

The alkylene group, the cycloalkylene group, and the aromatic group may further have a substituent, and the substituent is preferably a halogen atom.

$A^{31-}$ and $R_{a1}$ may be bonded together to form a ring.

Mechanism in Which Polarity-Decreasing Group Is Acid-Decomposable Group Having Structure Provided by Protecting Polar Group with Protective Group That Leaves Due to Action of Acid, and Polar Group Generated after Acid Decomposition Is More Hydrophobic Than Acid-Decomposable Group before Acid Decomposition

The polarity-decreasing group may be, for example, an acid-decomposable group having a structure provided by protecting a polar group with a protective group that leaves due to action of acid, in which the polar group generated after acid decomposition is more hydrophobic than the acid-decomposable group before acid decomposition.

Examples of the acid-decomposable group include groups having the following configurations.

The acid-decomposable group refers to a group that is decomposed due to action of acid to generate a polar group and typically has a structure in which the polar group is protected with a leaving group that leaves due to action of acid.

The polar group is preferably an alkali soluble group, and examples thereof include acidic groups such as a carboxyl group, a phenolic hydroxy group, fluorinated alcohol groups, a sulfonic group, a phosphate group, a sulfonamide group, a sulfonylimide group, (alkylsulfonyl)(alkylcarbonyl)methylene groups, (alkylsulfonyl)(alkylcarbonyl)imide groups, bis(alkylcarbonyl)methylene groups, bis(alkylcarbonyl)imide groups, bis(alkylsulfonyl)methylene groups, bis(alkylsulfonyl)imide groups, tris(alkylcarbonyl)methylene groups, and tris(alkylsulfonyl)methylene groups, and an alcoholic hydroxy group.

Of these, the polar group is preferably a carboxyl group, a phenolic hydroxy group, a fluorinated alcohol group (preferably a hexafluoroisopropanol group), or a sulfonic group.

Examples of the leaving group that leaves due to action of acid include groups represented by Formulae (Y1) to (Y4).

Formula (Y1): $-C(Rx_1)(Rx_2)(Rx_3)$

Formula (Y2): $-C(=O)OC(Rx_1)(Rx_2)(Rx_3)$

Formula (Y3): $-C(R_{36})(R_{37})(OR_{38})$

Formula (Y4): -C(Rn)(H)(Ar)

In Formula (Y1) and Formula (Y2), $Rx_1$ to $Rx_3$ each independently represent an alkyl group (linear or branched), a cycloalkyl group (monocyclic or polycyclic), an alkenyl group (linear or branched), or an aryl group (monocyclic or polycyclic). Note that, when all of $Rx_1$ to $Rx_3$ are alkyl groups (linear or branched), at least two of $Rx_1$ to $Rx_3$ are preferably methyl groups.

In particular, $Rx_1$ to $Rx_3$ preferably each independently represent a linear or branched alkyl group, and $Rx_1$ to $Rx_3$ more preferably each independently represent a linear alkyl group.

Two of $Rx_1$ to $Rx_3$ may be bonded together to form a monocycle or a polycycle.

The alkyl group in $Rx_1$ to $Rx_3$ is preferably an alkyl group having 1 to 5 carbon atoms, such as a methyl group, an ethyl group, a n-propyl group, an isopropyl group, a n-butyl group, an isobutyl group, or a t-butyl group.

The cycloalkyl group in $Rx_1$ to $Rx_3$ is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group.

The aryl group in $Rx_1$ to $Rx_3$ is preferably an aryl group having 6 to 10 carbon atoms, for example, a phenyl group, a naphthyl group, or an anthryl group.

The alkenyl group in $Rx_1$ to $Rx_3$ is preferably a vinyl group.

The ring formed by bonding two of $Rx_1$ to $Rx_3$ together is preferably a cycloalkyl group. The cycloalkyl group formed by bonding two of $Rx_1$ to $Rx_3$ together is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group, more preferably a monocyclic cycloalkyl group having 5 or 6 carbon atoms.

In the cycloalkyl group formed by bonding two of $Rx_1$ to $Rx_3$ together, for example, one of methylene groups constituting the ring may be replaced by a heteroatom such as an oxygen atom, a group having a heteroatom, such as a carbonyl group, or a vinylidene group. In the cycloalkyl group, one or more ethylene groups constituting the cycloalkane ring may be replaced by vinylene groups.

The group represented by Formula (Y1) or Formula (Y2) preferably has an embodiment in which, for example, $Rx_1$ is a methyl group or an ethyl group, and $Rx_2$ and $Rx_3$ are bonded together to form the above-described cycloalkyl group.

When the resist composition satisfying the requirement X is, for example, a resist composition for EUV exposure, the alkyl group, the cycloalkyl group, the alkenyl group, and the aryl group represented by $Rx_1$ to $Rx_3$ and the ring formed by bonding two of $Rx_1$ to $Rx_3$ together also preferably further have, as a substituent, a fluorine atom or an iodine atom.

In Formula (Y3), $R_{36}$ to $R_{38}$ each independently represent a hydrogen atom or a monovalent organic group. $R_{37}$ and $R_{38}$ may be bonded together to form a ring. The monovalent organic group may be, for example, an alkyl group, a cycloalkyl group, an aryl group, an aralkyl group, or an alkenyl group. $R_{36}$ is also preferably a hydrogen atom.

Note that the alkyl group, the cycloalkyl group, the aryl group, and the aralkyl group may include a heteroatom such as an oxygen atom and/or a group having a heteroatom, such as a carbonyl group. For example, in the alkyl group, the cycloalkyl group, the aryl group, and the aralkyl group, for example, one or more methylene groups may be replaced by a heteroatom such as an oxygen atom and/or a group having a heteroatom, such as a carbonyl group. An example of such a group is an alkylcarbonyl group.

When the resist composition is, for example, a resist composition for EUV exposure, the monovalent organic group represented by $R_{36}$ to $R_{38}$ and the ring formed by bonding $R_{37}$ and $R_{38}$ together also preferably further have, as a substituent, a fluorine atom or an iodine atom.

Formula (Y3) is preferably a group represented by Formula (Y3-1) below.

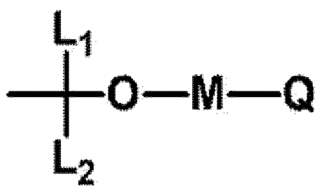

(Y3-1)

Here, $L_1$ and $L_2$ each independently represent a hydrogen atom, an alkyl group, a cycloalkyl group, an aryl group, or a combination thereof (for example, a group formed by provided an alkyl group and an aryl group).

M represents a single bond or a divalent linking group.

Q represents an alkyl group that may include a heteroatom, a cycloalkyl group that may include a heteroatom, an aryl group that may include a heteroatom, an amino group, an ammonium group, a mercapto group, a cyano group, an aldehyde group, or a combination thereof (for example, a group provided by combining an alkyl group and a cycloalkyl group).

In the alkyl group and the cycloalkyl group, for example, one of methylene groups may be replaced by a heteroatom such as an oxygen atom or a group having a heteroatom, such as a carbonyl group.

Note that one of $L_1$ and $L_2$ is preferably a hydrogen atom and the other is preferably an alkyl group, a cycloalkyl group, an aryl group, or a group provided by combining an alkylene group and an aryl group.
At least two of Q, M, and $L_1$ may be bonded together to form a ring (preferably a five-membered or six-membered ring).
From the viewpoint of miniaturization of patterns, $L_2$ is preferably a secondary or tertiary alkyl group, more preferably a tertiary alkyl group. The secondary alkyl group may be, for example, an isopropyl group, a cyclohexyl group, or a norbornyl group, and the tertiary alkyl group may be, for example, a tert-butyl group or an adamantane group. In these embodiments, since Tg (glass transition temperature) and activation energy of the resin into which the acid-decomposable group is introduced are increased, film hardness is ensured, and fogging can be suppressed.
When the resist composition is, for example, a resist composition for EUV exposure, the alkyl group, the cycloalkyl group, the aryl group, and the combination thereof, the groups being represented by $L_1$ and $L_2$, also preferably further have, as a substituent, a fluorine atom or an iodine atom. It is also preferable that the alkyl group, the cycloalkyl group, the aryl group, and the aralkyl group include, in addition to a fluorine atom and an iodine atom, a heteroatom such as an oxygen atom (specifically, in the alkyl group, the cycloalkyl group, the aryl group, and the aralkyl group, for example, one of methylene groups be replaced by a heteroatom such as an oxygen atom or a group having a heteroatom, such as a carbonyl group).
It is also preferable that when the resist composition is, for example, a resist composition for EUV exposure, in the alkyl group that may include a heteroatom, the cycloalkyl group that may include a heteroatom, the aryl group that may include a heteroatom, the amino group, the ammonium group, the mercapto group, the cyano group, the aldehyde group, and the combination thereof, the groups being represented by Q, the heteroatom be a heteroatom selected from the group consisting of a fluorine atom, an iodine atom, and an oxygen atom.
In Formula (Y4), Ar represents an aromatic ring group. Rn represents an alkyl group, a cycloalkyl group, or an aryl group. Rn and Ar may be bonded together to form a non-aromatic ring. Ar is more preferably an aryl group.
When the resist composition is, for example, a resist composition for EUV exposure, the aromatic ring group represented by Ar, and the alkyl group, the cycloalkyl group, and the aryl group represented by Rn also preferably have, as a substituent, a fluorine atom and an iodine atom.
From the viewpoint of further improving acid decomposability, in the leaving group protecting the polar group, when a non-aromatic ring is directly bonded to the polar group (or a residue thereof), a ring member atom adjacent to a ring member atom directly bonded to the polar group (or a residue thereof) in the non-aromatic ring also preferably does not have, as a substituent, a halogen atom such as a fluorine atom.
Alternatively, the leaving group that leaves due to action of acid may be a 2-cyclopentenyl group having a substituent (e.g., an alkyl group), such as 3-methyl-2-cyclopentenyl group, or a cyclohexyl group having a substituent (e.g., an alkyl group), such as a 1,1,4,4-tetramethylcyclohexyl group.
The acid-decomposable group serving as the polarity-decreasing group corresponds to a group in which a polar group generated after acid decomposition is more hydrophobic than the acid-decomposable group before acid decomposition.
Whether or not the polar group generated after acid decomposition is more hydrophobic than the acid-decomposable group before acid decomposition is determined by determining logP (octanol/water partition coefficient) based on each of the chemical structures of the acid-decomposable group and the polar group, and determining on the basis of the obtained values. The logP can be calculated using, for example, ChemBioDraw Ultra (Version16.0.14).
Accordingly, the acid-decomposable group serving as the polarity-decreasing group corresponds to an acid-decomposable group having a structure in which a polar group is protected with a protective group that leaves due to action of acid, where the logP of the acid-decomposable group is smaller than the logP of the polar group after the protective group leaves.
The difference between the logP of the acid-decomposable group and the logP of the polar group is not particularly limited, but is, for example, preferably 0.3 or more, more preferably 0.6 or more.

Repeating Unit Having Polarity-Decreasing Group

The resin preferably has a repeating unit having a polarity-decreasing group.
Examples of the repeating unit having a polarity-decreasing group include repeating units represented by any one of Formulae (I) to (IV) below.

Repeating Unit Represented by Formula (I)

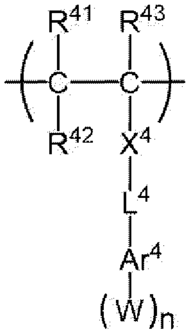

(I)

In Formula (I),

$R^{41}$, $R^{42}$, and $R^{43}$ each independently represent a hydrogen atom, an alkyl group, a cycloalkyl group, a halogen atom, a cyano group, or an alkoxycarbonyl group. However, $R^{42}$ may be bonded to $Ar^4$ to form a ring, and in such a case, $R^{42}$ represents a single bond or an alkylene group.

$X^4$ represents a single bond, -COO-, or -CONR$^{64}$-, where $R^{64}$ represents a hydrogen atom or an alkyl group.

$L^4$ represents a single bond or an alkylene group.

$Ar^4$ represents an (n + 1)-valent aromatic ring group or an (n + 1)-valent alicyclic group, and when $Ar^4$ is bonded to $R^{42}$ to form a ring, $Ar^4$ represents an (n + 2)-valent aromatic ring group or an (n + 2)-valent alicyclic group.

W represents a group represented by Formula (KD1) above (polarity-decreasing group).

n represents an integer of 1 to 5.

In $R^{41}$, $R^{42}$, and $R^{43}$ in Formula (I), the alkyl group is preferably an alkyl group having 20 or less carbon atoms, such as a methyl group, an ethyl group, a propyl group, an isopropyl group, a n-butyl group, a sec-butyl group, a hexyl group, a 2-ethylhexyl group, an octyl group, or a dodecyl group, more preferably an alkyl group having 8 or less carbon atoms, still more preferably an alkyl group having 3 or less carbon atoms.

In $R^{41}$, $R^{42}$, and $R^{43}$ in Formula (I), the cycloalkyl group may be monocyclic or polycyclic. In particular, monocyclic cycloalkyl groups having 3 to 8 carbon atoms, such as a cyclopropyl group, a cyclopentyl group, and a cyclohexyl group, are preferred.

In $R^{41}$, $R^{42}$, and $R^{43}$ in Formula (I), the halogen atom may be a fluorine atom, a chlorine atom, a bromine atom, or an iodine atom, and is preferably a fluorine atom.

The alkyl group included in the alkoxycarbonyl group in $R^{41}$, $R^{42}$, and $R^{43}$ in Formula (I) is preferably the same as the alkyl group in $R^{41}$, $R^{42}$, and $R^{43}$ above.

Each of the groups represented by $R^{41}$, $R^{42}$, and $R^{43}$ may have a substituent.

$Ar^4$ represents an (n + 1)-valent aromatic ring group or an (n + 1)-valent alicyclic group.

The divalent aromatic ring group in the case where n is 1 is preferably, for example, an arylene group having 6 to 18 carbon atoms, such as a phenylene group, a tolylene group, a naphthylene group, or an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, or a thiazole ring. Of these, an arylene group is preferred, and a phenylene group or a naphthalene group is more preferred.

Specific examples of the (n + 1)-valent aromatic ring group in the case where n is an integer of 2 or more include groups provided by removing any (n - 1) hydrogen atoms from any of the foregoing specific examples of the divalent aromatic ring group.

The (n + 1)-valent alicyclic group represented by $Ar^4$ may be, for example, a group provided by removing any (n + 1) hydrogen atoms from a polycyclic cycloalkane such as norbornene, tetracyclodecane, tetracyclododecane, or adamantane.

The (n + 1)-valent aromatic ring group and the (n + 1)-valent alicyclic group may further have a substituent.

Examples of substituents that the above alkyl group, cycloalkyl group, alkoxycarbonyl group, alkylene group, and (n + 1)-valent aromatic ring group or alicyclic group can have include the alkyl groups described in $R^{41}$, $R^{42}$, and $R^{43}$ in Formula (I); alkoxy groups such as a methoxy group, an ethoxy group, a hydroxyethoxy group, a propoxy group, a hydroxypropoxy group, and a butoxy group; aryl groups such as a phenyl group; and halogen atoms.

The alkyl group in $R^{64}$ in -CONR$^{64}$- (where $R^{64}$ represents a hydrogen atom or an alkyl group) represented by $X^4$ may be an alkyl group having 20 or less carbon atoms, such as a methyl group, an ethyl group, a propyl group, an isopropyl group, a n-butyl group, a sec-butyl group, a hexyl group, a 2-ethylhexyl group, an octyl group, or a dodecyl group, and is preferably an alkyl group having 8 or less carbon atoms.

$X^4$ is preferably a single bond, -COO-, or -CONH-, more preferably a single bond or - COO-.

The alkylene group in $L^4$ is preferably an alkylene group having 1 to 8 carbon atoms, such as a methylene

group, an ethylene group, a propylene group, a butylene group, a hexylene group, or an octylene group.

Examples of the repeating unit represented by Formula (I) are as follows. In the formulae, a represents 1 or 2. W represents a group represented by Formula (KD1) above (polarity-decreasing group). R represents a hydrogen atom or a substituent.

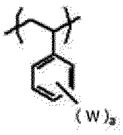
(B-1)

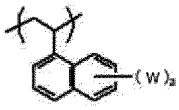
(B-2)

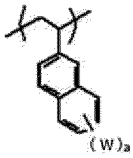
(B-3)

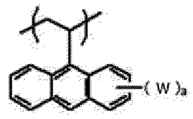
(B-4)

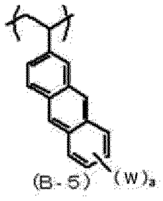
(B-5)

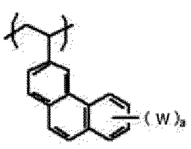
(B-6)

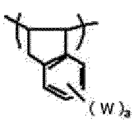
(B-7)

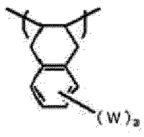
(B-8)

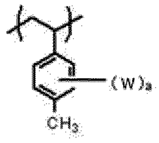
(B-9)

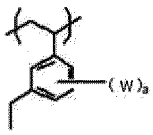
(B-10)

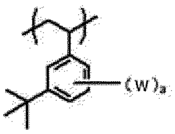
(B-11)

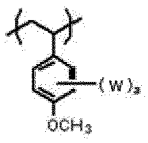
(B-12)

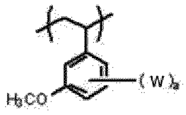
(B-13)

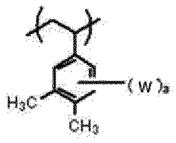
(B-14)

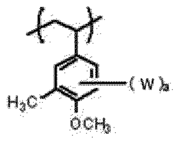
(B-15)

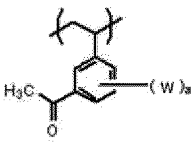
(B-16)

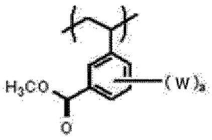
(B-17)

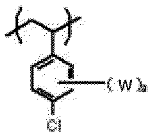
(B-18)

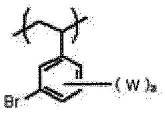
(B-19)

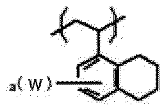
(B-20)

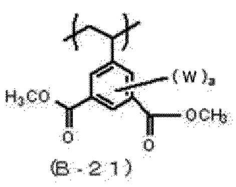
(B-21)

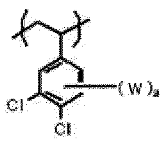
(B-22)

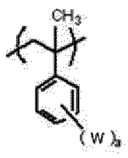
(B-23)

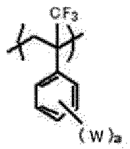
(B-24)

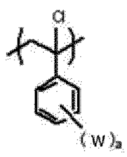
(B-25)

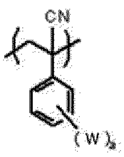
(B-26)

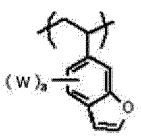
(B-27)

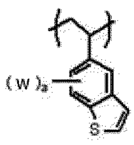
(B-28)

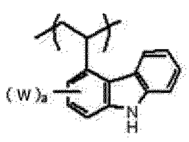
(B-29)

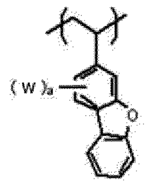
(B-30)

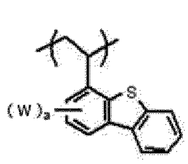
(B-31)

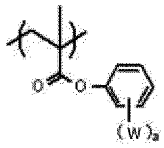
(B-32)

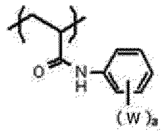
(B-33)

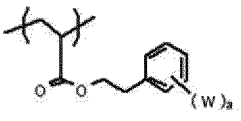
(B-34)

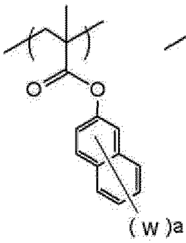
(B-35)

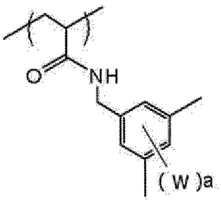
(B-36)

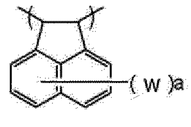
(B-37)

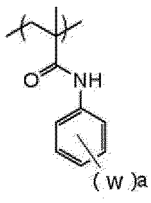
(B-38)

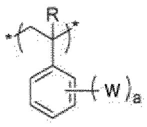

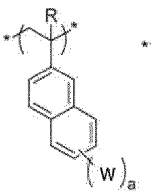

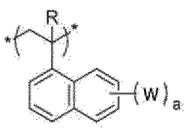

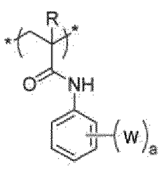

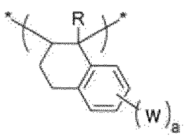

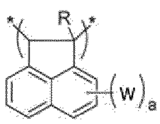

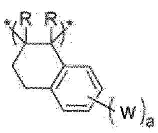

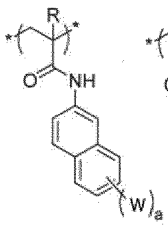

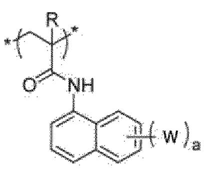

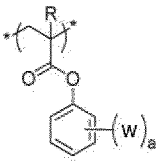

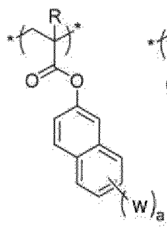

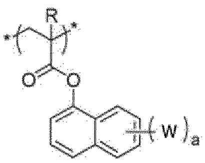

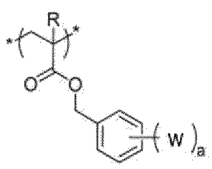

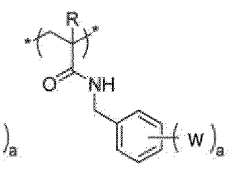

Repeating Unit Represented by Formula (II)

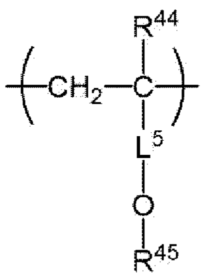
(II)

$L^5$ represents a divalent linking group.

Examples of the divalent linking group represented by $L^5$ include -CO-, -O-, -S-, -SO-, - $SO_2$-, hydrocarbon

groups (such as an alkylene group, a cycloalkylene group, an alkenylene group, and an arylene group), and a linking group provided by linking a plurality of these together. The hydrocarbon groups may have a substituent. The substituent is not particularly limited, and may be, for example, a fluorine atom or an iodine atom.

In particular, the divalent linking group represented by $L^5$ is preferably -CO-, an arylene group, or -arylene group-alkylene group-, more preferably -CO- or an -arylene group.

The arylene group is preferably a phenylene group.

The alkylene group may be linear or branched. The number of carbon atoms of the alkylene group is not particularly limited, but is preferably 1 to 10, more preferably 1 to 3.

$R^{44}$ represents a hydrogen atom, a fluorine atom, an iodine atom, an alkyl group, or an aryl group.

The alkyl group may be linear or branched. The number of carbon atoms of the alkyl group is not particularly limited, but is preferably 1 to 10, more preferably 1 to 3.

The alkyl group and the aryl group represented by $R^{44}$ may have a substituent. The substituent is not particularly limited, and may be, for example, a fluorine atom or an iodine atom.

$R^{45}$ represents a leaving group that leaves due to action of acid.

Examples of the leaving group that leaves due to action of acid and represented by $R^{45}$ include the above-described leaving groups represented by Formulae (Y1) to (Y4).

A preferred embodiment of $L_1$, $R_1$, and $R_2$ is an embodiment in which at least one of $L_1$, $R_1$, or $R_2$ has a fluorine atom or an iodine atom.

Here, when the repeating unit represented by Formula (II) includes an acid-decomposable group having a structure in which a polar group is protected with a leaving group, the polar group generated after acid decomposition is more hydrophobic than the acid-decomposable group before acid decomposition. Specifically, the logP of the acid-decomposable group is smaller than the logP of the polar group after the protective group leaves.

Repeating Unit Represented by Formula (III)

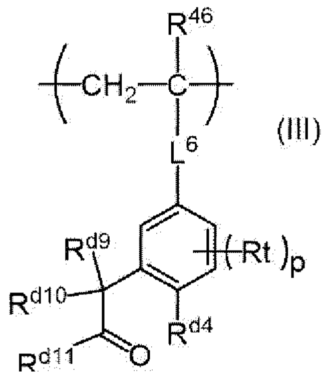

(III)

$R^{46}$ represents a hydrogen atom, a fluorine atom, an iodine atom, an alkyl group, or an aryl group.

The alkyl group may be linear or branched. The number of carbon atoms of the alkyl group is not particularly limited, but is preferably 1 to 10, more preferably 1 to 3.

The alkyl group and the aryl group represented by $R^{44}$ may have a substituent. The substituent is not particularly limited, and may be, for example, a fluorine atom or an iodine atom.

$L^6$ represents a single bond or a divalent linking group.

Examples of the divalent linking group represented by $L^6$ include -CO-, -O-, -S-, -SO-, - $SO_2$-, hydrocarbon groups (such as an alkylene group, a cycloalkylene group, an alkenylene group, and an arylene group), and a linking group provided by linking a plurality of these together. The hydrocarbon groups may have a substituent. The substituent is not particularly limited, and may be, for example, a fluorine atom or an iodine atom.

The divalent linking group represented by $L^6$ is preferably -COO-.

$R^{d4}$ and $R^{d9}$ to $R^{d11}$ have the same definitions and preferred embodiments as in the above-described $R^{d4}$ and $R^{d9}$ to $R^{d11}$, respectively, in Formula (KD2).

$R^t$ represents a substituent. The substituent is not particularly limited, and may be, for example, an alkyl group having 1 to 6 carbon atoms, an alkoxy group having 1 to 6 carbon atoms, a fluorine atom, or an iodine atom.

p represents an integer of 0 to 3.

Repeating Unit Represented by Formula (IV)

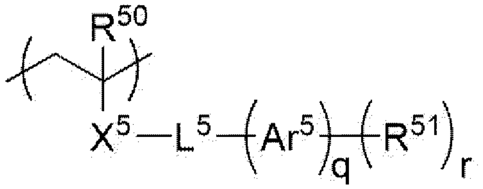

(IV)

In Formula (IV) above, $R^{50}$ represents a hydrogen atom, a halogen atom, or an alkyl group that may have a substituent.

$X^5$ represents a single bond, -COO-, or -CONR$^{52}$-, where $R^{52}$ represents a hydrogen atom or an alkyl group.

$L^5$ represents a single bond or a divalent linking group.

$Ar^5$ represents an (r + 1)-valent aromatic ring group or alicyclic group.

$R^{51}$ represent an onium salt group.

q represents 0 or 1.

When q is 0, r represents 1. When q is 1, r represents an integer of 1 to 4.

The alkyl group represented by $R^{50}$ may be linear, branched, or cyclic. The number of carbon atoms of the alkyl group is preferably 1 to 12, more preferably 1 to 6, still more preferably 1 to 3. The alkyl group represented by $R^{50}$ may have a substituent. The substituent is not particularly limited, but may be, for example, a halogen atom or a hydroxy group.

The alkyl group in $R^{64}$ in -CONR$^{64}$- (where $R^{64}$ represents a hydrogen atom or an alkyl group) represented by $X^5$ may be an alkyl group having 20 or less carbon atoms, such as a methyl group, an ethyl group, a propyl group, an isopropyl group, a n-butyl group, a sec-butyl group, a hexyl group, a 2-ethylhexyl group, an octyl group, or a dodecyl group, and is preferably an alkyl group having 8 or less carbon atoms.

$X^5$ is preferably a single bond, -COO-, or -CONH-, more preferably a single bond or - COO-.

Examples of the divalent linking group represented by $L^5$ include, but are not particularly limited to, -CO-, -O-, -SO-, -$SO_2$-, -NR$^A$-, an alkylene group (which preferably has 1 to 6 carbon atoms and may be linear or branched), and a divalent linking group provided by combining a plurality of these. The alkylene group may have a substituent. The substituent may be, for example, a halogen atom or a hydroxy group. $R^A$ may be a hydrogen atom or an alkyl group having 1 to 6 carbon atoms.

$Ar^5$ represents an (r + 1)-valent aromatic ring group or an (r + 1)-valent alicyclic group.

The divalent aromatic ring group in the case where r is 1 is preferably, for example, an arylene group having 6 to 18 carbon atoms, such as a phenylene group, a tolylene group, a naphthylene group, or an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, or a thiazole ring. Of these, an arylene group is preferred, and a phenylene group or a naphthalene group is more preferred. The aromatic ring group may have a substituent other than $R^{51}$.

Specific examples of the (r + 1)-valent aromatic ring group in the case where r is an integer of 2 or more include groups provided by removing any (r - 1) hydrogen atoms from any of the foregoing specific examples of the divalent aromatic ring group.

The (r + 1)-valent alicyclic group represented by $Ar^5$ may include a heteroatom such as an oxygen atom and a carbonyl carbon. Examples of the (r + 1)-valent alicyclic group represented by $Ar^5$ include groups provided by removing any r hydrogen atoms from a polycyclic cycloalkane such as norbornene, tetracyclodecane, tetracyclododecane, or adamantane. The (r + 1)-valent alicyclic group represented by $Ar^5$ may be a group provided by removing any r hydrogen atoms from a lactone ring or a sultone ring. The lactone ring or the sultone ring is preferably a five- to seven-membered lactone ring, more preferably a five- to seven-membered lactone ring or sultone ring to which another ring structure is fused so as to form a bicyclo structure or a spiro structure.

The (r + 1)-valent aromatic ring group and the (r + 1)-valent alicyclic group may further have a substituent.

Examples of the substituent include the alkyl groups described in $R^{50}$ in Formula (IV); alkoxy groups such as a methoxy group, an ethoxy group, a hydroxyethoxy group, a propoxy group, a hydroxypropoxy group, and a butoxy group; aryl groups such as a phenyl group; and halogen atoms.

In Formula (IV) above, an onium salt group is represented. The onium salt group is as described above.

In the resin, one or more repeating units having a polarity-decreasing group may be included, or two or more of such repeating units may be included.

In the resin, the content of the repeating unit having a polarity-decreasing group is preferably 5 mol% or more, more preferably 10 mol% or more relative to all the repeating units in the resin. The upper limit value thereof is preferably 100 mol% or less, more preferably 90 mol% or less, still more preferably 80 mol% or less.

Interactive Group

The interactive group will be described below.

The interactive group is a group that forms an interaction with an onium salt compound and that is released from the interaction due to action of exposure, acid, base, or heating.

The interactive group is preferably a group capable of forming an association structure due to an interaction with the onium salt compound, more preferably a group having a proton donor property or a proton acceptor property. The group having a proton donor property corresponds to a group having a free hydrogen atom, and the group having a proton acceptor property may be, for example, a group having a lone pair, such as a nitrogen atom or an oxygen atom. The interactive group is particularly preferably a phenolic hydroxy group, a carboxyl group, a sulfonic group, an amide group, or a sulfonamide group from the viewpoint of better interaction with the onium salt compound.

The phenolic hydroxy group means a hydroxy group bonded, as a substituent, to a ring member atom of an aromatic ring.

The aromatic ring is not limited to a benzene ring, and may be an aromatic hydrocarbon ring or an aromatic heterocycle. The aromatic ring may be monocyclic or polycyclic.

The amide group is not particularly limited, but may be, for example, -C(=O)-NHR$^B$ (where R$^B$ represents a hydrogen atom or an alkyl group having 1 to 5 carbon atoms).

The amino group is not particularly limited, but may be, for example, -NHR$^C$ (where R$^C$ represents a hydrogen atom or an alkyl group having 1 to 5 carbon atoms).

Note that when the resist composition includes an onium salt compound and a capping agent, for example, a carboxyl group in the resin corresponds to both an interactive group and a polar group.

Polar Group

The polar group is not particularly limited, but is preferably, for example, an alcoholic hydroxy group, a phenolic hydroxy group, or a carboxyl group from the viewpoint of better reactivity with a capping agent described later.

The phenolic hydroxy group means a hydroxy group bonded, as a substituent, to a ring member atom of an aromatic ring.

The aromatic ring is not limited to a benzene ring, and may be an aromatic hydrocarbon ring or an aromatic heterocycle. The aromatic ring may be monocyclic or polycyclic.

The alcoholic hydroxy group is distinguished from the phenolic hydroxy group and means, in the present specification, a hydroxy group bonded, as a substituent, to an aliphatic hydrocarbon group.

Repeating Unit Represented by Formula (T1)

The resin preferably has a repeating unit represented by Formula (T1).

The repeating unit represented by Formula (T1) is a repeating unit having one or more selected from the group consisting of an interactive group and a polar group.

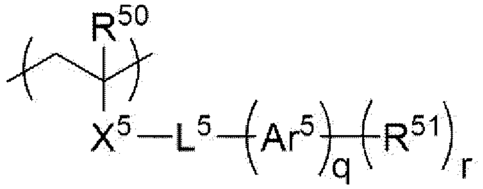

(T1)

In Formula (T1) above, R$^{50}$ represents a hydrogen atom, a halogen atom, or an alkyl group that may have a substituent.

X$^{51}$ represents a single bond, -COO-, or -CONR$^{52}$-, where R$^{52}$ represents a hydrogen atom or an alkyl group.

L$^5$ represents a single bond or a divalent linking group.

Ar$^5$ represents an (r + 1)-valent aromatic ring group or alicyclic group.

R$^{51}$ represents an interactive group or a polar group.

q represents 0 or 1.

When q is 0, r represents 1. When q is 1, r represents an integer of 1 to 4.

In Formula (T1) above, $R^{50}$, $X^5$, $R^{52}$, $L^5$, $Ar^5$, $R^{51}$, q, and r have the same definitions and preferred embodiments as in $R^{50}$, $X^5$, $R^{52}$, $L^5$, $Ar^5$, $R^{51}$, q, and r, respectively, in Formula (IV).

In the resin, one or more repeating units represented by Formula (T1) may be included, or two or more of such repeating units may be included.

In the resin, the content of the repeating unit having an interactive group is preferably 5 mol% or more, more preferably 10 mol% or more relative to all the repeating units in the resin. The upper limit value thereof is preferably 90 mol% or less, more preferably 80 mol% or less.

In the resin, the content of the repeating unit having a polar group is preferably 10 mol% or more, more preferably 20 mol% or more relative to all the repeating units in the resin. The upper limit value thereof is preferably 90 mol% or less, more preferably 80 mol% or less. Reactive Group A and Reactive Group B That Reacts with Reactive Group A

The combination of the reactive group A and the reactive group B that reacts with the reactive group A is not particularly limited, and a combination of publicly known functional groups can be used. In particular, a combination in which one of the reactive group A and the reactive group B is a vinyl ether group ($CH_2$=CH-O-) and the other is a carboxylic group, a sulfonic group, or a group represented by General formula (A) is preferred from the viewpoint of excellent reactivity and decrosslinkability between the reactive group A and the reactive group B.

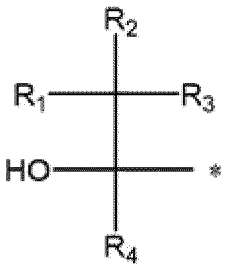

General formula (A)

In General formula (A), $R_1$ to $R_4$ each independently represent a hydrogen atom, a fluorine atom, or an alkyl group. Here, at least one of $R_1$ to $R_3$ represents a fluorine atom or an alkyl group (preferably having 1 to 4 carbon atoms) in which at least one hydrogen atom is substituted with a fluorine atom. * represents a bonding site.

The alkyl group may be linear or branched.

All of $R_1$ to $R_3$ are preferably fluorine atoms.

Specific examples of the group represented by General formula (A) include $-C(CF_3)_2OH$, $-C(C_2F_5)_2OH$, $-C(CF_3)(CH_3)OH$, and $-CH(CF_3)OH$.

In the case of the above combination, the reactive group A and the reactive group B react with each other to form a covalent bond. Alternatively, as described above, the reactive group A and the reactive group B may react with each other to form a non-covalent bond.

A combination for forming a non-covalent bond is preferably, for example, a combination in which one of the reactive group A and the reactive group B is an acidic group (for example, a carboxylic group, a sulfonic group, or a phosphoric group) and the other is a basic group (for example, an amino group, an imino group, an imidazoline group, a pyrrole group, an imidazole group, a benzimidazole group, a pyrazole group, a pyridine group, a pyrimidine group, a pyrazine group, a pyrrolidine group, a piperidine group, or a piperazine group). The amino group includes a primary amino group, a secondary amino group, and a tertiary amino group.

With this combination, an ionic bond is formed between the acidic group and the basic group, and this bond is broken by the action of acid.

Repeating Unit Having Reactive Group A or Reactive Group B

It is also preferable that the resin include a repeating unit having a reactive group A. The reactive group A is as described above.

The repeating unit having a reactive group A is, for example, an embodiment of the repeating unit represented by Formula (T1) described as an example of the repeating unit that the resin in the upper part may have, where $R^{511}$ represents a reactive group A.

When the resin includes a repeating unit having a reactive group A, the resin further includes a repeating unit having a reactive group B, or the resist composition further includes a crosslinking agent (a crosslinking agent including a reactive group B that reacts (that is subjected to a crosslinking reaction) with the reactive group A), which will be described later.

When the resin further includes a repeating unit having a reactive group B, the repeating unit having a reactive

group B is, for example, an embodiment of the repeating unit represented by Formula (T1) described as an example of the repeating unit that the resin in the upper part may have, where $R^{511}$ represents a reactive group B.

The reactive group B is as described above.

In the resin, one or more repeating units having a reactive group A may be included, or two or more of such repeating units may be included.

In the resin, the content of the repeating unit having the reactive group A is preferably 5 mol% or more, more preferably 10 mol% or more relative to all the repeating units in the resin. The upper limit value thereof is preferably 90 mol% or less, more preferably 80 mol% or less.

In the resin, one or more repeating units having a reactive group B may be included, or two or more of such repeating units may be included.

When the resin includes a repeating unit having a reactive group B, the content of the repeating unit is preferably 5 mol% or more, more preferably 10 mol% or more relative to all the repeating units in the resin. The upper limit value thereof is preferably 90 mol% or less, more preferably 80 mol% or less.

Repeating Unit That Undergoes Decrease in Molecular Weight Caused by Scission of Main Chain Due to Action of Exposure, Acid, Base, or Heating

The resin is preferably a resin that undergoes a decrease in molecular weight caused by the scission of the main chain due to action of exposure, acid, base, or heating, and is preferably a so-called main chain scission-type resin.

The main chain scission-type resin preferably has at least one of a repeating unit X1-I, a repeating unit X1-II, or a repeating unit X1-III, and more preferably has the repeating unit X1-I.

Note that when the resin has the repeating unit X1-I, the resin corresponds to a resin that undergoes a decrease in molecular weight caused by the scission of the main chain due to action of exposure, and when the resin has the repeating unit X1-II or X1-III, the resin corresponds to a resin that undergoes a decrease in molecular weight caused by the scission of the main chain due to action of acid.

Repeating Unit X1-I

The repeating unit X1-I includes a repeating unit represented by Formula (XP) below and a repeating unit represented by Formula (XQ) below.

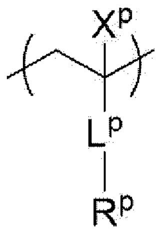

(XP)

In Formula (XP), $X^p$ represents a halogen atom. $L^p$ represents a single bond or a divalent linking group. $R^p$ represents a substituent.

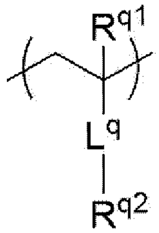

(XQ)

In Formula (XQ), $R^{q1}$ represents an alkyl group that may have a substituent. $L^q$ represents a single bond or a divalent linking group. $R^{42}$ represents a substituent.

In the repeating unit X1-I, at least one of the substituent represented by $R^p$ in Formula (XP) or the substituent represented by $R^{q2}$ in Formula (XQ) preferably has one or more groups selected from the group consisting of the above-described polarity-decreasing group, interactive group, and polar group; or preferably, a repeating unit other than the repeating unit represented by Formula (XP) and the repeating unit represented by Formula (XQ) is included, and the

other repeating unit has one or more groups selected from the group consisting of the above-described polarity-decreasing group, interactive group, and polar group.

From the viewpoint of providing a better effect of the present invention, in the resin X1-I, at least one of the substituent represented by $R^p$ in Formula (XP) or the substituent represented by $R^{q2}$ in Formula (XQ) more preferably has one or more groups selected from the group consisting of the above-described polarity-decreasing group, interactive group, and polar group.

In the repeating unit X1-I, the total content of the repeating unit represented by Formula (XP) above and the repeating unit represented by Formula (XQ) above is preferably 90 mol% or more, more preferably 95 mol% or more relative to all the repeating units. The upper limit value is preferably 100 mol% or less.

In the repeating unit X1-I, the repeating unit represented by Formula (XP) above and the repeating unit represented by Formula (XQ) above may be in any form of a random copolymer, a block copolymer, an alternating copolymer (ABAB···), and the like, and among these, an alternating copolymer is preferred.

A preferred embodiment of the repeating unit X1-I is, for example, an embodiment in which the presence ratio of the alternating copolymer in a block X1 is 90 mass% or more (preferably 100 mass% or more) relative to the total mass of the resin.

In the resin, the content of the repeating unit represented by Formula (XP) above is preferably 10 to 90 mol%, more preferably 30 to 70 mol% relative to all the repeating units. Furthermore, in the resin, the content of the repeating unit represented by Formula (XQ) above is preferably 10 to 90 mol%, more preferably 30 to 70 mol% relative to all the repeating units.

In Formula (XP) above, the halogen atom represented by $X^p$ is preferably a fluorine atom or a chlorine atom, more preferably a chlorine atom from the viewpoint of providing a better effect of the present invention.

In Formula (XP) above, examples of the divalent linking group represented by $L^p$ include, but are not particularly limited to, -CO-, -O-, -SO-, $-SO_2-$, $-NR^A-$, an alkylene group (which preferably has 1 to 6 carbon atoms and may be linear or branched), a cycloalkylene group (preferably having 3 to 15 carbon atoms), a divalent aromatic hydrocarbon ring group (preferably a six- to ten-membered ring, more preferably a six-membered ring), and a divalent linking group provided by combining a plurality of these. The alkylene group, the cycloalkylene group, and the divalent aromatic hydrocarbon ring group may have a substituent. The substituent is, for example, an alkyl group, a halogen atom, or a hydroxy group. $R^A$ may be a hydrogen atom or an alkyl group having 1 to 6 carbon atoms.

A preferred embodiment of the divalent linking group represented by $L^p$ is, for example, an embodiment in which -COO- is located at a position at which the divalent linking group represented by $L^p$ is bonded to the main chain.

In Formula (XP) above, the substituent represented by $R^p$ is not particularly limited, and may be, for example, an alkyl group, a cycloalkyl group, an aryl group, an aralkyl group, an alkenyl group, an alkoxy group, an acyloxy group, a cyano group, a nitro group, a halogen atom, an ester group (-OCOR" or -COOR": R" represents an alkyl group or a fluorinated alkyl group), a lactone group, a polarity-decreasing group, an interactive group, or a polar group.

The alkyl group, the cycloalkyl group, the aryl group, the aralkyl group, the alkenyl group, the alkoxy group, the acyloxy group, the ester group, and the lactone group may further have a substituent, and the substituent is, for example, a halogen atom, a polarity-decreasing group, an interactive group, or a polar group. When the alkyl group has a fluorine atom, the alkyl group may be a perfluoroalkyl group.

The alkyl group may be linear or branched. The number of carbon atoms is not particularly limited, but is, for example, preferably 1 to 20, more preferably 1 to 10, still more preferably 1 to 6.

The cycloalkyl group may be monocyclic or polycyclic. The number of carbon atoms is not particularly limited, but is, for example, preferably 5 to 15, more preferably 5 to 10. Examples of the cycloalkyl group include monocyclic cycloalkyl groups such as a cyclopentyl group and a cyclohexyl group, and polycyclic cycloalkyl groups such as a norbornyl group, a tetracyclodecanyl group, a tetracyclododecanyl group, and an adamantyl group.

The aryl group may be monocyclic or polycyclic. The number of carbon atoms is not particularly limited, but is, for example, preferably 6 to 15, more preferably 6 to 10. The aryl group is preferably a phenyl group, a naphthyl group, or an anthranyl group, more preferably a phenyl group.

The aralkyl group preferably has a structure in which one of hydrogen atoms in the above-mentioned alkyl group is substituted with the above-mentioned aryl group. The number of carbon atoms of the aralkyl group is preferably 7 to 20, more preferably 7 to 15.

The alkenyl group may be linear, branched, or cyclic. The number of carbon atoms is not particularly limited, but is, for example, preferably 2 to 20, more preferably 2 to 10, still more preferably 2 to 6.

The alkoxy group may be linear, branched, or cyclic, and the number of carbon atoms thereof is preferably 1 to 20, more preferably 1 to 10, still more preferably 1 to 6.

The acyloxy group may be linear, branched, or cyclic, and the number of carbon atoms thereof is preferably 2 to 20, more preferably 2 to 10, still more preferably 2 to 6.

The number of carbon atoms of the alkyl group or fluorinated alkyl group represented by R" above is preferably 1 to 20, more preferably 1 to 10, still more preferably 1 to 6.

The lactone group is preferably a five- to seven-membered lactone group, more preferably a five- to seven-membered lactone ring to which another ring structure is fused so as to form a bicyclo structure or a spiro structure.

The polarity-decreasing group, the interactive group, and the polar group are as described above.

The repeating unit represented by Formula (XP) is preferably one or more selected from the group consisting of a repeating unit represented by Formula (XP1) below and a repeating unit represented by Formula (XP2) below.

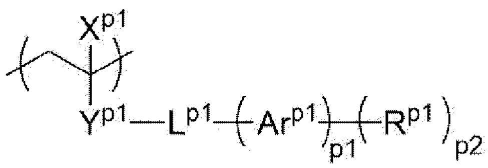

(XP1)

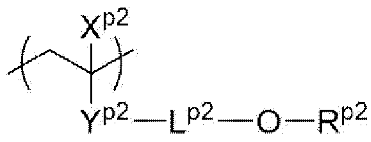

(XP2)

In Formula (XP1), $X^{p1}$ has the same definition and preferred embodiments as in $X^p$ in Formula (XP) above.

$Y^{p1}$ represents a single bond or -COO-.

$L^{p1}$ represents a single bond or a divalent linking group.

Examples of the divalent linking group represented by $L^{p1}$ include, but are not particularly limited to, -CO-, -O-, -SO-, $-SO_2-$, $-NR^A-$, an alkylene group (which preferably has 1 to 6 carbon atoms and may be linear or branched), and a divalent linking group provided by combining a plurality of these. The alkylene group may have a substituent. The substituent may be, for example, a halogen atom or a hydroxy group. $R^A$ may be a hydrogen atom or an alkyl group having 1 to 6 carbon atoms.

$Ar^{p1}$ represents a (p2 + 1)-valent aromatic ring group or a (p2 + 1)-valent alicyclic group.

The divalent aromatic ring group in the case where P2 is 1 is preferably, for example, an arylene group having 6 to 18 carbon atoms, such as a phenylene group, a tolylene group, a naphthylene group, or an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, or a thiazole ring. Of these, an arylene group is preferred, a phenylene group, a naphthalene group, or an anthracenylene group is more preferred, and a phenylene group or a naphthalene group is still more preferred.

Specific examples of the (p2 + 1)-valent aromatic ring group in the case where p2 is an integer of 2 or more include groups provided by removing any (p2 - 1) hydrogen atoms from any of the foregoing specific examples of the divalent aromatic ring group.

The (p2 + 1)-valent alicyclic group represented by $Ar^{p1}$ may include a heteroatom such as an oxygen atom and a carbonyl carbon. Examples of the (p2 + 1)-valent alicyclic group represented by $Ar^{p1}$ include groups provided by removing any p2 hydrogen atoms from a polycyclic cycloalkane such as norbornene, tetracyclodecane, tetracyclododecane, or adamantane. The (p2 + 1)-valent alicyclic group represented by $Ar^{p1}$ may be a group provided by removing any p2 hydrogen atoms from a lactone ring or a sultone ring. The lactone ring or the sultone ring is preferably a five- to seven-membered lactone ring or sultone ring, more preferably a five- to seven-membered lactone ring or sultone ring to which another ring structure is fused so as to form a bicyclo structure or a spiro structure.

The (p2 + 1)-valent aromatic ring group and the (p2 + 1)-valent alicyclic group may have a substituent other than $R^{p1}$.

p1 represents 0 or 1.

When p1 is 0, p2 represents 1. When p1 is 1, p2 represents an integer of 0 to 4.

$R^{p1}$ represents a substituent. $R^{p1}$ may be the same as $R^p$ in Formula (XP) above and is particularly preferably an alkyl group that may have a substituent, a polarity-decreasing group, an interactive group, or a polar group. The substituent is preferably a halogen atom.

As an embodiment of the substituent represented by $R^{p1}$, an embodiment represented by $*-L_N-R^{pA}$ is also preferred. $L_N$ represents a single bond or a divalent linking group. The divalent linking group represented by $L_N$ may be the same as the divalent linking group represented by $L^p$ in Formula (XP) above and is particularly preferably an alkylene group having 1 to 6 carbon atoms. $R^{pA}$ represents the polarity-decreasing group, interactive group, or polar group described above.

In Formula (XP2), $X^{p1}$ has the same definition as in $X^p$ in Formula (XP) above.

$Y^{p2}$ represents a single bond or -COO-.

$L^{p2}$ represents a divalent linking group.

Examples of the divalent linking group represented by $L^{p2}$ include -CO-, -O-, -S-, -SO-, $-SO_2-$, hydrocarbon groups (such as an alkylene group, a cycloalkylene group, an alkenylene group, and an arylene group), and a linking group provided by linking a plurality of these together. The hydrocarbon groups may have a substituent. The substituent is not particularly limited, and may be, for example, a fluorine atom or an iodine atom.

In particular, the divalent linking group represented by $L^{p2}$ is preferably an arylene group, an arylene group-CO-, an alkylene group-CO-, or an alkylene group-arylene group-, more preferably an arylene group.

The arylene group is preferably a phenylene group.

The alkylene group may be linear or branched. The number of carbon atoms of the alkylene group is not particularly limited, but is preferably 1 to 10, more preferably 1 to 3.

$R^{p2}$ represents a leaving group that leaves due to action of acid.

Examples of the leaving group that leaves due to action of acid and represented by $R^{p2}$ include the above-described leaving groups represented by Formulae (Y1) to (Y4).

Here, when the repeating unit represented by Formula (XP2) includes an acid-decomposable group having a structure in which a polar group is protected with a leaving group, the polar group generated after acid decomposition is more hydrophobic than the acid-decomposable group before acid decomposition. Specifically, the logP of the acid-decomposable group is smaller than the logP of the polar group after the protective group leaves.

In Formula (XQ), the alkyl group represented by $R^{q1}$ may be linear, branched, or cyclic. The number of carbon atoms of the alkyl group is preferably 1 to 12, more preferably 1 to 6, still more preferably 1 to 3.

The alkyl group represented by $R^{q1}$ may have a substituent. The substituent is not particularly limited, but may be, for example, a halogen atom or a hydroxy group.

In Formula (XQ), the divalent linking group represented by $L^q$ may be the same as the divalent linking group represented by $L^p$ in Formula (XP) above.

In Formula (XQ), the substituent represented by $R^{q2}$ may be the same as the substituent represented by $R^p$ in Formula (XP) above.

The repeating unit represented by Formula (XQ) is preferably one or more selected from the group consisting of a repeating unit represented by Formula (XQ1) below and a repeating unit represented by Formula (XQ2) below.

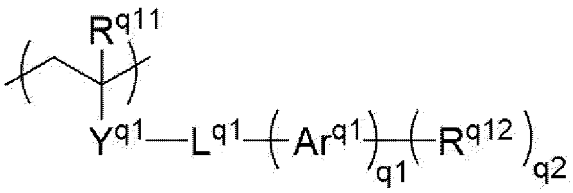

(XQ1)

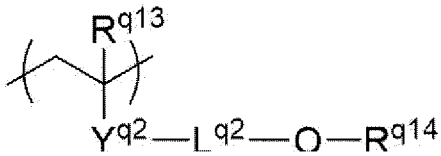

(XQ2)

In Formula (XQ1), $R^{q11}$ has the same definition and preferred embodiments as in $R^{q1}$ in Formula (XQ) above.

As an embodiment of the substituent represented by $R^{q12}$, an embodiment represented by $*-L_N-R^{pA}$ is also preferred. $L_N$ represents a single bond or a divalent linking group. The divalent linking group represented by $L_N$ may be the same as the divalent linking group represented by $L^p$ in Formula (XP) above and is particularly preferably an alkylene group having 1 to 6 carbon atoms. $R^{pA}$ represents the polarity-decreasing group, interactive group, or polar group described above.

$Y^{q1}$ represents a single bond or -COO-.

$L^{q1}$ represents a single bond or a divalent linking group.

Examples of the divalent linking group represented by $L^{q1}$ include, but are not particularly limited to, -CO-, -O-, -SO-, $-SO_2-$, $-NR^A-$, an alkylene group (which preferably has 1 to 6 carbon atoms and may be linear or branched), and a divalent linking group provided by combining a plurality of these. The alkylene group may have a substituent. The substituent may be, for example, a halogen atom or a hydroxy group. $R^A$ may be a hydrogen atom or an alkyl group having 1 to 6 carbon atoms.

$Ar^{q1}$ represents a (q2 + 1)-valent aromatic ring group or alicyclic group.

The divalent aromatic ring group in the case where q2 is 1 is preferably, for example, an arylene group having 6 to 18 carbon atoms, such as a phenylene group, a tolylene group, a naphthylene group, or an anthracenylene group,

or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, or a thiazole ring. Of these, an arylene group is preferred, and a phenylene group or a naphthalene group is more preferred.

Specific examples of the (q2 + 1)-valent aromatic ring group in the case where q2 is an integer of 2 or more include groups provided by removing any (q2 - 1) hydrogen atoms from any of the foregoing specific examples of the divalent aromatic ring group.

The (q2 + 1)-valent alicyclic group represented by $Ar^{q1}$ may include a heteroatom such as an oxygen atom and a carbonyl carbon. Examples of the (q2 + 1)-valent alicyclic group represented by $Ar^{q1}$ include groups provided by removing any q2 hydrogen atoms from a polycyclic cycloalkane such as norbornene, tetracyclodecane, tetracyclododecane, or adamantane. The (q2 + 1)-valent alicyclic group represented by $Ar^{q1}$ may be a group provided by removing any q2 hydrogen atoms from a lactone ring or a sultone ring. The lactone ring or the sultone ring is preferably a five- to seven-membered lactone ring or sultone ring, more preferably a five- to seven-membered lactone ring or sultone ring to which another ring structure is fused so as to form a bicyclo structure or a spiro structure.

The (q2 + 1)-valent aromatic ring group and the (q2 + 1)-valent alicyclic group may have a substituent other than $R^{q12}$.

q1 represents 0 or 1.

When q1 is 0, q2 represents 1. When q1 is 1, q2 represents an integer of 0 to 4.

$R^{p12}$ represents a substituent. $R^{p12}$ may be the same as $R^p$ in Formula (XP) above and is particularly preferably an alkyl group that may have a substituent, a polarity-decreasing group, an interactive group, or a polar group. The substituent is preferably a halogen atom.

As an embodiment of the substituent represented by $R^{p12}$, an embodiment represented by *-$L_N$-$R^{pA}$ is also preferred. $L_N$ represents a single bond or a divalent linking group. The divalent linking group represented by $L_N$ may be the same as the divalent linking group represented by $L^p$ in Formula (XP) above and is particularly preferably an alkylene group having 1 to 6 carbon atoms. $R^{pA}$ represents the polarity-decreasing group, interactive group, or polar group described above.

In Formula (XQ2), $R^{q13}$ has the same definition as in $R^{q1}$ in Formula (XQ) above.

$Y^{q2}$ represents a single bond or -COO-.

$L^{q2}$ represents a divalent linking group.

Examples of the divalent linking group represented by $L^{q2}$ include -CO-, -O-, -S-, -SO-, $-SO_2-$, hydrocarbon groups (such as an alkylene group, a cycloalkylene group, an alkenylene group, and an arylene group), and a linking group provided by linking a plurality of these together. The hydrocarbon groups may have a substituent. The substituent is not particularly limited, and may be, for example, a fluorine atom or an iodine atom.

In particular, the divalent linking group represented by $L^{q2}$ is preferably an arylene group, an arylene group-CO-, an alkylene group-CO-, or an alkylene group-arylene group-, more preferably an arylene group.

The arylene group is preferably a phenylene group.

The alkylene group may be linear or branched. The number of carbon atoms of the alkylene group is not particularly limited, but is preferably 1 to 10, more preferably 1 to 3.

$R^{q14}$ represents a leaving group that leaves due to action of acid.

Examples of the leaving group that leaves due to action of acid and represented by $R^{q14}$ include the above-described leaving groups represented by Formulae (Y1) to (Y4).

Here, when the repeating unit represented by Formula (XQ2) includes an acid-decomposable group having a structure in which a polar group is protected with a leaving group, the polar group generated after acid decomposition is more hydrophobic than the acid-decomposable group before acid decomposition. Specifically, the logP of the acid-decomposable group is smaller than the logP of the polar group after the protective group leaves. Repeating Unit X1-II

The resin preferably includes a moiety represented by Formula (XRO) below in a main chain structure.

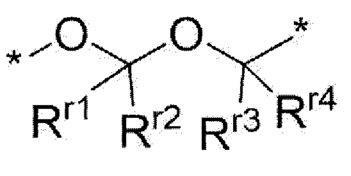

(XR0)

In Formula (XR0), $R^{r1}$ to $R^{r4}$ each independently represent a hydrogen atom or a substituent. $R^{r2}$ and $R^{r3}$ may be bonded together to form a ring. * represents a bonding site.

The moiety represented by Formula (XRO) above has one or more groups selected from the group consisting of the above-described polarity-decreasing group, interactive group, and polar group.

In the moiety represented by Formula (XRO) above, preferably, at least one or more of $R^{r1}$ to $R^{r4}$ in Formula

(XRO) represent substituents, and at least one or more of the substituents have one or more groups selected from the group consisting of the above-described polarity-decreasing group, interactive group, and polar group. Alternatively, preferably, $R^{r2}$ and $R^{r3}$ in Formula (XRO) are bonded together to form a ring, and at least one or more of substituents on the ring have one or more groups selected from the group consisting of the above-described polarity-decreasing group, interactive group, and polar group. Alternatively, preferably, a repeating unit other than the repeating unit represented by Formula (XRO) is included, and the other repeating unit has one or more groups selected from the group consisting of the polarity-decreasing group, the interactive group, and the polar group described above.

In the moiety represented by Formula (XRO) above, more preferably, at least one or more of $R^{r1}$ to $R^{r4}$ in Formula (XRO) represent substituents, and at least one or more of the substituents have one or more groups selected from the group consisting of the above-described polarity-decreasing group, interactive group, and polar group; or $R^{r2}$ and $R^{r3}$ in Formula (XRO) are bonded together to form a ring, and at least one or more of substituents on the ring have one or more groups selected from the group consisting of the above-described polarity-decreasing group, interactive group, and polar group.

From the viewpoint of providing a better effect of the present invention, in the moiety represented by Formula (XRO) above, more preferably, $R^{r2}$ and $R^{r3}$ in Formula (XRO) are bonded together to form a ring, and at least one or more of substituents on the ring have one or more groups selected from the group consisting of the above-described polarity-decreasing group, interactive group, and polar group.

The resin may include the moiety represented by Formula (XRO) as a part thereof or as a repeating unit thereof. From the viewpoint of providing a better effect of the present invention, the resin is preferably a resin including Formula (XRO) as a repeating unit (specifically, a resin including a repeating unit represented by Formula (XR) below).

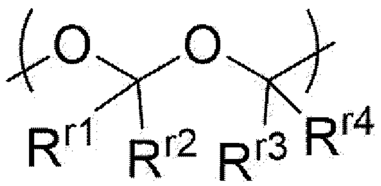
(XR)

In the resin, the content of the repeating unit represented by Formula (XR) above is preferably 90 mol% or more, more preferably 95 mol% or more relative to all the repeating units. The upper limit value is preferably 100 mol% or less.

In Formula (XR), the substituents represented by $R^{r1}$ to $R^{r4}$ may each be the same as the substituent represented by $R^p$ in Formula (XP) above, and preferred embodiments are also the same.

As an embodiment of the substituents represented by $R^{r1}$ to $R^{r4}$, an embodiment represented by *-$L_N$-$R^{pA}$ is also preferred. $L_N$ represents a single bond or a divalent linking group. The divalent linking group represented by $L_N$ may be the same as the divalent linking group represented by $L^p$ in Formula (XP) above and is particularly preferably an alkylene group having 1 to 6 carbon atoms. $R^{pA}$ represents the polarity-decreasing group, interactive group, or polar group described above.

In Formula (XR), the ring formed by bonding $R^{r2}$ and $R^{r3}$ together is not particularly limited, and may be an alicyclic ring or an aromatic ring. The ring may further have a substituent, and the substituent represents, for example, a polarity-decreasing group, an interactive group, or a polar group. Alternatively, the substituent is also preferably a group of an embodiment represented by *-$L_N$-$R^{pA}$ described as one embodiment of the substituents represented by $R^{r1}$ to $R^{r4}$ above.

In Formula (XR), when $R^{r2}$ and $R^{r3}$ are bonded together, the repeating unit represented by Formula (XR) is also preferably a repeating unit represented by Formula (XRA) below.

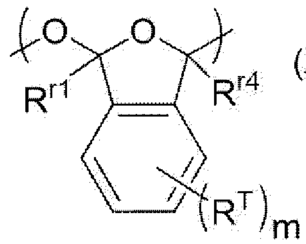
(XRA)

In the formula, $R^{r1}$ and $R^{r4}$ have the same definitions and preferred embodiments as in $R^{r1}$ and $R^{r4}$, respectively, in Formula (XR) above. $R^T$ represents a substituent. Each substituent represented by $R^T$ may be the same as the substituent represented by $R^p$ in Formula (XP) above, and preferred embodiments are also the same.

At least one of the substituents represented by $R^T$ preferably represents a polarity-decreasing group, an interactive group, or a polar group. m represents an integer of 0 to 4. Repeating Unit X1-III

The repeating unit X1-III is a repeating unit represented by Formula (XS) below.

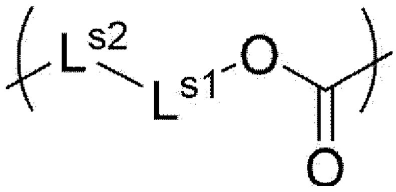

(XS)

In Formula (XS), $L^{s1}$ represents a linking group represented by *-C($R^{s1}$)($R^{s2}$)-*. $R^{s1}$ and $R^{s2}$ each independently represent a hydrogen atom or a monovalent organic group. However, at least one of $R^{s1}$ or $R^{s2}$ represents a monovalent organic group. $L^{s2}$ represents a single bond or a divalent linking group. * represents a bonding site.

When the resin has the repeating unit represented by Formula (XS) above, the repeating unit preferably has one or more groups selected from the group consisting of the above-described polarity-decreasing group, interactive group, and polar group. Specifically, at least one or more of the monovalent organic group represented by $R^{s1}$ and $R^{s2}$ or the divalent linking group represented by $L^{s2}$ in Formula (XS) above preferably have one or more groups selected from the group consisting of the above-described polarity-decreasing group, interactive group, and polar group.

From the viewpoint of providing a better effect of the present invention, in the repeating unit represented by Formula (XS) above, the monovalent organic group represented by $R^{s1}$ and $R^{s2}$ in Formula (XS) more preferably has one or more groups selected from the group consisting of the above-described polarity-decreasing group, interactive group, and polar group.

In the resin, the content of the repeating unit represented by Formula (XS) above is preferably 90 mol% or more, more preferably 95 mol% or more relative to all the repeating units. The upper limit value is preferably 100 mol% or less.

In Formula (XS), $L^{s1}$ represents a linking group represented by *-C($R^{s1}$)($R^{s2}$)-*.

$R^{s1}$ and $R^{s2}$ each independently represent a hydrogen atom or a monovalent organic group.

However, in Formula (XS), at least one of $R^{s1}$ or $R^{s2}$ represents a monovalent organic group.

The monovalent organic group represented by $R^{s1}$ and $R^{s2}$ is preferably an alkyl group (linear or branched), a cycloalkyl group (monocyclic or polycyclic), or an aryl (monocyclic or polycyclic) group, more preferably an alkyl group.

The alkyl group in $R^{s1}$ and $R^{s2}$ is preferably an alkyl group having 1 to 4 carbon atoms.

The cycloalkyl group in $R^{s1}$ and $R^{s2}$ is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group.

The aryl group in $R^{s1}$ and $R^{s2}$ is preferably a phenyl group.

$R^{s1}$ and $R^{s2}$ are each preferably an alkyl group, each more preferably an alkyl group having 1 to 4 carbon atoms, each still more preferably a methyl group.

The divalent linking group represented by $L^{s2}$ in Formula (XS) may be the same as the divalent linking group represented by $L^p$ in Formula (XP) above.

In particular, $L^{s2}$ is preferably a group represented by $*^1$-$L_{O1}$-ph-$L_{O2}$-O-$*^2$. ph represents a phenylene group that may have a substituent. $*^1$ represents a bonding site to $L^{s1}$, and $*^2$ represents another bonding site. $L_{O1}$ and $L_{O2}$ represent a single bond or a divalent linking group.

The substituent that ph may have is not particularly limited, but is preferably, for example, a group represented by *-$L_N$-$R^{pA}$. $L_N$ represents a single bond or a divalent linking group. The divalent linking group represented by $L_N$ may be the same as the divalent linking group represented by $L^p$ in Formula (XP) above and is particularly preferably an alkylene group having 1 to 6 carbon atoms. $R^{pA}$ represents the polarity-decreasing group, interactive group, or polar group described above.

Examples of the divalent linking group represented by $L_{O1}$ and $L_{O2}$ include -CO-, -O-, -SO-, -$SO_2$-, -$NR^A$-, an alkylene group (which preferably has 1 to 6 carbon atoms and may be linear or branched), and a divalent linking group provided by combining a plurality of these. The alkylene group may have a substituent. The substituent may be, for example, a halogen atom or a hydroxy group. $R^A$ may be a hydrogen atom or an alkyl group having 1 to 6 carbon atoms.

An embodiment of the divalent linking group represented by $L_{O1}$ and $L_{O2}$ may be a divalent linking group represented by an alkylene group-O-.

Other Repeating Units

The resin may have other repeating units in addition to those described above.

Examples of the other repeating units include a repeating unit having a lactone group or a sultone group, a repeating unit represented by Formula (V-1) or Formula (V-2) below, a repeating unit that decreases the mobility of the main chain, and a repeating unit having a fluorine atom or an iodine atom.

Repeating Unit Having Lactone Group or Sultone Group

The resin also preferably includes a repeating unit having at least one selected from the group consisting of a lactone group and a sultone group.

The lactone group or the sultone group at least has a lactone structure or a sultone structure. The lactone structure or the sultone structure is preferably a five- to seven-membered lactone structure or a five- to seven-membered sultone structure. In particular, a five- to seven-membered lactone structure to which another ring structure is fused so as to form a bicyclo structure or a spiro structure, or a five- to seven-membered sultone structure to which another ring structure is fused so as to form a bicyclo structure or a spiro structure is more preferred.

The resin preferably has a repeating unit having a lactone group or a sultone group provided by abstracting one or more hydrogen atoms from ring member atoms of a lactone structure represented by any one of Formulae (LC1-1) to (LC1-21) below or a sultone structure represented by any one of Formulae (SL1-1) to (SL1-3) below.

The lactone group or the sultone group may be directly bonded to the main chain. For example, ring member atoms of a lactone group or a sultone group may constitute the main chain of the resin.

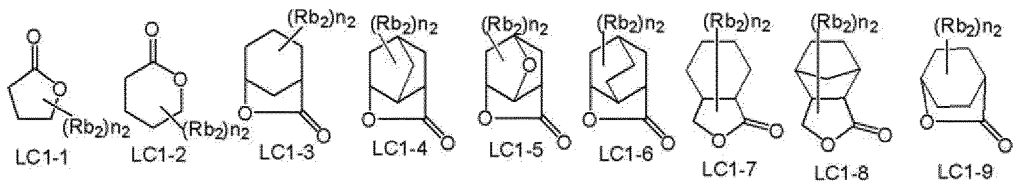

LC1-1 LC1-2 LC1-3 LC1-4 LC1-5 LC1-6 LC1-7 LC1-8 LC1-9

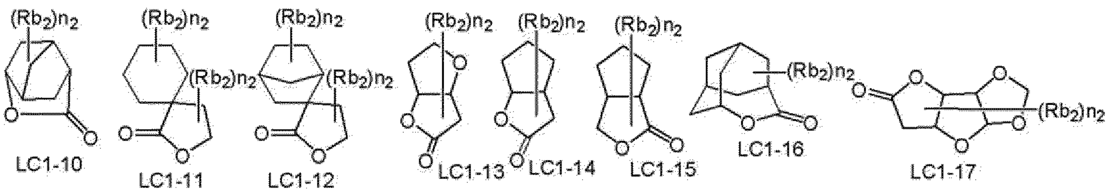

LC1-10 LC1-11 LC1-12 LC1-13 LC1-14 LC1-15 LC1-16 LC1-17

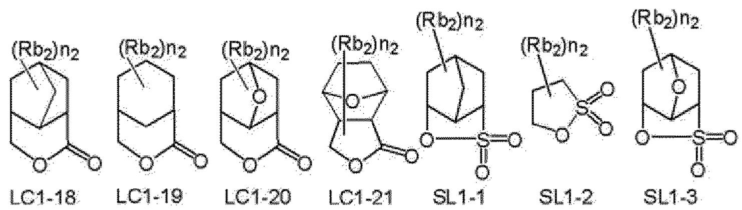

LC1-18 LC1-19 LC1-20 LC1-21 SL1-1 SL1-2 SL1-3

The lactone or sultone structural moiety may have a substituent ($Rb_2$). Preferred examples of the substituent ($Rb_2$) include an alkyl group having 1 to 8 carbon atoms, a cycloalkyl group having 4 to 7 carbon atoms, an alkoxy group having 1 to 8 carbon atoms, a halogen atom, a cyano group, and an acid-decomposable group. n2 represents an integer of 0 to 4. When n2 is 2 or more, a plurality of $Rb_2$'s may be different and a plurality of $Rb_2$'s may be bonded together to form a ring.

The repeating unit having a group having the lactone structure represented by any one of Formulae (LC1-1) to (LC1-21) or the sultone structure represented by any one of Formulae (SL1-1) to (SL1-3) is, for example, a repeating unit represented by Formula (AI) below.

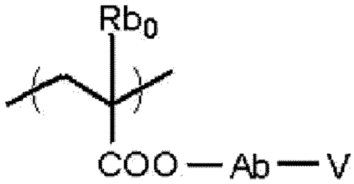

(AI)

In Formula (AI), $Rb_0$ represents a hydrogen atom, a halogen atom, or an alkyl group having 1 to 4 carbon atoms.
A preferred substituent that the alkyl group in $Rb_0$ may have is, for example, a halogen atom.
Examples of the halogen atom in $Rb_0$ include a fluorine atom, a chlorine atom, a bromine atom, and an iodine atom. $Rb_0$ is preferably a hydrogen atom or a methyl group.
Ab represents a single bond, an alkylene group, a divalent linking group having a monocyclic or polycyclic alicyclic hydrocarbon structure, an ether group, an ester group, a carbonyl group, a carboxyl group, or a divalent group provided by combining these. In particular, a single bond or a linking group represented by $-Ab_1-CO_2-$ is preferred. $Ab_1$ is a linear or branched alkylene group or a monocyclic or polycyclic cycloalkylene group, and preferably a methylene group, an ethylene group, a cyclohexylene group, an adamantylene group, or a norbomylene group.
V represents a group provided by abstracting one hydrogen atom from a ring member atom of the lactone structure represented by any one of Formulae (LC1-1) to (LC1-21) or a group provided by abstracting one hydrogen atom from a ring-member atom of the sultone structure represented by any one of Formulae (SL1-1) to (SL1-3).
When the repeating unit having a lactone group or a sultone group has an optical isomer, any optical isomer may be used. A single optical isomer may be used alone, or a plurality of optical isomers may be used in combination. When a single optical isomer is mainly used, its optical purity (ee) is preferably 90 or more, more preferably 95 or more.
The content of the repeating unit having a lactone group or a sultone group is preferably 1 mol% or more, more preferably 10 mol% or more relative to all the repeating units in the resin. The upper limit value thereof is preferably 85 mol% or less, more preferably 80 mol% or less, still more preferably 70 mol% or less, particularly preferably 60 mol% or less.

Repeating Unit Represented by Formula (V-1) or Formula (V-2) below

The resin may have a repeating unit represented by Formula (V-1) below or Formula (V-2) below.
The repeating units represented by Formula (V-1) below and Formula (V-2) below are preferably repeating units different from the repeating units described above.

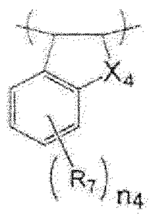

(V-1)

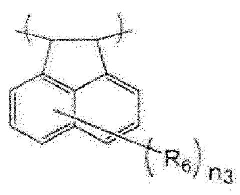

(V-2)

In Formulae (V-1) and (V-2), $R_6$ and $R_7$ each independently represent a substituent.
The substituent is, for example, an alkyl group, an alkoxy group, a cyano group, a nitro group, a halogen atom, or an ester group (-OCOR or -COOR: R is an alkyl group or fluoroalkyl group having 1 to 6 carbon atoms).
The alkyl group and the alkyl group moiety (which may be linear, branched, or cyclic) in the alkoxy group preferably have 1 to 10 carbon atoms.
$n_3$ represents an integer of 0 to 6.
$n_4$ represents an integer of 0 to 4.
$X^4$ is a methylene group, an oxygen atom, or a sulfur atom.
Examples of the repeating unit represented by Formula (V-1) or (V-2) are as follows.
Examples of the repeating unit represented by Formula (V-1) or (V-2) include the repeating units described in paragraph [0100] of WO2018/193954A.

Repeating Unit That Decreases Mobility of Main Chain

The resin preferably has a high glass transition temperature (Tg) from the viewpoint that excessive diffusion

of the generated acid or pattern collapse during development can be suppressed. Tg is preferably higher than 90°C, more preferably higher than 100°C, still more preferably higher than 110°C, particularly preferably higher than 125°C. Note that since an excessively high Tg leads to a decrease in the dissolution rate in developers, Tg is preferably 400°C or lower, more preferably 350°C or lower.

In the present specification, the glass transition temperature (Tg) of a polymer such as the resin is calculated by the following method. First, Tg's of homopolymers composed only of the repeating units included in the polymer are calculated by the Bicerano method. Hereinafter, the calculated Tg's are referred to as "Tg's of repeating units". Next, the mass ratios (%) of the repeating units relative to all the repeating units in the polymer are calculated. Next, Tg's at the mass ratios are calculated using the Fox equation (described in, for example, Materials Letters 62 (2008) 3152), and the sum total of the Tg's is defined as the Tg (°C) of the polymer.

The Bicerano method is described in, for example, Prediction of polymer properties, Marcel Dekker Inc., New York (1993). The calculation of Tg by the Bicerano method can be performed using software for estimating physical properties of polymers, MDL Polymer (MDL Information Systems, Inc.).

In order to increase Tg of the resin (preferably, to make Tg higher than 90°C), the mobility of the main chain of the resin is preferably decreased. Examples of the method for decreasing the mobility of the main chain of the resin include the following methods (a) to (e):

(a) Introduction of a bulky substituent into the main chain
(b) Introduction of a plurality of substituents into the main chain
(c) Introduction of substituents that induce an interaction between molecules of the resin at positions near the main chains
(d) Formation of the main chain with a ring structure
(e) Linking of a ring structure to the main chain

The resin preferably has a repeating unit whose homopolymer has a Tg of 130°C or higher.

The type of the repeating unit whose homopolymer has a Tg of 130°C or higher is not particularly limited as long as it is a repeating unit whose homopolymer has a Tg of 130°C or higher as calculated by the Bicerano method. Note that repeating units represented by Formulae (A) to (E) described later may, depending on the types of functional groups, correspond to the repeating unit whose homopolymer has a Tg of 130°C or higher.

Repeating Unit Represented by Formula (A)

An example of specific means for achieving (a) above is a method of introducing a repeating unit represented by Formula (A) into the resin.

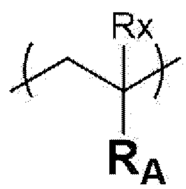

(A)

Formula (A), $R_A$ represents a group having a polycyclic structure. $R_x$ represents a hydrogen atom, a methyl group, or an ethyl group. The group having a polycyclic structure is a group having a plurality of ring structures, and the plurality of ring structures may be fused together or may not be fused together.

Specific examples of the repeating unit represented by Formula (A) include those described in paragraphs [0107] to [0119] of WO2018/193954A.

Repeating Unit Represented by Formula (B)

An example of specific means for achieving (b) above is a method of introducing a repeating unit represented by Formula (B) into the resin.

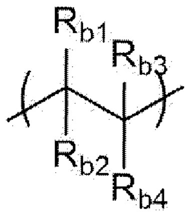

(B)

In Formula (B), $R_{b1}$ to $R_{b4}$ each independently represent a hydrogen atom or an organic group, and at least two or more of $R_{b1}$ to $R_{b4}$ represent organic groups.
When at least one of the organic groups is a group whose ring structure is directly linked to the main chain in the repeating unit, the types of other organic groups are not particularly limited.
When none of the organic groups is a group whose ring structure is directly linked to the main chain in the repeating unit, at least two or more of the organic groups are substituents in which the number of constituent atoms excluding hydrogen atoms is 3 or more.
Specific examples of the repeating unit represented by Formula (B) include those described in paragraphs [0113] to [0115] of WO2018/193954A.

Repeating Unit Represented by Formula (C)

An example of specific means for achieving (c) above is a method of introducing a repeating unit represented by Formula (C) into the resin.

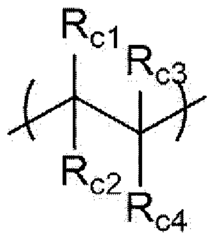

(C)

In Formula (C), $R_{c1}$ to $R_{c4}$ each independently represent a hydrogen atom or an organic group, and at least one of $R_{c1}$ to $R_{c4}$ is a group having a hydrogen-bond-forming hydrogen atom positioned within three atoms from a carbon atom in the main chain. In particular, from the viewpoint of inducing the interaction between the main chains of the resin, it is preferable to have a hydrogen-bond-forming hydrogen atom positioned within two atoms (closer to the main chain).
Specific examples of the repeating unit represented by Formula (C) include those described in paragraphs [0119] to [0121] of WO2018/193954A.

Repeating Unit Represented by Formula (D)

An example of specific means for achieving (d) above is a method of introducing a repeating unit represented by Formula (D) into the resin.

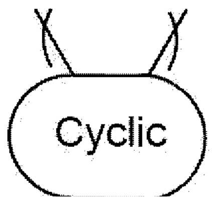

(D)

In Formula (D), "cylic" represents a group that forms the main chain with a ring structure. The number of atoms constituting the ring is not particularly limited.
Specific examples of the repeating unit represented by Formula (D) include those described in paragraphs [0126] and [0127] of WO2018/193954A.

Repeating Unit Represented by Formula (E)

An example of specific means for achieving (e) above is a method of introducing a repeating unit represented by Formula (E) into the resin.

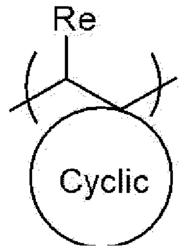

(E)

In Formula (E), each Re independently represents a hydrogen atom or an organic group. The organic group may be, for example, an alkyl group, cycloalkyl group, aryl group, aralkyl group, or alkenyl group that may have a substituent.

"Cylic" is a cyclic group including a carbon atom of the main chain. The number of atoms included in the cyclic group is not particularly limited.

Specific examples of the repeating unit represented by Formula (E) include those described in paragraphs [0131] to [0133] of WO2018/193954A.

Repeating Unit Having Fluorine Atom or Iodine Atom

The resin may have a repeating unit having a fluorine atom or an iodine atom.

Note that herein, the repeating unit having a fluorine atom or an iodine atom is a repeating unit different from each of the repeating units described above.

The repeating unit having a fluorine atom or an iodine atom is preferably a repeating unit represented by Formula (C).

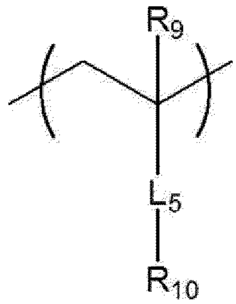

(C)

$L_5$ represents a single bond or an ester group.

$R_9$ represents a hydrogen atom or an alkyl group that may have a fluorine atom or an iodine atom.

$R_{10}$ represents a hydrogen atom, an alkyl group that may have a fluorine atom or an iodine atom, a cycloalkyl group that may have a fluorine atom or an iodine atom, an aryl group that may have a fluorine atom or an iodine atom, or a group provided by combining these.

Examples of the repeating unit having a fluorine atom or an iodine atom are as follows.

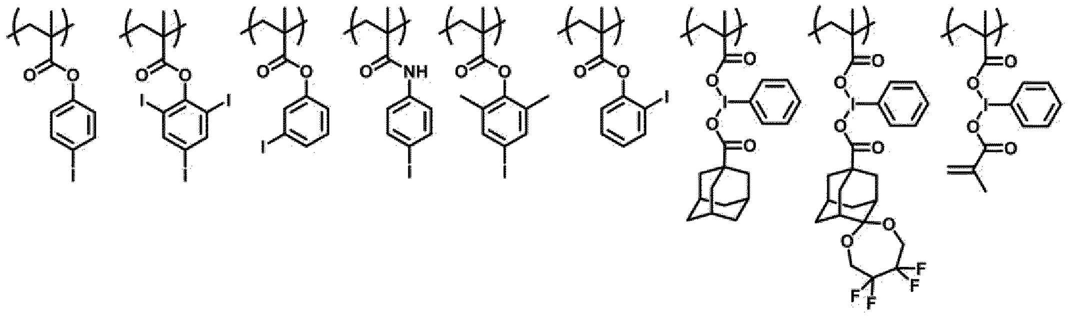

The content of the repeating unit having a fluorine atom or an iodine atom is preferably 0 mol% or more, more preferably 5 mol% or more, still more preferably 10 mol% or more relative to all the repeating units in the resin. The upper limit value thereof is preferably 50 mol% or less, more preferably 45 mol% or less, still more preferably 40 mol% or less.

Preferred Embodiments of Resin

Preferred embodiments of the resin include a resin X1, resins Y1 and Y2, resins Z1 and Z2, and a resin S1.

Resin X1

Hereinafter, the resin X1 included in the resist composition satisfying the requirement X will be described.
The resin X1 is a resin that undergoes a decrease in molecular weight caused by scission of the main chain due to action of exposure, acid, base, or heating and satisfies at least one of the requirements A1 to A3 described above.
An embodiment (Embodiment 1) of the resin X1 is, for example, an embodiment in which the resin undergoes a decrease in molecular weight caused by scission of the main chain due to action of exposure, acid, base, or heating and has a polarity-decreasing group.
Another embodiment (Embodiment 2) of the resin X1 is, for example, an embodiment in which the resin undergoes a decrease in molecular weight caused by scission of the main chain due to action of exposure, acid, base, or heating and has an interactive group.
Another embodiment (Embodiment 3) of the resin X1 is, for example, an embodiment in which the resin undergoes a decrease in molecular weight caused by scission of the main chain due to action of exposure, acid, base, or heating and has a polar group.
Another embodiment (Embodiment 4) of the resin X1 is, for example, an embodiment in which the resin undergoes a decrease in molecular weight caused by scission of the main chain due to action of exposure, acid, base, or heating and which includes two or more embodiments selected from the group consisting of an embodiment in which the resin has a polarity-decreasing group, an embodiment in which the resin has an interactive group, and an embodiment in which the resin has a polar group.
In Embodiments 1 to 4, as described above, the polarity-decreasing group refers to a group that decreases polarity due to action of exposure, acid, base, or heating. The interactive group refers to an interactive group that forms an interaction with an onium salt compound and that is released from the interaction due to action of exposure, acid, base, or heating.
Note that when the resin X1 has a polarity-decreasing group, the resin X1 may have, before the action of exposure, acid, base, or heating, both the polarity-decreasing group and a group after the decrease in polarity, the group being generated from the polarity-decreasing group by the action of exposure, acid, base, or heating.
In the embodiments in which the resin X1 has an interactive group (Embodiments 2 and 4), the resist composition further includes an onium salt compound that can generate a bond due to an interaction with the interactive group in the resin X1.
In the embodiments in which the resin X1 has a polar group (Embodiments 3 and 4), the resist composition further includes a capping agent that reacts with the polar groups in the resin X1 to decrease the polarity of the resin X1.
Each of the terms is as described above.
Preferred embodiments of the resin X1 will be described below.
The resin X1 corresponds to a so-called main chain scission-type resin that undergoes a decrease in molecular weight caused by the scission of the main chain due to action of exposure, acid, base, or heating.
Examples of the form of the resin X1 which is a main chain scission-type resin include resins having the following configurations. In the resins having the configurations described below, a resin X1-I corresponds to a resin that undergoes

a decrease in molecular weight caused by the scission of the main chain due to action of exposure, and resins X1-II and X1-III correspond to a resin that undergoes a decrease in molecular weight caused by the scission of the main chain due to action of acid.

Of these, the resin X1-I is preferred from the viewpoint of providing a better effect of the present invention.

Resin X1-I

The resin X1-I is a resin having the repeating unit X1-I.

Preferred embodiments of the repeating unit X1-I are as described above.

In the resin X1-I, the total content of the repeating unit represented by Formula (XP) above and the repeating unit represented by Formula (XQ) above is preferably 90 mol% or more, more preferably 95 mol% or more relative to all the repeating units. The upper limit value is preferably 100 mol% or less.

In the resin X1-I, the repeating unit represented by Formula (XP) above and the repeating unit represented by Formula (XQ) above may be in any form of a random copolymer, a block copolymer, an alternating copolymer (ABAB···), and the like, and among these, an alternating copolymer is preferred.

A preferred embodiment of the resin X1-I is, for example, an embodiment in which the presence ratio of the alternating copolymer in the resin X1 is 90 mass% or more (preferably 100 mass% or more) relative to the total mass of the resin X1.

In the resin X1-I, the content of the repeating unit represented by Formula (XP) above is preferably 10 to 90 mol%, more preferably 30 to 70 mol% relative to all the repeating units. Furthermore, in the resin X1-I, the content of the repeating unit represented by Formula (XQ) above is preferably 10 to 90 mol%, more preferably 30 to 70 mol% relative to all the repeating units.

The above-described resin X1-I may include a repeating unit (for example, any of the other repeating units) other than the above-described repeating units as long as the effects of the present invention are not inhibited.

Resin X1-II

The resin X1-II is a resin having the repeating unit X1-II.

Preferred embodiments of the repeating unit X1-II are as described above.

In the resin X1-II, the content of the repeating unit represented by Formula (XR) above is preferably 90 mol% or more, more preferably 95 mol% or more relative to all the repeating units. The upper limit value is preferably 100 mol% or less.

The above-described resin X1-II may include a repeating unit (for example, any of the other repeating units) other than the above-described repeating unit as long as the effects of the present invention are not inhibited.

Resin X1-III

The resin X1-III is a resin having the repeating unit X1-III.

Preferred embodiments of the repeating unit X1-III are as described above.

In the resin X1-III, the content of the repeating unit represented by Formula (XS) above is preferably 90 mol% or more, more preferably 95 mol% or more relative to all the repeating units. The upper limit value is preferably 100 mol% or less.

The above-described resin X1-III may include a repeating unit (for example, any of the other repeating units) other than the above-described repeating unit as long as the effects of the present invention are not inhibited.

Resin Y1

Hereinafter, the resin Y1 included in the resist composition satisfying the requirement Y will be described.

The resin Y1 corresponds to a so-called main chain scission-type resin that undergoes a decrease in molecular weight caused by the scission of the main chain due to action of exposure, acid, base, or heating.

Examples of the form of the resin Y1 which is a main chain scission-type resin include resins having the following configurations. In the resins having the configurations described below, a resin Y1-I corresponds to a resin that undergoes a decrease in molecular weight caused by the scission of the main chain due to action of exposure, and resins Y1-II and Y1-III correspond to a resin that undergoes a decrease in molecular weight caused by the scission of the main chain due to action of acid.

The resin Y1 includes neither the polarity-decreasing group, the interactive group, nor the polar group described above.

Resin Y1-I

The resin Y1-I is a resin having the repeating unit X1-I.
Preferred embodiments of the repeating unit X1-I are as described above.
In the resin Y1-I, the total content of the repeating unit represented by Formula (XP) above and the repeating unit represented by Formula (XQ) above is preferably 90 mol% or more, more preferably 95 mol% or more relative to all the repeating units. The upper limit value is preferably 100 mol% or less.
In the resin Y1-I, the repeating unit represented by Formula (XP) above and the repeating unit represented by Formula (XQ) above may be in any form of a random copolymer, a block copolymer, an alternating copolymer (ABAB···), and the like, and among these, an alternating copolymer is preferred.
A preferred embodiment of the resin Y1-I is, for example, an embodiment in which the presence ratio of the alternating copolymer in the resin Y1 is 90 mass% or more (preferably 100 mass% or more) relative to the total mass of the resin Y1.
In the resin Y1-I, the content of the repeating unit represented by Formula (XP) above is preferably 10 to 90 mol%, more preferably 30 to 70 mol% relative to all the repeating units. Furthermore, in the resin Y1-I, the content of the repeating unit represented by Formula (XQ) above is preferably 10 to 90 mol%, more preferably 30 to 70 mol% relative to all the repeating units.
The resin Y1-I may include a repeating unit (for example, any of the other repeating units) other than the above-described repeating units as long as the effects of the present invention are not inhibited.

Resin Y1-II

The resin Y1-II is a resin having the repeating unit X1-II.
Preferred embodiments of the repeating unit X1-II are as described above.
In the resin Y1-II, the content of the repeating unit represented by Formula (XR) above is preferably 90 mol% or more, more preferably 95 mol% or more relative to all the repeating units. The upper limit value is preferably 100 mol% or less.
The resin Y1-II may include a repeating unit (for example, any of the other repeating units) other than the above-described repeating unit as long as the effects of the present invention are not inhibited.

Resin Y1-III

The resin Y1-III is a resin having the repeating unit X1-III.
Preferred embodiments of the repeating unit X1-III are as described above.
In the resin Y1-III, the content of the repeating unit represented by Formula (XS) above is preferably 90 mol% or more, more preferably 95 mol% or more relative to all the repeating units. The upper limit value is preferably 100 mol% or less.
The resin Y1-III may include a repeating unit (for example, any of the other repeating units) other than the above-described repeating unit as long as the effects of the present invention are not inhibited.
The resin Y1 can be synthesized by an ordinary method (for example, radical polymerization).
The resin Y1 preferably has a weight-average molecular weight of 1,000 to 200,000, more preferably 2,500 to 150,000, still more preferably 30,00 to 50,000 in terms of polystyrene as determined by the GPC method. When the weight-average molecular weight is within the above numerical range, deterioration of heat resistance and dry etching resistance can be further suppressed. In addition, deterioration of developing performance and deterioration of film-forming properties due to an increase in viscosity can also be further suppressed.
The dispersity (molecular weight distribution) of the resin Y1 is usually 1.0 to 5.0, preferably 1.0 to 3.0, more preferably 1.2 to 3.0, still more preferably 1.2 to 2.0. The smaller the dispersity, the better the resolution and the resist shape.
In the resist composition satisfying the requirement Y, the content of the resin Y1 is preferably 50 to 100 mass%, more preferably 60 to 100 mass%, still more preferably 70 to 100 mass% relative to the total solid content of the resist composition.
Such resins Y1 may be used alone or in combination of two or more thereof. When two or more resins are used, the total content thereof is preferably within the above preferred content range.
In the resist composition satisfying the requirement Y, the content of the resin Y1 is preferably 10 to 90 mass%, more preferably 20 to 80 mass%, still more preferably 30 to 70 mass% relative to the total content of the resin Y1 and the resin Y2.

Resin Y2

Hereinafter, the resin Y2 included in the resist composition satisfying the requirement Y will be described.

An embodiment (Embodiment 1) of the resin Y2 is, for example, an embodiment in which the resin has a polarity-decreasing group.

Another embodiment (Embodiment 2) of the resin Y2 is, for example, an embodiment in which the resin has an interactive group.

Another embodiment (Embodiment 3) of the resin Y2 is, for example, an embodiment in which the resin has a polar group.

Another embodiment (Embodiment 4) of the resin Y2 is, for example, an embodiment which includes two or more embodiments selected from the group consisting of an embodiment in which the resin has a polarity-decreasing group, an embodiment in which the resin has an interactive group, and an embodiment in which the resin has a polar group.

In Embodiments 1 to 4, as described above, the polarity-decreasing group refers to a group that decreases polarity due to action of exposure, acid, base, or heating. The interactive group refers to an interactive group that forms an interaction with an onium salt compound and that is released from the interaction due to action of exposure, acid, base, or heating.

In the embodiments in which the resin Y2 has an interactive group (Embodiments 2 and 4), the resist composition further includes an onium salt compound that can generate a bond due to an interaction with the interactive group in the resin Y2.

In the embodiments in which the resin Y2 has a polar group (Embodiments 3 and 4), the resist composition further includes a capping agent that reacts with the polar groups in the resin Y2 to decrease the polarity of the resin Y2.

The polarity-decreasing group, the interactive group, and the polar group which can be included in the resin Y2 respectively have the same definitions and preferred embodiments as in the polarity-decreasing group, the interactive group, and the polar group which can be included in the resin X1 described above.

Preferred embodiments of the resin Y2 will be described below.

The resin Y2 is not particularly limited as long as one or more selected from the group consisting of a polarity-decreasing group, an interactive group, and a polar group are included.

The resin Y2 preferably includes a repeating unit having one or more functional groups selected from the group consisting of a polarity-decreasing group, an interactive group, and a polar group. Examples of such a repeating unit include repeating units represented by any one of Formulae (I) to (III) and Formula (T1) below.

The resin Y2 may include a repeating unit (for example, any of the other repeating units) other than the above-described repeating units as long as the effects of the present invention are not inhibited.

Repeating Unit Represented by Formula (I)

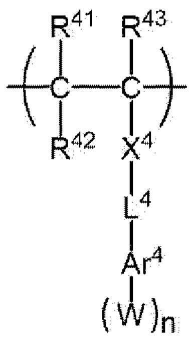

(I)

In Formula (I),

$R^{41}$, $R^{42}$, and $R^{43}$ each independently represent a hydrogen atom, an alkyl group, a cycloalkyl group, a halogen atom, a cyano group, or an alkoxycarbonyl group. However, $R^{42}$ may be bonded to $Ar^4$ to form a ring, and in such a case, $R^{42}$ represents a single bond or an alkylene group.

$X^4$ represents a single bond, -COO-, or -CONR$^{64}$-, where $R^{64}$ represents a hydrogen atom or an alkyl group.

$L^4$ represents a single bond or an alkylene group.

$Ar^4$ represents an (n + 1)-valent aromatic ring group, and when $Ar^4$ is bonded to $R^{42}$ to form a ring, $Ar^4$ represents an (n + 2)-valent aromatic ring group.

W represents a polarity-decreasing group, an interactive group, or a polar group.

n represents an integer of 1 to 5.

In $R^{41}$, $R^{42}$, and $R^{43}$ in Formula (I), the alkyl group is preferably an alkyl group having 20 or less carbon atoms, such as a methyl group, an ethyl group, a propyl group, an isopropyl group, a n-butyl group, a sec-butyl group, a hexyl group, a 2-ethylhexyl group, an octyl group, or a dodecyl group, more preferably an alkyl group having 8 or less carbon atoms, still more preferably an alkyl group having 3 or less carbon atoms.

In $R^{41}$, $R^{42}$, and $R^{43}$ in Formula (I), the cycloalkyl group may be monocyclic or polycyclic. In particular, monocyclic cycloalkyl groups having 3 to 8 carbon atoms, such as a cyclopropyl group, a cyclopentyl group, and a cyclohexyl group, are preferred.

In $R^{41}$, $R^{42}$, and $R^{43}$ in Formula (I), the halogen atom may be a fluorine atom, a chlorine atom, a bromine atom, or an iodine atom, and is preferably a fluorine atom.

The alkyl group included in the alkoxycarbonyl group in $R^{41}$, $R^{42}$, and $R^{43}$ in Formula (I) is preferably the same as the alkyl group in $R^{41}$, $R^{42}$, and $R^{43}$ above.

Each of the groups represented by $R^{41}$, $R^{42}$, and $R^{43}$ may have a substituent.

$Ar^4$ represents an (n + 1)-valent aromatic ring group. The divalent aromatic ring group in the case where n is 1 is preferably, for example, an arylene group having 6 to 18 carbon atoms, such as a phenylene group, a tolylene group, a naphthylene group, or an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, or a thiazole ring. Of these, an arylene group is preferred, and a phenylene group or a naphthalene group is more preferred. The aromatic ring group may have a substituent.

Specific examples of the (n + 1)-valent aromatic ring group in the case where n is an integer of 2 or more include groups provided by removing any (n - 1) hydrogen atoms from any of the foregoing specific examples of the divalent aromatic ring group.

The (n + 1)-valent aromatic ring group may further have a substituent.

Examples of substituents that the foregoing alkyl group, cycloalkyl group, alkoxycarbonyl group, alkylene group, and (n + 1)-valent aromatic ring group can have include the alkyl groups described in $R^{41}$, $R^{42}$, and $R^{43}$ in Formula (I); alkoxy groups such as a methoxy group, an ethoxy group, a hydroxyethoxy group, a propoxy group, a hydroxypropoxy group, and a butoxy group; aryl groups such as a phenyl group; and halogen atoms.

The alkyl group in $R^{64}$ in $-CONR^{64}-$ (where $R^{64}$ represents a hydrogen atom or an alkyl group) represented by $X^4$ may be an alkyl group having 20 or less carbon atoms, such as a methyl group, an ethyl group, a propyl group, an isopropyl group, a n-butyl group, a sec-butyl group, a hexyl group, a 2-ethylhexyl group, an octyl group, or a dodecyl group, and is preferably an alkyl group having 8 or less carbon atoms.

$X^4$ is preferably a single bond, -COO-, or -CONH-, more preferably a single bond or - COO-.

The alkylene group in $L^4$ is preferably an alkylene group having 1 to 8 carbon atoms, such as a methylene group, an ethylene group, a propylene group, a butylene group, a hexylene group, or an octylene group.

Specific examples of the polarity-decreasing group, the interactive group, and the polar group represented by W are as described above. In particular, W preferably represents a group represented by Formula (KD1), an interactive group, or a polar group.

The repeating unit represented by Formula (I) is preferably a repeating unit represented by Formula (1) below.

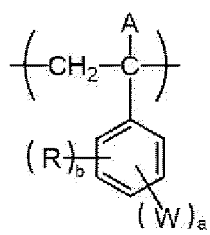

(1)

In Formula (1),

A represents a hydrogen atom, an alkyl group, a cycloalkyl group, a halogen atom, or a cyano group.

R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group. When a plurality of R's are present, the plurality of R's may be the same or different. When a plurality of R's are present, the plurality of R's may together form a ring. R is preferably a hydrogen atom.

a represents an integer of 1 to 3.

b represents an integer of 0 to (5-a).

W represents a polarity-decreasing group, an interactive group, or a polar group.

Examples of the repeating unit represented by Formula (I) are as follows. In the formulae, a represents 1 or 2. W represents a polarity-decreasing group, an interactive group, or a polar group. Specific examples of the polarity-decreasing group, the interactive group, and the polar group represented by W are as described above.

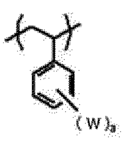
(B-1)

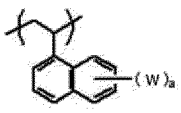
(B-2)

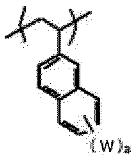
(B-3)

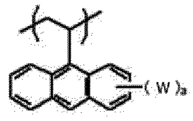
(B-4)

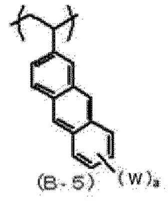
(B-5)

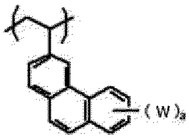
(B-6)

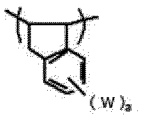
(B-7)

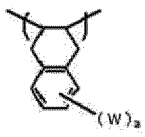
(B-8)

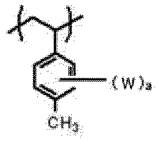
(B-9)

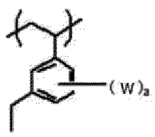
(B-10)

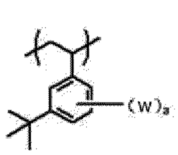
(B-11)

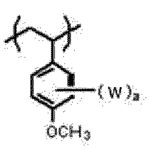
(B-12)

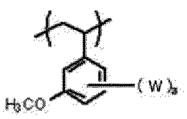
(B-13)

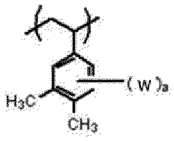
(B-14)

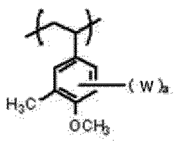
(B-15)

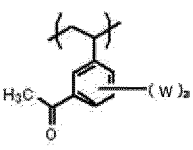
(B-16)

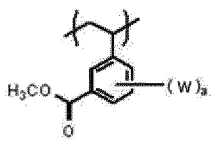
(B-17)

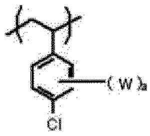
(B-18)

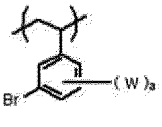
(B-19)

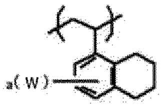
(B-20)

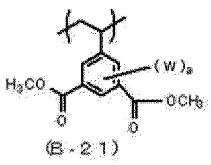
(B-21)

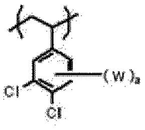
(B-22)

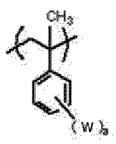
(B-23)

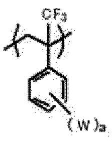
(B-24)

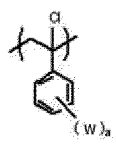
(B-25)

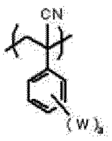
(B-26)

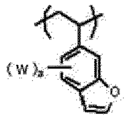
(B-27)

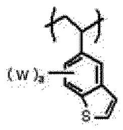
(B-28)

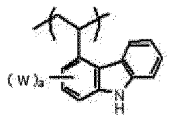
(B-29)

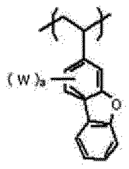
(B-30)

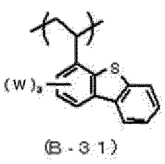
(B-31)

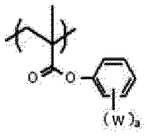
(B-32)

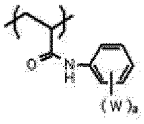
(B-33)

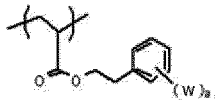
(B-34)

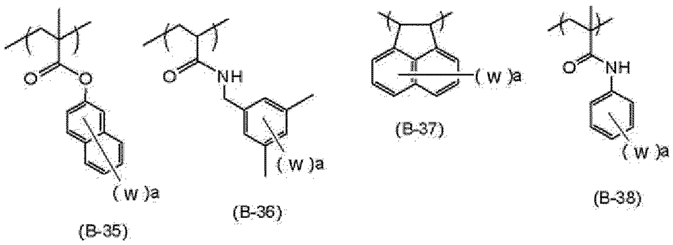

(B-35) (B-36) (B-37) (B-38)

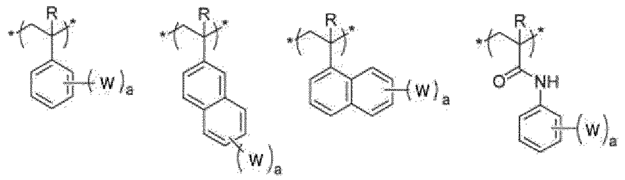

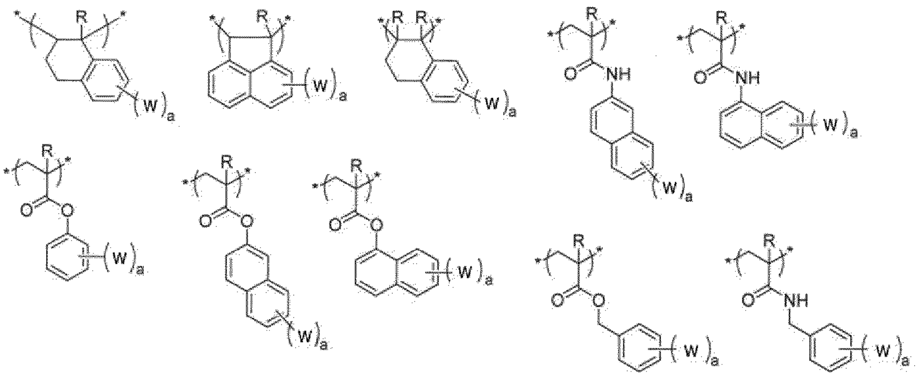

The content of the repeating unit represented by Formula (I) is preferably 10 mol% or more, more preferably 20 mol% or more relative to all the repeating units in the resin Y2. The upper limit value thereof is preferably 100 mol% or less, more preferably 90 mol% or less, still more preferably 80 mol% or less.

Repeating Unit Represented by Formula (II)

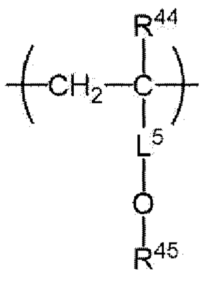

(II)

$L^5$ represents a divalent linking group.

Examples of the divalent linking group represented by $L^5$ include -CO-, -O-, -S-, -SO-, - $SO_2$-, hydrocarbon groups (such as an alkylene group, a cycloalkylene group, an alkenylene group, and an arylene group), and a linking group provided by linking a plurality of these together. The hydrocarbon groups may have a substituent. The substituent is not particularly limited, and may be, for example, a fluorine atom or an iodine atom.

In particular, the divalent linking group represented by $L^5$ is preferably -CO-, an arylene group, or -arylene group-alkylene group-, more preferably -CO- or an -arylene group.

The arylene group is preferably a phenylene group.

The alkylene group may be linear or branched. The number of carbon atoms of the alkylene group is not particularly limited, but is preferably 1 to 10, more preferably 1 to 3.

$R^{44}$ represents a hydrogen atom, a fluorine atom, an iodine atom, an alkyl group, or an aryl group.

The alkyl group may be linear or branched. The number of carbon atoms of the alkyl group is not particularly limited, but is preferably 1 to 10, more preferably 1 to 3.

The alkyl group and the aryl group represented by $R^{44}$ may have a substituent. The substituent is not particularly limited, and may be, for example, a fluorine atom or an iodine atom.

$R^{45}$ represents a leaving group that leaves due to action of acid.

Examples of the leaving group that leaves due to action of acid and represented by $R^{45}$ include the above-described leaving groups represented by Formulae (Y1) to (Y4).

A preferred embodiment of $L^5$, $R^{44}$, and $R^{45}$ is an embodiment in which at least one of $L^5$, $R^{44}$, or $R^{45}$ has a fluorine atom or an iodine atom.

However, the repeating unit represented by Formula (II) includes an acid-decomposable group having a structure in which a polar group is protected with a leaving group, and the polar group generated after acid decomposition is more hydrophobic than the acid-decomposable group before acid decomposition. Specifically, the logP of the acid-decomposable group is smaller than the logP of the polar group after the leaving group leaves.

The content of the repeating unit represented by Formula (II) is preferably 10 mol% or more, more preferably 20 mol% or more relative to all the repeating units in the resin Y2. The upper limit value thereof is preferably 100 mol% or less, more preferably 90 mol% or less, still more preferably 80 mol% or less.

Repeating Unit Represented by Formula (III)

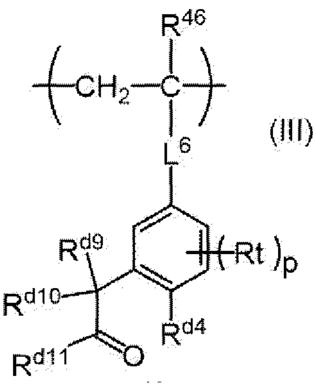

(III)

$R^{46}$ represents a hydrogen atom, a fluorine atom, an iodine atom, an alkyl group, or an aryl group.

The alkyl group may be linear or branched. The number of carbon atoms of the alkyl group is not particularly limited, but is preferably 1 to 10, more preferably 1 to 3.

The alkyl group and the aryl group represented by $R^{46}$ may have a substituent. The substituent is not particularly limited, and may be, for example, a fluorine atom or an iodine atom.

$L^6$ represents a single bond or a divalent linking group.

Examples of the divalent linking group represented by $L^6$ include -CO-, -O-, -S-, -SO-, - $SO_2$-, hydrocarbon groups (such as an alkylene group, a cycloalkylene group, an alkenylene group, and an arylene group), and a linking group provided by linking a plurality of these together. The hydrocarbon groups may have a substituent. The substituent is not particularly limited, and may be, for example, a fluorine atom or an iodine atom.

The divalent linking group represented by $L^6$ is preferably -COO-.

$R^{d4}$ and $R^{d9}$ to $R^{d11}$ have the same definitions and preferred embodiments as in the above-described $R^{d4}$ and $R^{d9}$ to $R^{d11}$, respectively, in Formula (KD2).

$R^t$ represents a substituent. The substituent is not particularly limited, and may be, for example, an alkyl group having 1 to 6 carbon atoms, an alkoxy group having 1 to 6 carbon atoms, a fluorine atom, or an iodine atom.

p represents an integer of 0 to 3.

The content of the repeating unit represented by Formula (III) is preferably 10 mol% or more, more preferably 20 mol% or more relative to all the repeating units in the resin Y2. The upper limit value thereof is preferably 100 mol% or less, more preferably 90 mol% or less, still more preferably 80 mol% or less.

Repeating Unit Represented by Formula (T1)

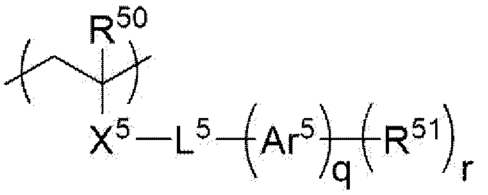 (T1)

In Formula (T1) above, $R^{50}$ represents a hydrogen atom, a halogen atom, or an alkyl group that may have a substituent.

$X^5$ represents a single bond, -COO-, or -$CONR^{52}$-, where $R^{52}$ represents a hydrogen atom or an alkyl group.

$L^5$ represents a single bond or an alkylene group.

$Ar^5$ represents an (r + 1)-valent aromatic ring group or alicyclic group.

$R^{51}$ represents an interactive group or a polar group.

q represents 0 or 1.

When q is 0, r represents 1. When q is 1, r represents an integer of 1 to 4.

The alkyl group represented by $R^{50}$ may be linear, branched, or cyclic. The number of carbon atoms of the alkyl group is preferably 1 to 12, more preferably 1 to 6, still more preferably 1 to 3. The alkyl group represented by $R^{50}$ may have a substituent. The substituent is not particularly limited, but may be, for example, a halogen atom or a hydroxy group.

The alkyl group in $R^{64}$ in -$CONR^{64}$- (where $R^{64}$ represents a hydrogen atom or an alkyl group) represented by $X^5$ may be an alkyl group having 20 or less carbon atoms, such as a methyl group, an ethyl group, a propyl group, an isopropyl group, a n-butyl group, a sec-butyl group, a hexyl group, a 2-ethylhexyl group, an octyl group, or a dodecyl group, and is preferably an alkyl group having 8 or less carbon atoms.

$X^5$ is preferably a single bond, -COO-, or -CONH-, more preferably a single bond or - COO-.

Examples of the divalent linking group represented by $L^5$ include, but are not particularly limited to, -CO-, -O-, -SO-, -$SO_2$-, -$NR^A$-, an alkylene group (which preferably has 1 to 6 carbon atoms and may be linear or branched), and a divalent linking group provided by combining a plurality of these. The alkylene group may have a substituent. The substituent may be, for example, a halogen atom or a hydroxy group. $R^A$ may be a hydrogen atom or an alkyl group having 1 to 6 carbon atoms.

$Ar^5$ represents an (r + 1)-valent aromatic ring group or alicyclic group.

The divalent aromatic ring group in the case where r is 1 is preferably, for example, an arylene group having 6 to 18 carbon atoms, such as a phenylene group, a tolylene group, a naphthylene group, or an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, or a thiazole ring. Of these, an arylene group is preferred, and a phenylene group or a naphthalene group is more preferred. The aromatic ring group may have a substituent other than $R^{51}$.

Specific examples of the (r + 1)-valent aromatic ring group in the case where r is an integer of 2 or more include groups provided by removing any (r - 1) hydrogen atoms from any of the foregoing specific examples of the divalent aromatic ring group.

The (r + 1)-valent alicyclic group represented by $Ar^5$ may include a heteroatom such as an oxygen atom and a carbonyl carbon. Examples of the (r + 1)-valent alicyclic group represented by $Ar^5$ include groups provided by removing any r hydrogen atoms from a polycyclic cycloalkane such as norbornene, tetracyclodecane, tetracyclododecane, or adamantane. The (r + 1)-valent alicyclic group represented by $Ar^5$ may be a group provided by removing any r hydrogen atoms from a lactone ring. The lactone ring is preferably a five- to seven-membered lactone ring, more preferably a five- to seven-membered lactone ring to which another ring structure is fused so as to form a bicyclo structure or a spiro structure.

The (r + 1)-valent aromatic ring group and alicyclic group may further have a substituent. Examples of the substituent include alkyl groups that are the same as the alkyl groups represented by $R^{50}$; alkoxy groups such as a methoxy group, an ethoxy group, a hydroxyethoxy group, a propoxy group, a hydroxypropoxy group, and a butoxy group; aryl groups such as a phenyl group; and halogen atoms.

In Formula (T1) above, $R^{51}$ represents an interactive group or a polar group. The interactive group and the polar group are as described above.

The content of the repeating unit represented by Formula (T1) is preferably 10 mol% or more, more preferably 20 mol% or more relative to all the repeating units in the resin Y2. The upper limit value thereof is preferably 100 mol% or less, more preferably 90 mol% or less, still more preferably 80 mol% or less.

Resin Z1

Hereinafter, the resin Z1 included in the resist composition satisfying the requirement Z will be described.

The resin Z1 may be any resin having a polarity-decreasing group.

The resin Z1 preferably has a repeating unit having a polarity-decreasing group.

Examples of the repeating unit having a polarity-decreasing group include the above-described repeating units represented by any one of Formulae (I) to (IV).

An example of preferred embodiments of the resin Z1 will be described below.

An embodiment (Embodiment 1) of the resin Z1 is, for example, an embodiment in which the resin has a polarity-decreasing group and has an interactive group that forms an interaction with an onium salt compound and that is released from the interaction due to action of exposure, acid, base, or heating (interactive group).

An embodiment (Embodiment 2) of the resin Z1 is, for example, an embodiment in which the resin has a polarity-decreasing group and has an onium salt group that is decomposed due to action of exposure.

An embodiment (Embodiment 3) of the resin Z1 is, for example, an embodiment in which the resin has a polarity-decreasing group and undergoes a decrease in molecular weight due to action of exposure, acid, base, or heating. One form of Embodiment 3 may be an embodiment in which the decrease in molecular weight is caused by the decomposition of the main chain due to action of exposure.

An embodiment (Embodiment 4) of the resin Z1 is, for example, an embodiment in which the resin has a polarity-decreasing group and has a reactive group A.

An embodiment (Embodiment 5) of the resin Z1 is, for example, an embodiment in which the resin has a polarity-decreasing group and has a reactive group A and a reactive group B that reacts with the reactive group A.

An embodiment (Embodiment 6) of the resin Z1 is, for example, an embodiment in which the resin has a polarity-decreasing group and has a polar group.

An embodiment (Embodiment 7) of the resin Z1 is, for example, an embodiment to which at least two or more of Embodiments 1 to 6 above correspond. Such an embodiment may be, for example, an embodiment in which the resin has a polarity-decreasing group, an onium salt group that is decomposed due to action of exposure, and an interactive group. Alternatively, such an embodiment may be, for example, an embodiment in which the resin has a polarity-decreasing group, an onium salt group that is decomposed due to action of exposure, and an interactive group and undergoes a decrease in molecular weight due to action of light, acid, or base.

The resin Z1 may be any resin having a polarity-decreasing group, but preferably includes a repeating unit having a polarity-decreasing group from the viewpoint of providing a better effect of the present invention.

In Embodiments 1 to 6, the polarity-decreasing group refers to a group that decreases polarity due to action of exposure, acid, base, or heating.

In Embodiment 1, the interactive group refers to an interactive group that forms an interaction with an onium salt compound and that is released from the interaction due to action of exposure, acid, base, or heating. In the case of Embodiment 1, the composition further includes an onium salt compound that can generate a bond due to an interaction with the interactive group in the resin Z1.

In the resist film including the resin Z1 of Embodiment 1, the interaction between the onium salt compound and the interactive group in the resin is released by the action of exposure, acid, base, or heating. Consequently, the intermolecular forces of the respective components in the resist film before development are thereby further reduced, the resist film tends to be in a more stable state upon structural relaxation, and a change in sensitivity when the waiting time before development varies is less likely to occur.

In addition, in the resist film including the resin Z1 of Embodiment 1, the interaction between the onium salt compound and the interactive group in the resin is released by the action of exposure, acid, base, or heating, and an exposed region is thereby more easily dissolved in organic solvent-based developers, and, as a result, the resolution of a pattern to be formed is also further improved.

The resin Z1 of Embodiment 1 preferably includes a repeating unit having an interactive group from the viewpoint of providing a better effect of the present invention.

In the resist film including the resin Z1 of Embodiment 2, the onium salt is decomposed due to exposure, and the intermolecular forces of the respective components in the resist film before development are thereby further reduced, the resist film tends to be in a more stable state upon structural relaxation, and a change in sensitivity when the waiting time before development varies is less likely to occur.

In addition, in the resist film including the resin Z1 of Embodiment 2, the onium salt is decomposed due to exposure, and an exposed region is thereby more easily dissolved in organic solvent-based developers, and, as a result, the resolution of a pattern to be formed is also further improved.

The resin Z1 of Embodiment 2 preferably includes a repeating unit having an onium salt group from the viewpoint of providing a better effect of the present invention.

In the resist film including the resin Z1 of Embodiment 3, the molecular weight of the resin Z1 is decreased by

the action of exposure, acid, base, or heating, and the intermolecular forces of the respective components in the resist film before development are thereby further reduced, the resist film tends to be in a more stable state upon structural relaxation, and a change in sensitivity when the waiting time before development varies is less likely to occur.

In addition, in the resist film including the resin Z1 of Embodiment 3, the molecular weight of the resin Z1 is decreased by the action of exposure, acid, base, or heating, and an exposed region is thereby more easily dissolved in organic solvent-based developers, and, as a result, the resolution of a pattern to be formed is also further improved.

In Embodiments 4 and 5, the reactive group A means a group that is bonded to a crosslinking agent including a reactive group B that reacts (undergoes a crosslinking reaction) with the reactive group A or a reactive group B in the resin Z1 to form a bond in the resist film. The bond between the reactive group A and the reactive group B is broken by the action of exposure, acid, base, or heating. In Embodiment 5, since the resin Z 1 has the reactive group B in its molecule, the composition may not include a crosslinking agent including the reactive group B.

In each of the resist films including the resins Z1 of Embodiments 4 and 5, a bond is formed by the reactive group A and the reactive group B before exposure, but the bond formed by the reactive group A and the reactive group B is broken by the action of exposure, acid, base, or heating, and the intermolecular forces of the respective components in the resist film before development are thereby further reduced, the resist film tends to be in a more stable state upon structural relaxation, and a change in sensitivity when the waiting time before development varies is less likely to occur.

In addition, in each of the resist films including the resins Z1 of Embodiments 4 and 5, the bond formed by the reactive group A and the reactive group B is broken by the action of exposure, acid, base, or heating, and an exposed region is thereby more easily dissolved in organic solvent-based developers, and, as a result, the resolution of a pattern to be formed is also further improved.

The resins Z1 of Embodiments 4 and 5 preferably include a repeating unit having a reactive group A from the viewpoint of providing a better effect of the present invention.

The resin Z1 of Embodiment 5 preferably includes a repeating unit having a reactive group A and a repeating unit having a reactive group B from the viewpoint of providing a better effect of the present invention.

When the resist composition includes the resin Z1 of Embodiment 4 or 5, the resist composition also preferably further includes a photoacid generator.

The types of the reactive group A and the reactive group B will be described in detail later, but both groups are also preferably groups whose reaction proceeds under heating.

The bond formed by the reaction between the reactive group A and the reactive group B may be a covalent bond or a non-covalent bond. The non-covalent bond may be, for example, an ionic bond (for example, an ionic bond formed between a carboxylic group and an amino group).

When the resist composition includes the resin Z1 of Embodiment 6, the composition further includes a compound that reacts with the polar group due to action of exposure, acid, base, or heating (capping agent).

Resin Z2

Hereinafter, the resin Z2 included in the resist composition satisfying the requirement Z will be described.

The resin Z2 may be any resin having a polar group.

An example of preferred embodiments of the resin Z2 will be described below.

An embodiment (Embodiment 1) of the resin Z2 is, for example, an embodiment in which the resin has a polar group and has an interactive group that forms an interaction with an onium salt compound and that is released from the interaction due to action of exposure, acid, base, or heating (interactive group).

An embodiment (Embodiment 2) of the resin Z2 is, for example, an embodiment in which the resin has a polar group and has an onium salt group that is decomposed due to action of exposure.

An embodiment (Embodiment 3) of the resin Z2 is, for example, an embodiment in which the resin has a polar group and undergoes a decrease in molecular weight due to action of exposure, acid, base, or heating. One form of Embodiment 3 may be an embodiment in which the decrease in molecular weight is caused by the decomposition of the main chain due to action of exposure.

An embodiment (Embodiment 4) of the resin Z2 is, for example, an embodiment in which the resin has a polar group and has a reactive group A.

An embodiment (Embodiment 5) of the resin Z2 is, for example, an embodiment in which the resin has a polar group and has a reactive group A and a reactive group B that reacts with the reactive group A.

An embodiment (Embodiment 6) of the resin Z2 is, for example, an embodiment in which the resin has a polar group and has a polarity-decreasing group.

An embodiment (Embodiment 7) of the resin Z2 is, for example, an embodiment to which at least two or more of Embodiments 1 to 6 above correspond.

Such an embodiment may be, for example, an embodiment in which the resin has a polar group, an onium salt group that is decomposed due to action of exposure, and an interactive group. Alternatively, such an embodiment may

be, for example, an embodiment in which the resin has a polar group, an onium salt group that is decomposed due to action of exposure, and an interactive group and undergoes a decrease in molecular weight due to action of light, acid, or base.

The polar group, the interactive group, the polarity-decreasing group (onium salt group), the reactive group A, and the reactive group B are as described above.

The resin Z2 may be any resin having a polar group, but preferably includes a repeating unit having a polar group from the viewpoint of providing a better effect of the present invention.

When the resist composition includes the resin Z2, the resist composition further includes a compound that reacts with the polar group due to action of exposure, acid, base, or heating (capping agent).

In Embodiment 5, since the resin Z2 has the reactive group B in its molecule, the resist composition may not include a crosslinking agent including the reactive group B.

A first preferred embodiment of the resin Z2 will be described below.

The resin Z2 preferably includes a repeating unit having a polar group.

Examples of the polar group include those described above.

Examples of the repeating unit having a polar group include embodiments of the above-described repeating unit represented by Formula (T1) where $R^{51}$ represents a polar group.

In the resin Z2, one or more repeating units having a polar group may be included, or two or more of such repeating units may be included.

In the resin Z2, the content of the repeating unit having a polar group is preferably 5 mol% or more, more preferably 10 mol% or more relative to all the repeating units in the resin Z2. The upper limit value thereof is preferably 100 mol% or less, more preferably 90 mol% or less, still more preferably 80 mol% or less.

The resin Z2 may include a repeating unit (for example, any of the other repeating units) other than the repeating unit having a polar group.

A second preferred embodiment of the resin Z2 will be described below.

The resin Z2 of the second preferred embodiment is preferably a resin that undergoes a decrease in molecular weight due to action of exposure, acid, base, or heating, more preferably a resin that undergoes a decrease in molecular weight caused by the decomposition of a structure (e.g., a main chain structure or a side chain structure) in the resin due to action of exposure, acid, base, or heating, still more preferably a resin that undergoes a decrease in molecular weight caused by the scission of the main chain in the resin due to action of exposure, acid, base, or heating (a so-called main chain scission resin).

Examples of the form of the resin Z2 which is a main chain scission-type resin include resins having the above-described (block or repeating unit that undergoes a decrease in molecular weight caused by the scission of the main chain due to action of exposure, acid, base, or heating).

Resin S1

It is also preferable that the resist composition satisfying the requirement Z further include a resin S1 different from the resin Z1 and the resin Z2. That is, it is also preferable that the resist composition satisfy the requirement C1 or the requirement C2 described above and include a resin S1.

The resin Z1 and the resin Z2 have the same definitions and preferred embodiments as in the resin Z1 and the resin Z2, respectively, included in the resist composition (resist composition of the first exemplary embodiment) described above.

Components other than the resin Z1 and the resin Z2, the contents thereof, and the like are the same as those of the resist composition (resist composition of the first exemplary embodiment) described above, and preferred embodiments thereof are also the same.

Preferred embodiments of the resin S1 will be described below.

An embodiment (Embodiment 1) of the resin S1 is, for example, an embodiment in which the resin has an interactive group that forms an interaction with an onium salt compound and that is released from the interaction due to action of exposure, acid, base, or heating (interactive group).

An embodiment (Embodiment 2) of the resin S1 is, for example, an embodiment in which the resin has an onium salt group that is decomposed due to action of exposure.

An embodiment (Embodiment 3) of the resin S1 is, for example, an embodiment in which the resin undergoes a decrease in molecular weight due to action of exposure, acid, base, or heating. One form of Embodiment 3 may be an embodiment in which the decrease in molecular weight is caused by the decomposition of the main chain due to action of exposure.

An embodiment (Embodiment 4) of the resin S1 is, for example, an embodiment in which the resin has a reactive group A.

An embodiment (Embodiment 5) of the resin S1 is, for example, an embodiment in which the resin has a reactive

group A and a reactive group B that reacts with the reactive group A.

An embodiment (Embodiment 6) of the resin S1 is, for example, an embodiment to which at least two or more of Embodiments 1 to 5 above correspond. Such an embodiment may be, for example, an embodiment in which the resin has an interactive group and undergoes a decrease in molecular weight due to action of exposure, acid, base, or heating.

The onium salt group, the interactive group, the reactive group A, and the reactive group B are as described above.

Preferably, the resin S1 does not include a polar group (provided that when used in combination with a compound that reacts with the polar group due to action of exposure, acid, base, or heating (capping agent)) or a polarity-decreasing group. Note that when a component corresponding to the capping agent is not included in the composition, the resin S1 also preferably includes a polar group.

In Embodiment 5, since the resin S1 has the reactive group B in its molecule, the composition may not include a crosslinking agent including the reactive group B.

Preferred embodiments of the resin S 1 will be described below.

A first preferred embodiment of the resin S 1 may include resins having the following configurations.

Resin S1A: A resin including one or more repeating units selected from the group consisting of a repeating unit having an onium salt group, a repeating unit having an interactive group, a repeating unit having a reactive group A, and a repeating unit having a reactive group B (provided that when a repeating unit having a reactive group B is included, a repeating unit having a reactive group A is also included).

Resin S1B: A resin that undergoes a decrease in molecular weight due to action of exposure, acid, base, or heating.

Resin S1C: A resin that undergoes a decrease in molecular weight due to action of exposure, acid, base, or heat and that has one or more groups selected from the group consisting of an onium salt group, an interactive group, a reactive group A, and a reactive group B (provided that when the resin has a reactive group B, the resin also has a reactive group A).

The resins S1A to S1C will be described below.

Resin S1A

The resin S 1A includes one or more repeating units selected from the group consisting of a repeating unit having an onium salt group, a repeating unit having an interactive group, a repeating unit having a reactive group A, and a repeating unit having a reactive group B.

Examples of the repeating unit having an onium salt group include embodiments of the above-described repeating unit represented by Formula (T1) where $R^{51}$ represents an onium salt group.

Examples of the repeating unit having an interactive group include embodiments of the above-described repeating unit represented by Formula (T1) where $R^{51}$ represents an interactive group.

Examples of the repeating unit having a reactive group A include embodiments of the above-described repeating unit represented by Formula (T1) where $R^{51}$ represents a reactive group A.

Examples of the repeating unit having a reactive group B include embodiments of the above-described repeating unit represented by Formula (T1) where $R^{51}$ represents a reactive group B.

When the resin S1A includes a repeating unit having an onium salt group, a repeating unit having an interactive group, a repeating unit having a reactive group A, and/or a repeating unit having a reactive group B, the content of the repeating unit (total content in the case of a plurality of repeating units) is preferably 5 mol% or more, more preferably 10 mol% or more relative to all the repeating units in the resin S1A. The upper limit value thereof is, for example, 100 mol% or less, preferably 90 mol% or less, more preferably 80 mol% or less.

When the resin S1A includes a repeating unit having an onium salt group, the content of the repeating unit is preferably 2 mol% or more, more preferably 5 mol% or more relative to all the repeating units in the resin S1A. The upper limit value thereof is, for example, 100 mol% or less, preferably 90 mol% or less, more preferably 80 mol% or less.

When the resin S1A includes a repeating unit having an interactive group, the content of the repeating unit is preferably 5 mol% or more, more preferably 10 mol% or more relative to all the repeating units in the resin S1A. The upper limit value thereof is, for example, 100 mol% or less, preferably 90 mol% or less, more preferably 80 mol% or less.

When the resin S1A includes a repeating unit having a reactive group A, the content of the repeating unit is preferably 5 mol% or more, more preferably 10 mol% or more relative to all the repeating units in the resin S1A. The upper limit value thereof is, for example, 100 mol% or less, preferably 90 mol% or less, more preferably 80 mol% or less.

When the resin S1A includes a repeating unit having a reactive group B, the content of the repeating unit is preferably 5 mol% or more, more preferably 10 mol% or more relative to all the repeating units in the resin S1A. The upper limit value thereof is preferably 90 mol% or less, more preferably 80 mol% or less.

When the composition does not include the compound that reacts with a polar group due to action of exposure, acid, base, or heating (capping agent), the resin S1A also preferably includes a repeating unit having a polar group.

The resin S1A may include a repeating unit other than the above-described repeating units. Examples of the other repeating unit include the other repeating units described in the section of Other Repeating Units.

Resin S1B

The resin S1B is a resin that undergoes a decrease in molecular weight due to action of exposure, acid, base, or heating.

The resin S1B preferably corresponds to a so-called main chain scission-type resin that undergoes a decrease in molecular weight caused by the scission of the main chain due to action of exposure, acid, base, or heating.

Examples of the form of the resin S1B which is a main chain scission-type resin include the resins described in the section "second preferred embodiment of the resin X1 (main chain decomposition-type resin)", in which each substituent does not include a polarity-decreasing group, an interactive group, an onium salt group, a polar group, a reactive group A, or a reactive group B.

Resin S1C

The resin S1C is a resin that undergoes a decrease in molecular weight due to action of exposure, acid, base, or heat and that has one or more groups selected from the group consisting of an interactive group, an onium salt group, a reactive group A, and a reactive group B.

The resin S1C preferably corresponds to a so-called main chain scission-type resin that undergoes a decrease in molecular weight caused by the scission of the main chain due to action of exposure, acid, base, or heating.

Examples of the form of the resin S1C which is a main chain scission-type resin include the resins described in the section "second preferred embodiment of the resin X1 (main chain decomposition-type resin)", in which each substituent does not include a polarity-decreasing group or a polar group (provided that when used in combination with a compound that reacts with the polar group due to action of exposure, acid, base, or heating (capping agent)), and at least one substituent of the resin is one selected from the group consisting of an interactive group, an onium salt group, a reactive group A, and a reactive group B.

Note that when a component corresponding to the capping agent is not included in the composition, the resin S1C also preferably includes a polar group.

The resin can be synthesized by an ordinary method (for example, radical polymerization).

The resin preferably has a weight-average molecular weight of 1,000 to 200,000, more preferably 2,500 to 150,000, still more preferably 30,00 to 50,000 in terms of polystyrene as determined by the GPC method. When the weight-average molecular weight is within the above numerical range, deterioration of heat resistance and dry etching resistance can be further suppressed. In addition, deterioration of developing performance and deterioration of film-forming properties due to an increase in viscosity can also be further suppressed.

The dispersity (molecular weight distribution) of the resin is usually 1.0 to 5.0, preferably 1.0 to 3.0, more preferably 1.2 to 3.0, still more preferably 1.2 to 2.0. The smaller the dispersity, the better the resolution and the resist shape.

In the resist composition, the content of the resin is preferably 50.0 to 99.9 mass%, more preferably 60.0 to 99.0 mass%, still more preferably 70.0 to 99.0 mass% relative to the total solid content of the composition.

Such resins may be used alone or in combination of two or more thereof. When two or more resins are used, the total content thereof is preferably within the above preferred content range.

Photoacid Generator

The resist composition preferably includes a compound that generates acid upon irradiation with an actinic ray or a radiation (photoacid generator).

A preferred embodiment of the photoacid generator may be a compound (I) or a compound (II) described below.

The compound (I) and the compound (II) (hereinafter, the "compound (I) and compound (II)" are also referred to as "photoacid generator PG1 ") will be described below.

Compound (I)

The compound (I) is a compound having one or more of the following moiety X and one or more of the following moiety Y and is a compound that generates an acid including the following first acidic moiety derived from the following moiety X and the following second acidic moiety derived from the following moiety Y upon irradiation with an actinic ray or a radiation.

Moiety X: A moiety that is constituted by an anionic moiety $A_1^-$ and a cationic moiety $M_1^+$ and that forms the

first acidic moiety represented by $HA_1$ upon irradiation with an actinic ray or a radiation

Moiety Y: A moiety that is constituted by an anionic moiety $A_2^-$ and a cationic moiety $M_2^+$ and that forms the second acidic moiety represented by $HA_2$ upon irradiation with an actinic ray or a radiation

Here, the compound (I) satisfies the following condition I.

Condition I: A compound PI in which, in the compound (I), the cationic moiety $M_1^+$ in the moiety X and the cationic moiety $M_2^+$ in the moiety Y are replaced by $H^+$ has an acid dissociation constant a1 derived from an acidic moiety represented by $HA_1$ in which the cationic moiety $M_1^+$ in the moiety X is replaced by $H^+$ and an acid dissociation constant a2 derived from an acidic moiety represented by $HA_2$ in which the cationic moiety $M_2^+$ in the moiety Y is replaced by $H^+$, and the acid dissociation constant a2 is larger than the acid dissociation constant a1.

The condition I will be more specifically described below.

When the compound (I) is, for example, a compound that generates an acid having a single first acidic moiety derived from the moiety X and a single second acidic moiety derived from the moiety Y, the compound PI corresponds to a "compound having $HA_1$ and $HA_2$".

The acid dissociation constant a1 and the acid dissociation constant a2 of such a compound PI are more specifically described as follows. In determination of the acid dissociation constants of the compound PI, the pKa determined when the compound PI is turned into a "compound having $A_1^-$ and $HA_2$" is the acid dissociation constant a1, and the pKa determined when the "compound having $A_1^-$ and $HA_2$" is turned into "compound having $A_1^-$ and $A_2^-$" is the acid dissociation constant a2.

When the compound (I) is, for example, a compound that generates an acid having two first acidic moieties derived from the moiety X and a single second acidic moiety derived from the moiety Y, the compound PI corresponds to a "compound having two $HA_1$ and a single $HA_2$".

In determination of the acid dissociation constants of such a compound PI, the acid dissociation constant determined when the compound PI is turned into a "compound having a single $A_1^-$, a single $HA_1$, and a single $HA_2$" and the acid dissociation constant determined when the "compound having a single $A_1^-$, a single $HA_1$, and a single $HA_2$" is turned into a "compound having two $A_1^-$ and a single $HA_2$" correspond to the above-described acid dissociation constant a1. The acid dissociation constant determined when the "compound having two $A_1^-$ and a single $HA_2$" is turned into a "compound having two $A_1^-$ and $A_2^-$" corresponds to the acid dissociation constant a2. That is, as in such a compound PI, when there are a plurality of acid dissociation constants derived from acidic moieties represented by $HA_1$ in which the cationic moiety $M_1^+$ in the moiety X is replaced by $H^+$, the value of the acid dissociation constant a2 is larger than the maximum value of the plurality of acid dissociation constants a1. Note that, when the acid dissociation constant determined when the compound PI is turned into a "compound having a single $A_1^-$, a single $HA_1$, and a single $HA_2$" is defined as aa and the acid dissociation constant determined when the "compound having a single $A_1^-$, a single $HA_1$, and a single $HA_2$" is turned into a "compound having two $A_1^-$ and a single $HA_2$" is defined as ab, the relation between aa and ab satisfies aa < ab.

The acid dissociation constant a1 and the acid dissociation constant a2 can be determined by the above-described method of measuring an acid dissociation constant.

The compound PI corresponds to an acid generated when the compound (I) is irradiated with an actinic ray or a radiation.

When the compound (I) has two or more moieties X, the moieties X may be the same or different. The two or more $A_1^-$ and the two or more $M_1^+$ may be individually the same or different.

In the compound (I), the $A_1^-$ and the $A_2^-$, and the $M_1^+$ and the $M_2^+$ may be individually the same or different, but the $A_1^-$ and the $A_2^-$ are preferably different.

From the viewpoint of a better LWR performance of the pattern to be formed, in the compound PI, the difference between the acid dissociation constant a1 (in the case where there are a plurality of acid dissociation constants a1, the maximum value thereof) and the acid dissociation constant a2 is preferably 0.1 or more, more preferably 0.5 or more, still more preferably 1.0 or more. The upper limit value of the difference between the acid dissociation constant a1 (in the case where there are a plurality of acid dissociation constants a1, the maximum value thereof) and the acid dissociation constant a2 is not particularly limited, but is, for example, 16 or less.

From the viewpoint of a better LWR performance of the pattern to be formed, in the compound PI, the acid dissociation constant a2 is, for example, 20 or less, preferably 15 or less. The lower limit value of the acid dissociation constant a2 is preferably -4.0 or more.

From the viewpoint of a better LWR performance of the pattern to be formed, in the compound PI, the acid dissociation constant a1 is preferably 2.0 or less, more preferably 0 or less. The lower limit value of the acid dissociation constant a1 is preferably -20.0 or more.

The anionic moiety $A_1^-$ and the anionic moiety $A_2^-$ are moieties including a negatively charged atom or atomic group and are, for example, moieties selected from the group consisting of Formulae (AA-1) to (AA-3) and Formulae (BB-1) to (BB-6) below. The anionic moiety $A_1^-$ is preferably one that can form an acidic moiety having a small acid dissociation constant, particularly preferably any one of Formulae (AA-1) to (AA-3). The anionic moiety $A_2^-$ is preferably

one that can form an acidic moiety having a larger acid dissociation constant than the anionic moiety $A_1^-$ and is preferably selected from the group consisting of Formulae (BB-1) to (BB-6). In Formulae (AA-1) to (AA-3) and Formulae (BB-1) to (BB-6) below, * represents a bonding site. $R^A$ represent a monovalent organic group. The monovalent organic groups represented by $R^A$ may be, for example, a cyano group, a trifluoromethyl group, or a methanesulfonyl group.

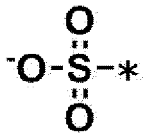
AA-1
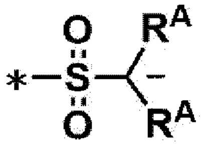
AA-2
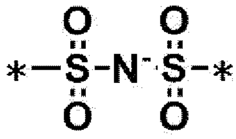
AA-3

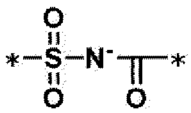
BB-1
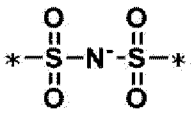
BB-2
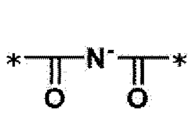
BB-3
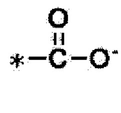
BB-4
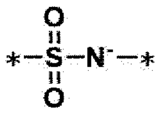
BB-5
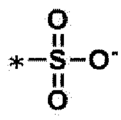
BB-6

The cationic moiety Mi and the cationic moiety $M_2^+$ are moieties including a positively charged atom or atomic group and are, for example, organic cations having a charge number of 1. The organic cations are not particularly limited, but may be, for example, the same organic cations as those represented by $M_{11}^+$ and $M_{12}^+$ in Formula (Ia-1) described below.

The specific structure of the compound (I) is not particularly limited, and examples of the compound (I) include compounds represented by Formula (Ia-1) to Formula (Ia-5) described below.

First, the compound represented by Formula (Ia-1) will be described below. The compound represented by Formula (Ia-1) is as follows.

$$M_{11}^+\ A_{11}^- \text{-} L_1 \text{-} A_{12}^-\ M_{12}^+ \qquad \text{(Ia-1)}$$

The compound (Ia-1) generates an acid represented by $HA_{11}$-$L_1$-$A_{12}H$ upon irradiation with an actinic ray or a radiation.

In Formula (Ia-1), $M_{11}^+$ and $M_{12}^+$ each independently represent an organic cation.

$A_{11}^-$ and $A_{12}^-$ each independently represent a monovalent anionic functional group.

$L_1$ represents a divalent linking group.

$M_{11}^+$ and $M_{12}^+$ may be the same or different.

$A_{11}^-$ and $A_{12}^-$ may be the same or different, but are preferably different from each other.

Note that, in a compound PIa ($HA_{11}$-$L_1$-$A_{12}H$) in which, in Formula (Ia-1) above, the organic cations represented by $M_{11}^+$ and $M_{12}^+$ are replaced by $H^+$, the acid dissociation constant a2 derived from the acidic moiety represented by $A_{12}H$ is larger than the acid dissociation constant a1 derived from the acidic moiety represented by $HA_{11}$. Preferred values of the acid dissociation constant a1 and the acid dissociation constant a2 are the same as those described above. The compound PIa is the same as the acid generated from the compound represented by Formula (Ia-1) upon irradiation with an actinic ray or a radiation.

At least one of $M_{11}^+$, $M_{12}^+$, $A_{11}^-$, $A_{12}^-$, or $L_1$ may have an acid-decomposable group as a substituent.

In Formula (Ia-1), the organic cations represented by $M_{11}^+$ and $M_{12}^+$ are as described below.

The monovalent anionic functional group represented by $A_{11}^-$ means a monovalent group including the above-described anionic moiety $A_1^-$. The monovalent anionic functional group represented by $A_{12}^-$ means a monovalent group including the above-described anionic moiety $A_2^-$.

The monovalent anionic functional groups represented by $A_{11}^-$ and $A_{12}^-$ are preferably monovalent anionic functional groups including the anionic moiety of any one of Formulae (AA-1) to (AA-3) and Formulae (BB-1) to (BB-6), more preferably monovalent anionic functional groups selected from the group consisting of Formulae (AX-1) to (AX-3) and Formulae (BX-1) to (BX-7). In particular, the monovalent anionic functional group represented by $A_{11}^-$ is preferably the monovalent anionic functional group represented by any one of Formulae (AX-1) to (AX-3). In particular, the monovalent anionic functional group represented by $A_{12}^-$ is preferably the monovalent anionic functional group represented by any one of Formulae (BX-1) to (BX-7), more preferably the monovalent anionic functional group represented by any one of Formulae (BX-1) to (BX-6).

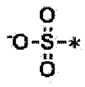
AX-1

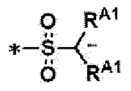
AX-2

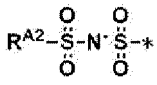
AX-3

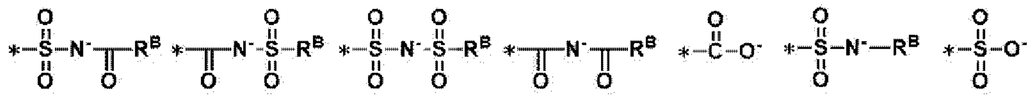
BX-1 BX-2 BX-3 BX-4 BX-5 BX-6 BX-7

In Formulae (AX-1) to (AX-3), $R^{A1}$ and $R^{A2}$ each independently represent a monovalent organic group. * represents a bonding site.

The monovalent organic groups represented by $R^{A1}$ may be, for example, a cyano group, a trifluoromethyl group, or a methanesulfonyl group.

The monovalent organic group represented by $R^{A2}$ is preferably a linear, branched, or cyclic alkyl group or an aryl group.

The number of carbon atoms of the alkyl group is preferably 1 to 15, more preferably 1 to 10, still more preferably 1 to 6.

The alkyl group may have a substituent. The substituent is preferably a fluorine atom or a cyano group, more preferably a fluorine atom. When the alkyl group has a fluorine atom as a substituent, the alkyl group may be a perfluoroalkyl group.

The aryl group is preferably a phenyl group or a naphthyl group, more preferably a phenyl group.

The aryl group may have a substituent. The substituent is preferably a fluorine atom, an iodine atom, a perfluoroalkyl group (for example, preferably having 1 to 10 carbon atoms, more preferably 1 to 6 carbon atoms), or a cyano group, more preferably a fluorine atom, an iodine atom, or a perfluoroalkyl group.

In Formulae (BX-1) to (BX-4) and Formula (BX-6), $R^B$ represent a monovalent organic group. * represents a bonding site.

The monovalent organic groups represented by $R^B$ are preferably a linear, branched, or cyclic alkyl group or an aryl group.

The number of carbon atoms of the alkyl group is preferably 1 to 15, more preferably 1 to 10, still more preferably 1 to 6.

The alkyl group may have a substituent. The substituent is not particularly limited, but the substituent is preferably a fluorine atom or a cyano group, more preferably a fluorine atom. When the alkyl group has a fluorine atom as a substituent, the alkyl group may be a perfluoroalkyl group.

Note that, in the alkyl group, when a carbon atom serving as a bonding site (which corresponds to, for example, in the case of Formulae (BX-1) and (BX-4), the carbon atom directly bonded to -CO- clearly shown in the formula of such an alkyl group; in the case of Formulae (BX-2) and (BX-3), the carbon atom directly bonded to $-SO_2-$ clearly shown in the formula of such an alkyl group; and in the case of Formula (BX-6), the carbon atom directly bonded to $-N^-$- clearly shown in the formula of the alkyl group) has a substituent, the substituent is also preferably a substituent other than a fluorine atom and a cyano group.

In the alkyl group, a carbon atom may be replaced by a carbonyl carbon.

The aryl group is preferably a phenyl group or a naphthyl group, more preferably a phenyl group.

The aryl group may have a substituent. The substituent is preferably a fluorine atom, an iodine atom, a perfluoroalkyl group (for example, preferably having 1 to 10 carbon atoms, more preferably 1 to 6 carbon atoms), a cyano group, an alkyl group (for example, preferably having 1 to 10 carbon atoms, more preferably 1 to 6 carbon atoms), an alkoxy group (for example, preferably having 1 to 10 carbon atoms, more preferably 1 to 6 carbon atoms), or an alkoxycarbonyl group (for example, preferably having 2 to 10 carbon atoms, more preferably 2 to 6 carbon atoms), more preferably a fluorine atom, an iodine atom, a perfluoroalkyl group, an alkyl group, an alkoxy group, or an alkoxycarbonyl group.

In Formula (I), examples of the divalent linking group represented by $L_1$ include, but are not particularly limited to, -CO-, -NR-, -CO-, -O-, -S-, -SO-, $-SO_2-$, an alkylene group (which preferably has 1 to 6 carbon atoms and may be linear or branched), a cycloalkylene group (preferably having 3 to 15 carbon atoms), an alkenylene group (preferably having 2 to 6 carbon atoms), a divalent aliphatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic heterocyclic group (which is preferably a five- to ten-membered ring, more preferably a five- to seven-membered ring, still more preferably a five- or six-membered

ring having at least one N atom, O atom, S atom, or Se atom in the ring structure), and a divalent aromatic hydrocarbon ring group (which is preferably a six- to ten-membered ring, more preferably a six-membered ring), and a divalent linking group provided by combining a plurality of these. R above is, for example, a hydrogen atom or a monovalent organic group. The monovalent organic group is not particularly limited, but is preferably, for example, an alkyl group (preferably having 1 to 6 carbon atoms).

The alkylene group, the cycloalkylene group, the alkenylene group, the divalent aliphatic heterocyclic group, the divalent aromatic heterocyclic group, and the divalent aromatic hydrocarbon ring group may have a substituent. The substituent is, for example, a halogen atom (preferably a fluorine atom).

The divalent linking group represented by $L_1$ is particularly preferably a divalent linking group represented by Formula (L1).

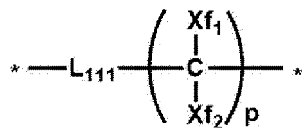
(L1)

In Formula (L1), $L_{111}$ represents a single bond or a divalent linking group.

The divalent linking group represented by $L_{111}$ is not particularly limited, and may be, for example, -CO-, -NH-, -O-, -SO-, $-SO_2-$, an alkylene group that may have a substituent (which preferably has 1 to 6 carbon atoms and may be linear or branched), a cycloalkylene group that may have a substituent (preferably having 3 to 15 carbon atoms), an arylene group that may have a substituent (preferably having 6 to 10 carbon atoms), or a divalent linking group provided by combining a plurality of these. The substituent is not particularly limited, and may be, for example, a halogen atom.

p represents an integer of 0 to 3, and preferably represents an integer of 1 to 3.

Each $Xf_1$ independently represents a fluorine atom or an alkyl group substituted with at least one fluorine atom. The number of carbon atoms of the alkyl group is preferably 1 to 10, more preferably 1 to 4. The alkyl group substituted with at least one fluorine atom is preferably a perfluoroalkyl group.

Each $Xf_2$ independently represents a hydrogen atom, an alkyl group that may have a fluorine atom as a substituent, or a fluorine atom. The number of carbon atoms of the alkyl group is preferably 1 to 10, more preferably 1 to 4. In particular, $Xf_2$ preferably represents a fluorine atom or an alkyl group substituted with at least one fluorine atom, more preferably a fluorine atom or a perfluoroalkyl group.

In particular, $Xf_1$ and $Xf_2$ are preferably each independently a fluorine atom or a perfluoroalkyl group having 1 to 4 carbon atoms, more preferably a fluorine atom or $CF_3$. In particular, $Xf_1$ and $Xf_2$ are each still more preferably a fluorine atom.

**[0948]** * represents a bonding site.

When $L_1$ in Formula (Ia-1) represents a divalent linking group represented by Formula (L1), the direct bond (*) on the Lm-side in Formula (L1) is preferably bonded to $A_{12}^-$ in Formula (Ia-1).

In Formula (I), the organic cations represented by $M_{11}^+$ and $M_{12}^+$ are, for example, the same as the organic cation represented by $M_A^+$ in the group represented by Formula (O1) described in an onium salt group, which is one form of the polarity-decreasing group, in the above Polarity-Decreasing Group, Interactive Group, and Polar Group, and preferred embodiments thereof are also the same.

Specific examples of the organic cations represented by $M_{11}^+$ and $M_{12}^+$ are as follows; however, the present invention is not limited to these.

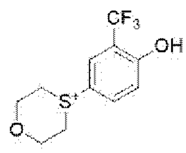
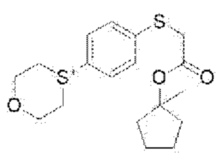
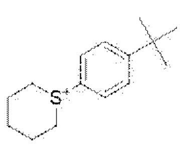
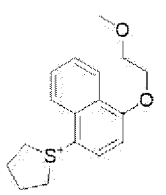
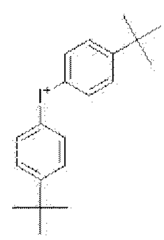
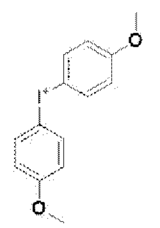

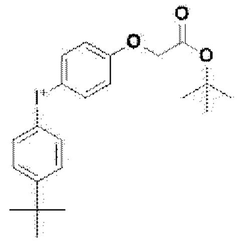

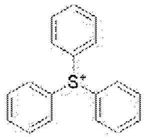
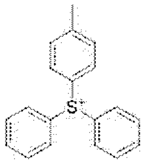
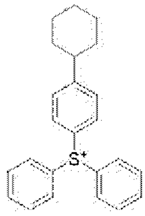
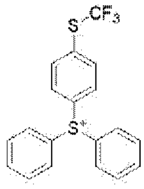
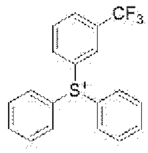
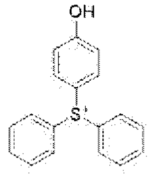

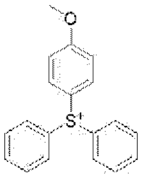
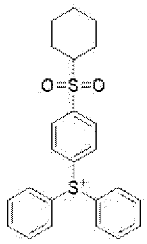
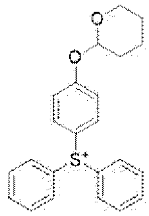
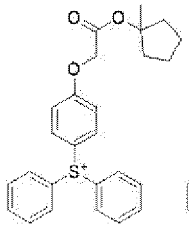
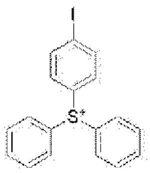
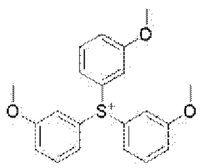

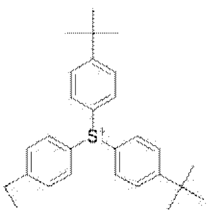
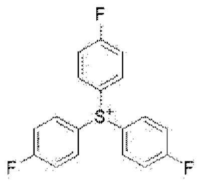
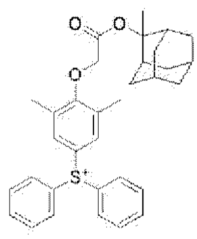
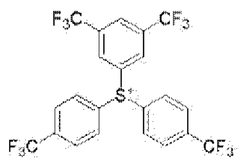

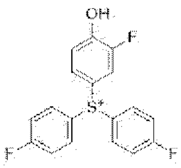
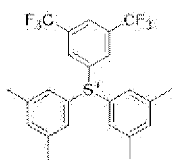
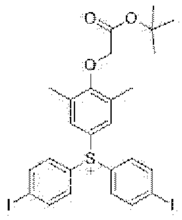
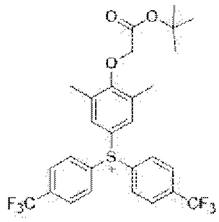
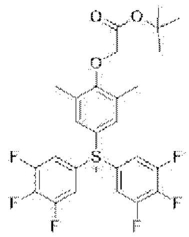

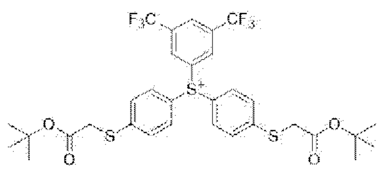
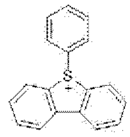
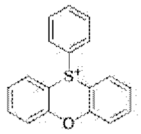
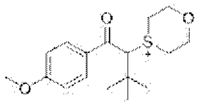

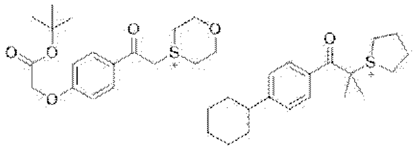
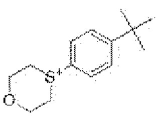
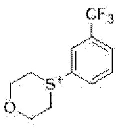
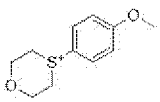
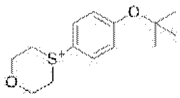

Next, Formulae (Ia-2) to (Ia-4) will be described.

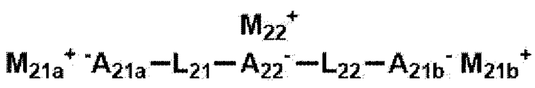

(Ia-2)

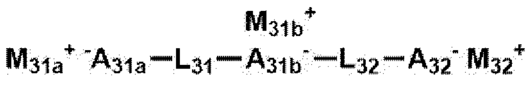

(Ia-3)

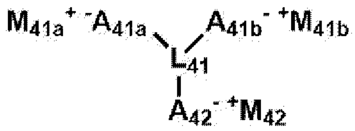

(Ia-4)

In Formula (Ia-2), $A_{21a}^-$ and $A_{21b}^-$ each independently represent a monovalent anionic functional group. Here, each of the monovalent anionic functional groups represented by $A_{21a}^-$ and $A_{21b}^-$ means a monovalent group including the above-described anionic moiety $A_1^-$. The monovalent anionic functional groups represented by $A_{21a}^-$ and $A_{21b}^-$ are not particularly limited, but each may be, for example, a monovalent anionic functional group selected from the group consisting of Formulae (AX-1) to (AX-3) above.

$A_{22}^-$ represents a divalent anionic functional group. Here, the divalent anionic functional group represented by $A_{22}^-$ means a divalent group including the above-described anionic moiety $A_2^-$. Examples of the divalent anionic functional group represented by $A_{22}^-$ include divalent anionic functional groups represented by Formulae (BX-8) to (BX-11) below.

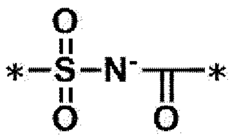

BX-8

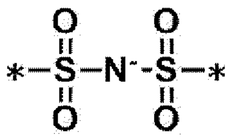

BX-9

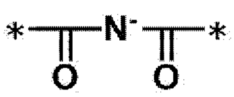

BX-10

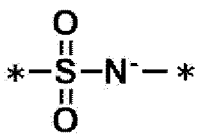

BX-11

$M_{21a}^+$, $M_{21b}^+$, and $M_{22}^+$ each independently represent an organic cation. The organic cations represented by $M_{21a}^+$, $M_{21b}^+$, and $M_{22}^+$ have the same definitions and preferred embodiments as in $M_1^+$ described above.

$L_{21}$ and $L_{22}$ each independently represent a divalent organic group.

In a compound PIa-2 in which, in Formula (Ia-2) above, the organic cations represented by $M_{21a}^+$, $M_{21b}^+$, and $M_{22}^+$ are replaced by $H^+$, the acid dissociation constant a2 derived from the acidic moiety represented by $A_{22}H$ is larger than the acid dissociation constant a1-1 derived from $A_{21a}H$ and the acid dissociation constant a1-2 derived from the acidic moiety represented by $A_{21b}H$. Note that the acid dissociation constant a1-1 and the acid dissociation constant a1-2 correspond to the above-described acid dissociation constant a1.

$A_{21a}^-$ and $A_{21b}^-$ may be the same or different. $M_{21a}^+$, $M_{21b}^+$, and $M_{22}^+$ may be the same or different.

At least one of $M_{21a}^+$, $M_{21b}^+$, $M_{22}^+$, $A_{21a}^-$, $A_{21b}^-$, $A_{22}^-$, $L_{21}$, or $L_{22}$ may have an acid-decomposable group as a substituent.

In Formula (Ia-3), $A_{31a}^-$ and $A_{32}^-$ each independently represent a monovalent anionic functional group. The monovalent anionic functional group represented by $A_{31a}^-$ has the same definition and preferred embodiments as in the above-described $A_{21a}^-$ and $A_{21b}^-$ in Formula (Ia-2).

The monovalent anionic functional group represented by $A_{32}^-$ means a monovalent group including the above-described anionic moiety $A_2^-$. The monovalent anionic functional group represented by $A_{32}^-$ is not particularly limited, but may be, for example, a monovalent anionic functional group selected from the group consisting of Formulae (BX-1) to (BX-7) above.

$A_{31b}^-$ represents a divalent anionic functional group. Here, the divalent anionic functional group represented by $A_{31b}^-$ means a divalent group including the above-described anionic moiety $A_1^-$. The divalent anionic functional group represented by $A_{31b}^-$ may be, for example, a divalent anionic functional group represented by Formula (AX-4) below.

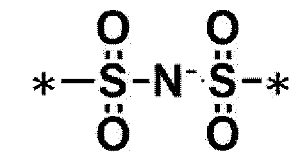

AX-4

$M_{31a}^+$, $M_{31b}^+$, and $M_{32}^+$ each independently represent a monovalent organic cation. The organic cations represented by $M_{31a}^+$, $M_{31b}^+$, and $M_{32}^+$ have the same definitions and preferred embodiments as in $M_1^+$ described above.

$L_{31}$ and $L_{32}$ each independently represent a divalent organic group.

In a compound PIa-3, in which, in Formula (Ia-3) above, the organic cations represented by $M_{31a}^+$, $M_{31b}^+$, and $M_{32}^+$ are replaced by $H^+$, the acid dissociation constant a2 derived from the acidic moiety represented by $A_{32}H$ is larger than the acid dissociation constant a1-3 derived from the acidic moiety represented by $A_{31a}H$ and the acid dissociation constant a1-4 derived from the acidic moiety represented by $A_{31b}H$. Note that the acid dissociation constant a1-3 and the acid dissociation constant a1-4 correspond to the above-described acid dissociation constant a1.

$A_{31a}^-$ and $A_{32}^-$ may be the same or different. $M_{31a}^+$, $M_{31b}^+$, and $M_{32}^+$ may be the same or different.

At least one of $M_{31a}^+$, $M_{31b}^+$, $M_{32}^+$, $A_{31a}^-$, $A_{31b}^-$, $A_{32}^-$, $L_{31}$, or $L_{32}$ may have an acid-decomposable group as a substituent.

In Formula (Ia-4), $A_{41a}^-$, $A_{41b}^-$, and $A_{42}^-$ each independently represent a monovalent anionic functional group. The definition of the monovalent anionic functional groups represented by $A_{41a}^-$ and $A_{41b}^-$ is the same as that of the above-described $A_{21a}^-$ and $A_{21b}^-$ in Formula (Ia-2). The monovalent anionic functional group represented by $A_{42}^-$ has the same definition and preferred embodiments as in the above-described $A_{32}^-$ in Formula (Ia-3).

$M_{41a}^+$, $M_{41b}^+$, and $M_{42}^+$ each independently represent an organic cation.

$L_{41}$ represents a trivalent organic group.

In a compound PIa-4 in which, in Formula (Ia-4) above, the organic cations represented by $M_{41a}^+$, $M_{41b}^+$, and $M_{42}^+$ are replaced by $H^+$, the acid dissociation constant a2 derived from the acidic moiety represented by $A_{42}H$ is larger than the acid dissociation constant a1-5 derived from the acidic moiety represented by $A_{41a}H$ and the acid dissociation constant a1-6 derived from the acidic moiety represented by $A_{41b}H$. Note that the acid dissociation constant a1-5 and the acid dissociation constant a1-6 correspond to the above-described acid dissociation constant a1.

$A_{41a}^-$, $A_{41b}^-$, and $A_{42}^-$ may be the same or different. $M_{41a}^+$, $M_{41b}^+$, and $M_{42}^+$ may be the same or different.

At least one of $M_{41a}^+$, $M_{41b}^+$, $M_{42}^+$, $A_{41a}^-$, $A_{41b}^-$, $A_{42}^-$, or $L_{41}$ may have an acid-decomposable group as a substituent.

Examples of the divalent organic groups represented by $L_{21}$ and $L_{22}$ in Formula (Ia-2) and $L_{31}$ and $L_{32}$ in Formula (Ia-3) include, but are not particularly limited to, -CO-, -NR-, -O-, - S-, -SO-, $-SO_2-$, an alkylene group (which preferably has 1 to 6 carbon atoms and may be linear or branched), a cycloalkylene group (preferably having 3 to 15 carbon atoms), an alkenylene group (preferably having 2 to 6 carbon atoms), a divalent aliphatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic heterocyclic group (which is preferably a five-to ten-membered ring, more preferably a five- to seven-membered ring, still more preferably a five- or six-membered ring having at least one N atom, O atom, S atom, or Se atom in the ring structure), a divalent aromatic hydrocarbon ring group (which is preferably a six- to ten-membered ring, more preferably a six-membered ring), and a divalent organic group provided by combining a plurality of these. R above is, for example, a hydrogen atom or a monovalent organic group. The monovalent organic group is not particularly limited, but is preferably, for example, an alkyl group (preferably having 1 to 6 carbon atoms).

The alkylene group, the cycloalkylene group, the alkenylene group, the divalent aliphatic heterocyclic group, the divalent aromatic heterocyclic group, and the divalent aromatic hydrocarbon ring group may have a substituent. The substituent is, for example, a halogen atom (preferably a fluorine atom).

The divalent organic groups represented by $L_{21}$ and $L_{22}$ in Formula (Ia-2) and $L_{31}$ and $L_{32}$ in Formula (Ia-3) are also preferably, for example, divalent organic groups represented by Formula (L2) below.

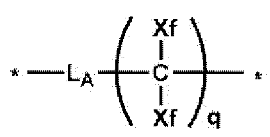

(L2)

In Formula (L2), q represents an integer of 1 to 3. * represents a bonding site.

Xf's each independently represent a fluorine atom or an alkyl group substituted with at least one fluorine atom. The number of carbon atoms of the alkyl group is preferably 1 to 10, more preferably 1 to 4. The alkyl group substituted with at least one fluorine atom is preferably a perfluoroalkyl group.

Each Xf is preferably a fluorine atom or a perfluoroalkyl group having 1 to 4 carbon atoms, more preferably a fluorine atom or $CF_3$. In particular, both of Xf's are still more preferably fluorine atoms.

$L_A$ represents a single bond or a divalent linking group.

The divalent linking group represented by $L_A$ is not particularly limited, but may be, for example, -CO-, -O-, -SO-, -$SO_2$-, an alkylene group (which preferably has 1 to 6 carbon atoms and may be linear or branched), a cycloalkylene group (preferably having 3 to 15 carbon atoms), a divalent aromatic hydrocarbon cyclic group (preferably a six- to ten-membered ring, more preferably a six-membered ring), or a divalent linking group provided by combining a plurality of these.

The alkylene group, the cycloalkylene group, and the divalent aromatic hydrocarbon ring group may have a substituent. The substituent is, for example, a halogen atom (preferably a fluorine atom).

Examples of the divalent organic group represented by Formula (L2) include *-$CF_2$-*, *-$CF_2$-$CF_2$-*, *-$CF_2$-$CF_2$-$CF_2$-*, *-Ph-O-$SO_2$-$CF_2$-*, *-Ph-O-$SO_2$-$CF_2$-$CF_2$-*, *-Ph-O-$SO_2$-$CF_2$-$CF_2$-$CF_2$-*, and *-Ph-OCO-$CF_2$-*. Note that Ph is a phenylene group that may have a substituent, and preferably a 1,4-phenylene group. The substituent is not particularly limited, but is preferably an alkyl group (for example, preferably having 1 to 10 carbon atoms, more preferably 1 to 6 carbon atoms), an alkoxy group (for example, preferably having 1 to 10 carbon atoms, more preferably 1 to 6 carbon atoms), or an alkoxycarbonyl group (for example, preferably having 2 to 10 carbon atoms, more preferably 2 to 6 carbon atoms).

When $L_{21}$ and $L_{22}$ in Formula (Ia-2) represent a divalent organic group represented by Formula (L2), the direct bond (*) on the $L_A$-side in Formula (L2) is preferably bonded to $A_{22}^-$ in Formula (Ia-2).

When $L_{32}$ in Formula (Ia-3) represents a divalent organic group represented by Formula (L2), the direct bond (*) on the $L_A$-side in Formula (L2) is preferably bonded to $A_{32}^-$ in Formula (Ia-3).

The trivalent organic group represented by $L_{41}$ in Formula (Ia-4) is not particularly limited, and may be, for example, a trivalent organic group represented by Formula (L3) below.

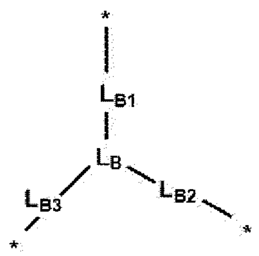

(L3)

In Formula (L3), $L_B$ represents a trivalent hydrocarbon ring group or a trivalent heterocyclic group. * represents a bonding site.

The hydrocarbon ring group may be an aromatic hydrocarbon ring group or an aliphatic hydrocarbon ring group. The number of carbon atoms included in the hydrocarbon ring group is preferably 6 to 18, more preferably 6 to 14. The heterocyclic group may be an aromatic heterocyclic group or an aliphatic heterocyclic group. The heterocycle is preferably a five- to ten-membered ring, more preferably a five- to seven-membered ring, still more preferably a five- or six-membered ring having at least one N atom, O atom, S atom, or Se atom in the ring structure.

Of these, $L_B$ is preferably a trivalent hydrocarbon ring group, more preferably a benzene ring group or an adamantane ring group. The benzene ring group or the adamantane ring group may have a substituent. The substituent is not particularly limited, but is, for example, a halogen atom (preferably a fluorine atom).

In Formula (L3), $L_{B1}$ to $L_{B3}$ each independently represent a single bond or a divalent linking group. Examples of the divalent linking group represented by $L_{B1}$ to $L_{B3}$ include, but are not particularly limited to, -CO-, -NR-, -O-, -S-, -SO-, -$SO_2$-, an alkylene group (which preferably has 1 to 6 carbon atoms and may be linear or branched), a cycloalkylene group (preferably having 3 to 15 carbon atoms), an alkenylene group (preferably having 2 to 6 carbon atoms), a divalent aliphatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic hydrocarbon ring group (which is preferably a six- to ten-membered ring, more preferably a six-membered ring), and a divalent linking group provided by combining a plurality

of these. R above is, for example, a hydrogen atom or a monovalent organic group. The monovalent organic group is not particularly limited, but is preferably, for example, an alkyl group (preferably having 1 to 6 carbon atoms).

The alkylene group, the cycloalkylene group, the alkenylene group, the divalent aliphatic heterocyclic group, the divalent aromatic heterocyclic group, and the divalent aromatic hydrocarbon ring group may have a substituent. The substituent is, for example, a halogen atom (preferably a fluorine atom).

Among these, the divalent linking group represented by $L_{B1}$ to $L_{B3}$ is preferably -CO-, - NR-, -O-, -S-, -SO-, $-SO_2-$, an alkylene group that may have a substituent, and a divalent linking group provided by combining a plurality of these.

In particular, the divalent linking group represented by $L_{B1}$ to $L_{B3}$ is more preferably a divalent linking group represented by Formula (L3-1).

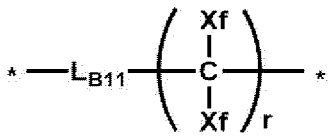

(L3-1)

In Formula (L3-1), $L_{B11}$ represents a single bond or a divalent linking group.

Examples of the divalent linking group represented by $L_{B11}$ include, but are not particularly limited to, -CO-, -O-, -SO-, $-SO_2-$, an alkylene group that may have a substituent (which preferably has 1 to 6 carbon atoms and may be linear or branched), and a divalent linking group provided by combining a plurality of these. The substituent is not particularly limited, and may be, for example, a halogen atom.

r represents an integer of 1 to 3.

Xf s have the same definition and preferred embodiments as in the above-described Xf s in Formula (L2).

**[0998]** * represents a bonding site.

Examples of the divalent linking group represented by $L_{B1}$ to $L_{B3}$ include *-O-*, $*-O-SO_2-CF_2-*$, $*-O-SO_2-CF_2-CF_2-*$, $*-O-SO_2-CF_2-CF_2-CF_2-*$, and $*-COO-CH_2-CH_2-*$.

When $L_{41}$ in Formula (Ia-4) includes a divalent linking group represented by Formula (L3-1) and the divalent linking group represented by Formula (L3-1) is bonded to $A_{42}^-$, the direct bond (*) on the carbon-atom-side clearly shown in Formula (L3-1) is preferably bonded to $A_{42}^-$ in Formula (Ia-4).

When $L_{41}$ in Formula (Ia-4) includes a divalent linking group represented by Formula (L3-1) and the divalent linking group represented by (L3-1) is bonded to $A_{41a}^-$ and $A_{41b}^-$, the direct bond (*) on the carbon-atom-side clearly shown in Formula (L3-1) is also preferably bonded to $A_{41a}^-$ and $A_{41b}^-$ in Formula (Ia-4).

Next, Formula (Ia-5) will be described.

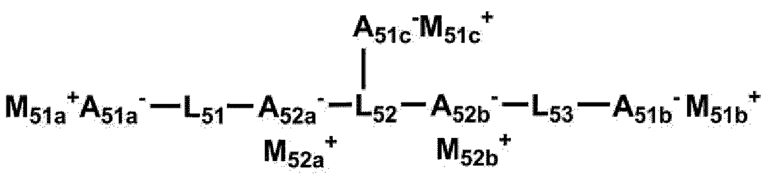

(Ia-5)

In Formula (Ia-5), $A_{51a}^-$, $A_{51b}^-$, and $A_{51c}^-$ each independently represent a monovalent anionic functional group. Here, the monovalent anionic functional groups represented by $A_{51a}^-$, $A_{51b}^-$, and $A_{51c}^-$ each mean a monovalent group including the above-described anionic moiety $A_1^-$. The monovalent anionic functional groups represented by $A_{51a}^-$, $A_{51b}^-$, and $A_{51c}^-$ are not particularly limited, but each may be, for example, a monovalent anionic functional group selected from the group consisting of Formulae (AX-1) to (AX-3) above.

$A_{52a}^-$ and $A_{52b}^-$ represent a divalent anionic functional group. Here, the divalent anionic functional groups represented by $A_{52a}^-$ and $A_{52b}^-$ each mean a divalent group including the above-described anionic moiety $A_2^-$. The divalent anionic functional group represented by $A_{52a}^-$ and $A_{52b}^-$ may be, for example, a divalent anionic functional group selected from the group consisting of Formulae (BX-8) to (BX-11) above.

$M_{51a}^+$, $M_{51b}^+$, $M_{51c}^+$, $M_{52a}^+$, and $M_{52b}^+$ each independently represent an organic cation. The organic cations represented by $M_{51a}^+$, $M_{51b}^+$, $M_{51c}^+$, $M_{52a}^+$, and $M_{52b}^+$ have the same definitions and preferred embodiments as in $M_1^+$ described above.

$L_{51}$ and $L_{53}$ each independently represent a divalent organic group. The divalent organic groups represented by $L_{51}$ and $L_{53}$ have the same definitions and preferred embodiments as in the above-described $L_{21}$ and $L_{22}$ in Formula

(Ia-2). When $L_{51}$ in Formula (Ia-5) represents a divalent organic group represented by Formula (L2), the direct bond (*) on the $L_A$-side in Formula (L2) is also preferably bonded to $A_{52a}^-$ in Formula (Ia-5). When $L_{53}$ in Formula (Ia-5) represents a divalent organic group represented by Formula (L2), the direct bond (*) on the $L_A$-side in Formula (L2) is also preferably bonded to $A_{52b}^-$ in Formula (Ia-5).

$L_{52}$ represents a trivalent organic group. The trivalent organic group represented by $L_{52}$ has the same definition and preferred embodiments as in the above-described $L_{41}$ in Formula (Ia-4). When $L_{52}$ in Formula (Ia-5) includes a divalent linking group represented by Formula (L3-1) and the divalent linking group represented by (L3-1) is bonded to $A_{51c}^-$, the direct bond (*) on the carbon-atom-side clearly shown in Formula (L3-1) is also preferably bonded to $A_{51c}^-$ in Formula (Ia-5).

In a compound PIa-5 in which, in Formula (Ia-5) above, the organic cations represented by $M_{51a}^+$, $M_{51b}^+$, $M_{51c}^+$, $M_{52a}^+$, and $M_{52b}^+$ are replaced by $H^+$, the acid dissociation constant a2-1 derived from the acidic moiety represented by $A_{52a}H$ and the acid dissociation constant a2-2 derived from the acidic moiety represented by $A_{52b}H$ are larger than the acid dissociation constant a1-1 derived from $A_{51a}H$, the acid dissociation constant a1-2 derived from the acidic moiety represented by $A_{51b}H$, and the acid dissociation constant a1-3 derived from the acidic moiety represented by $A_{51c}H$. Note that the acid dissociation constants a1-1 to a1-3 correspond to the above-described acid dissociation constant a1, and the acid dissociation constants a2-1 and a2-2 correspond to the above-described acid dissociation constant a2.

$A_{51a}^-$, $A_{51b}^-$, and $A_{51c}^-$ may be the same or different. $A_{52a}^-$ and $A_{52b}^-$ may be the same or different. $M_{51a}^+$, $M_{51b}^+$, $M_{51c}^+$, $M_{52a}^+$, and $M_{52b}^+$ may be the same or different.

At least one of $M_{51b}^+$, $M_{51c}^+$, $M_{52a}^+$, $M_{52b}^+$, $A_{51a}^-$, $A_{51b}^-$, $A_{51c}^-$, $L_{51}$, $L_{52}$, or $L_{53}$ may have an acid-decomposable group as a substituent.

Compound (II)

The compound (II) is a compound having two or more moieties X described above and one or more moieties Z described below and is a compound that generates an acid including two or more first acidic moieties derived from the moiety X and the moiety Z upon irradiation with an actinic ray or a radiation.

Moiety Z: nonionic moiety that can neutralize acid

In the compound (II), the moiety X, $A_1^-$, and $M_1^+$ have the same definitions and preferred embodiments as in the above-described moiety X, $A_1^-$, and $M_1^+$, respectively, in the compound (I).

In a compound PII in which, in the compound (II), the cationic moiety $M_1^+$ in the moiety X is replaced by $H^+$, the acid dissociation constant a1 derived from the acidic moiety represented by $HA_1$ in which the cationic moiety $M_1^+$ in the moiety X is replaced by $H^+$ has the same preferred range as in the acid dissociation constant a1 in the compound PI.

When the compound (II) is, for example, a compound that generates an acid having two first acidic moieties derived from the moiety X and the moiety Z, the compound PII corresponds to a "compound having two $HA_1$". When the acid dissociation constant of this compound PII is determined, the acid dissociation constant determined when the compound PII is turned into a "compound having a single $A_1^-$ and a single $HA_1$" and the acid dissociation constant determined when the "compound having a single $A_1^-$ and a single $HA_1$" is turned into a "compound having two $A_1^-$" correspond to the acid dissociation constant a1.

The acid dissociation constant a1 can be determined by the method of measuring an acid dissociation constant described above.

The compound PII corresponds to an acid generated when the compound (II) is irradiated with an actinic ray or a radiation.

The two or more moieties X may be the same or different. The two or more $A_1^-$ and the two or more $M_1^+$ may be individually the same or different.

The nonionic moiety that can neutralize acid in the moiety Z is not particularly limited, and is preferably, for example, a moiety including a group that can electrostatically interact with a proton or a functional group having an electron.

The group that can electrostatically interact with a proton or the functional group having an electron may be, for example, a functional group having a macrocyclic structure such as a cyclic polyether or a functional group having a nitrogen atom having an unshared electron pair that does not contribute to π conjugation. Examples of the nitrogen atom having an unshared electron pair that does not contribute to π conjugation include nitrogen atoms having moieties represented by formulae below.

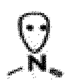
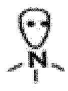
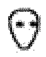

Unshared electron pair

Examples of the moiety of the group that can electrostatically interact with a proton or the functional group having an electron include a crown ether moiety, an azacrown ether moiety, primary to tertiary amine moieties, a pyridine moiety, an imidazole moiety, and a pyrazine moiety. Of these, primary to tertiary amine moieties are preferred.

The compound (II) is not particularly limited, and examples thereof include compounds represented by Formula (IIa-1) and Formula (IIa-2) below.

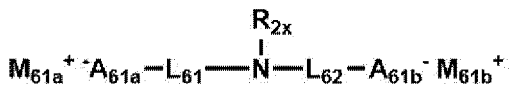

(IIa-1)

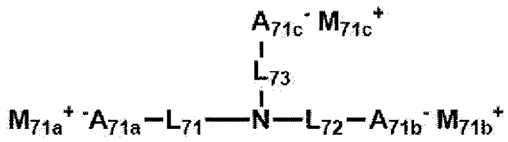

(IIa-2)

In Formula (IIa-1) above, $A_{61a}^-$ and $A_{61b}^-$ have the same definitions and preferred embodiments as in the above-described $A_{11}^-$ in Formula (Ia-1). $M_{61a}^+$ and $M_{61b}^+$ have the same definitions and preferred embodiments as in the above-described $M_{11}^+$ in Formula (Ia-1).

In Formula (IIa-1) above, $L_{61}$ and $L_{62}$ have the same definitions and preferred embodiments as in the above-described $L_1$ in Formula (Ia-1).

When $L_{61}$ in Formula (IIa-1) represents a divalent linking group represented by Formula (L1), the direct bond (*) on the $L_{111}$-side in Formula (L1) is preferably bonded to the nitrogen atom clearly shown in Formula (IIa-1). When $L_{62}$ in Formula (IIa-1) represents a divalent linking group represented by Formula (L1), the direct bond (*) on the $L_{111}$-side in Formula (L1) is preferably bonded to the nitrogen atom clearly shown in Formula (IIa-1).

In Formula (IIa-1), $R_{2X}$ represents a monovalent organic group. The monovalent organic group represented by $R_{2X}$ is not particularly limited, and may be, for example, an alkyl group (which preferably has 1 to 10 carbon atoms and may be linear or branched), a cycloalkyl group (preferably having 3 to 15 carbon atoms), or an alkenyl group (preferably having 2 to 6 carbon atoms), in which $-CH_2-$ may be substituted with one or a combination of two or more selected from the group consisting of -CO-, -NH-, -O-, -S-, -SO-, and $-SO_2-$.

The alkylene group, the cycloalkylene group, and the alkenylene group may have a substituent. The substituent is not particularly limited, but is, for example, a halogen atom (preferably a fluorine atom).

In a compound PIIa-1 in which, in Formula (IIa-1) above, the organic cations represented by $M_{61a}^+$ and $M_{61b}^+$ are replaced by $H^+$, the acid dissociation constant a1-7 derived from the acidic moiety represented by $A_{61a}H$ and the acid dissociation constant a1-8 derived from the acidic moiety represented by $A_{61b}H$ correspond to the above-described acid dissociation constant a1.

The compound PIIa-1 in which, in the compound (IIa-1), the cationic moieties $M_{61a}^+$ and $M_{61b}^+$ in the moiety X are replaced by $H^+$ corresponds to $HA_{61a}$-$L_{61}$-$N(R_{2X})$-$L_{62}$-$A_{61b}H$. The compound PIIa-1 is the same as the acid generated from the compound represented by Formula (IIa-1) upon irradiation with an actinic ray or a radiation.

At least one of $M_{61a}^+$, $M_{61b}^+$, $A_{61a}^-$, $A_{61b}^-$, $L_{61}$, $L_{62}$, or $R_{2X}$ may have an acid-decomposable group as a substituent.

In Formula (IIa-2) above, $A_{71a}^-$, $A_{71b}^-$, and $A_{71c}^-$ have the same definitions and preferred embodiments as in the above-described $A_{11}^-$ in Formula (Ia-1). $M_{71a}^+$, $M_{71b}^+$, and $M_{71c}$ have the same definitions and preferred embodiments as in the above-described $M_{11}^+$ in Formula (Ia-1).

In Formula (IIa-2) above, $L_{71}$, $L_{72}$, and $L_{73}$ have the same definitions and preferred embodiments as in the above-described $L_1$ in Formula (Ia-1).

When $L_{71}$ in Formula (IIa-2) represents a divalent linking group represented by Formula (L1), the direct bond (*) on the $L_{111}$-side in Formula (L1) is preferably bonded to the nitrogen atom clearly shown in Formula (IIa-2). When $L_{72}$ in Formula (IIa-2) represents a divalent linking group represented by Formula (L1), the direct bond (*) on the $L_{111}$-side in Formula (L1) is preferably bonded to the nitrogen atom clearly shown in Formula (IIa-2). When $L_{73}$ in Formula (IIa-2) represents a divalent linking group represented by Formula (L1), the direct bond (*) on the $L_{111}$-side in Formula (L1) is preferably bonded to the nitrogen atom clearly shown in Formula (IIa-2).

In a compound PIIa-2 in which, in Formula (IIa-2) above, the organic cations represented by $M_{71a}^+$, $M_{71b}^+$, and $M_{71c}^+$ are replaced by $H^+$, the acid dissociation constant a1-9 derived from the acidic moiety represented by $A_{71a}H$, the

acid dissociation constant a1-10 derived from the acidic moiety represented by $A_{71b}H$, and the acid dissociation constant a1-11 derived from the acidic moiety represented by $A_{71c}H$ correspond to the above-described acid dissociation constant a1.

The compound PIIa-2 in which, in the compound (IIa-2), the cationic moieties $M_{71a}^+$, $M_{71b}^+$, and $M_{71c}^+$ in the moieties X are replaced by $H^+$ corresponds to $HA_{71a}$-$L_{71}$-N($L_{73}$-$A_{71c}$H)-$L_{72}$-$A_{71b}$H. The compound PIIa-2 is the same as the acid generated from the compound represented by Formula (IIa-2) upon irradiation with an actinic ray or a radiation.

At least one of $M_{71a}^+$, $M_{71b}^+$, $M_{71c}^+$, $A_{71a}^-$, $A_{71b}^-$, $A_{71c}^-$, $L_{71}$, $L_{72}$, or $L_{73}$ may have an acid-decomposable group as a substituent.

The molecular weight of the photoacid generator PG1 is preferably 100 to 10,000, more preferably 100 to 2,500, still more preferably 100 to 1,500.

Other Photoacid Generators

Another preferred embodiment of the photoacid generator may be a photoacid generator (hereinafter, also referred to as "photoacid generator PG2") other than the above-described photoacid generator PG1.

The photoacid generator PG2 may be, for example, a compound represented by "$M^+$ $X^-$" (onium salt compound) and is preferably a compound that generates an organic acid due to exposure.

Examples of the organic acid include sulfonic acids (such as aliphatic sulfonic acids, aromatic sulfonic acids, and camphorsulfonic acid), carboxylic acids (such as aliphatic carboxylic acids, aromatic carboxylic acids, and aralkyl carboxylic acids), carbonylsulfonylimidic acid, bis(alkylsulfonyl)imidic acids, and tris(alkylsulfonyl)methide acids.

In the compound represented by "$M^+$ $X^-$", $M^+$ represents an organic cation.

The organic cation is, for example, the same as the organic cation represented by $M_A^+$ in the group represented by Formula (O1) described as an onium salt group, which is one form of the polarity-decreasing group, in the above Polarity-Decreasing Group, Interactive Group, and Polar Group. Specifically, a cation represented by Formula (ZaI) (cation (ZaI)) or a cation represented by Formula (ZaII) (cation (ZaII)) is preferred.

In the compound represented by "$M^+$ $X^-$", $X^-$ represents an organic anion.

The organic anion is, for example, the same as the organic cation represented by $X_B^-$ in the group represented by Formula (O2) described as an onium salt group, which is one form of the polarity-decreasing group, in the above Polarity-Decreasing Group, Interactive Group, and Polar Group.

It is also preferable to use, as the photoacid generator PG2, for example, photoacid generators disclosed in paragraphs [0135] to [0171] of WO2018/193954A, paragraphs [0077] to [0116] of WO2020/066824A, and paragraphs [0018] to [0075] and [0334] and [0335] of WO2017/154345A.

The molecular weight of the photoacid generator PG2 is preferably 3,000 or less, more preferably 2,000 or less, still more preferably 1,000 or less.

When the resist composition includes a photoacid generator, the content thereof is not particularly limited, but is preferably 0.5 mass% or more, more preferably 1.0 mass% or more, still more preferably 5.0 mass% or more relative to the total solid content of the composition. The content is preferably 40.0 mass% or less, more preferably 30.0 mass% or less.

Such photoacid generators may be used alone or in combination of two or more thereof. When two or more photoacid generators are used, the total content thereof is preferably within the above preferred content range.

Acid Diffusion Control Agent

The resist composition may include an acid diffusion control agent.

The acid diffusion control agent serves as a quencher that traps acid generated from the photoacid generator or the like upon exposure and that suppresses a reaction of the resin X1 in an unexposed region due to an excess of the generated acid. Examples of the acid diffusion control agent that can be used include a basic compound (CA), a basic compound (CB) that undergoes a decrease or loss of the basicity upon irradiation with an actinic ray or a radiation, a low-molecular-weight compound (CD) having a nitrogen atom and having a group that leaves due to action of acid, and an onium salt compound (CE) having a nitrogen atom in a cationic moiety. In the resist composition, publicly known acid diffusion control agents can be appropriately used. For example, the publicly known compounds disclosed in paragraphs [0627] to [0664] of US2016/0070167A1, paragraphs [0095] to [0187] of US2015/0004544A1, paragraphs [0403] to [0423] of US2016/0237190A1, and paragraphs [0259] to [0328] of US2016/0274458A1 can be suitably used as acid diffusion control agents.

Specific examples of the basic compound (CA) include those described in paragraphs [0132] to [0136] of WO2020/066824A. Specific examples of the basic compound (CB) that undergoes a decrease or loss of the basicity upon irradiation with an actinic ray or a radiation include those described in paragraphs [0137] to [0155] of WO2020/066824A. Specific examples of the low-molecular-weight compound (CD) having a nitrogen atom and having

a group that leaves due to action of acid include those described in paragraphs [0156] to [0163] of WO2020/066824A. Specific examples of the onium salt compound (CE) having a nitrogen atom in a cationic moiety include those described in paragraph [0164] of WO2020/066824A.

An onium salt compound that serves as a weak acid relative to a photoacid-generating component can also be used as the acid diffusion control agent.

In the case where a photoacid generator (photoacid generator PG1 and photoacid generator PG2 are also collectively referred to as a photoacid-generating component) is used in combination with an onium salt compound that generates an acid weaker than the acid generated from the photoacid-generating component, upon collision between the acid generated from the photoacid-generating component upon irradiation with an actinic ray or a radiation and the onium salt compound having an unreacted weak-acid anion, the weak acid is released by salt exchange to generate an onium salt compound having a strong-acid anion. In this process, since the strong acid is exchanged with the weak acid having a lower catalytic ability, the acid is apparently deactivated and acid diffusion can be controlled.

The onium salt compound that serves as a weak acid relative to a photoacid-generating component is preferably a compound represented by any of Formulae (d1-1) to (d1-3) below.

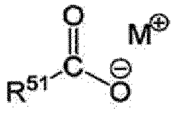
(d1-1)

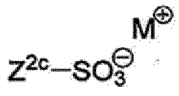
(d1-2)

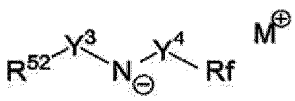
(d1-3)

In the formula, $R^{51}$ is an organic group. The number of carbon atoms is preferably 1 to 30.

$Z^{2c}$ is an organic group. The number of carbon atoms of the organic group is preferably 1 to 30. However, in the organic group represented by $Z^{2c}$, when a carbon atom is adjacent to $SO^{3-}$ clearly shown in the formula, this carbon atom ($\alpha$-carbon atom) does not have a fluorine atom and/or a perfluoroalkyl group as a substituent. The $\alpha$-carbon atom is other than a ring member atom of a ring structure, and is preferably a methylene group. In $Z^{2c}$, when the atom at the $\beta$-position with respect to $SO_3^-$ is a carbon atom ($\beta$-carbon atom), the $\beta$-carbon atom also does not have a fluorine atom and/or a perfluoroalkyl group as a substituent.

$R^{52}$ is an organic group (such as an alkyl group), $Y^3$ is $-SO_2-$, a linear, branched, or cyclic alkylene group, or an arylene group, $Y^4$ is -CO- or $-SO_2-$, and Rf is a hydrocarbon group having a fluorine atom (such as a fluoroalkyl group).

Each $M^+$ is independently an ammonium cation, a sulfonium cation, or an iodonium cation. $M^+$ in Formulae (d1-1) to (d1-3) is, for example, the same as the organic cation represented by $M_A^+$ in the group represented by Formula (O1) described as an onium salt group, which is one form of the polarity-decreasing group, in the above Polarity-Decreasing Group, Interactive Group, and Polar Group.

In one embodiment, these cations also preferably have an acid-decomposable group.

A zwitterion may be used as the acid diffusion control agent. The acid diffusion control agent which is a zwitterion preferably has a carboxylate anion, and also preferably has a sulfonium cation or an iodonium cation.

When the resist composition includes an acid diffusion control agent, the content of the acid diffusion control agent (the total content in the case where a plurality of acid diffusion control agents are present) is preferably 0.1 mass% or more, more preferably 1.0 mass% or more relative to the total solid content of the composition. The upper limit value is not particularly limited, but is preferably 30.0 mass% or less, more preferably 20.0 mass% or less, still more preferably 10.0 mass% or less.

In the resist composition, such acid diffusion control agents may be used alone or in combination of two or more thereof.

Capping Agent

For example, when the resist composition includes a resin corresponding to Embodiment 3 described as one embodiment of the resin X1, the resist composition preferably includes a compound that reacts with the polar group in the resin X1 due to action of exposure, acid, base, or heating (capping agent). The polarity of the polar group in the resin X1 decreases due to reaction with the capping agent.

The capping agent may be a compound that itself can bind to the polar group in the resin X1 due to action of exposure, acid, base, or heat, or may be a compound that undergoes a change in structure due to action of exposure, acid, base, or heating and can bind to the polar group in the resin X1 after the structural change.

The capping agent is preferably a compound having a functional group that reacts with the polar group in the resin X1, such as an alcoholic hydroxy group, a phenolic hydroxy group, or a carboxyl group.

The reaction mechanism between the capping agent and the polar group is not particularly limited as long as the reaction proceeds by the action of exposure, acid, base, or heating.

The compound that can react with a polar group such as an alcoholic hydroxy group, a phenolic hydroxy group, or a carboxyl group may be, for example, a tertiary alcohol, a tertiary ether, an epoxide, a vinyl ether, an olefin, a benzyl ether, benzyl alcohol, and a carboxylic acid.

Regarding an example of an embodiment of specific combinations of the polar group and the capping agent, for example, when the polar group is an alcoholic hydroxy group or a carboxyl group, an epoxide or the like is preferred, and when the polar group is a phenolic hydroxy group, a tertiary alcohol, a tertiary ether epoxide, a vinyl ether, or a benzyl ether is preferred.

The tertiary alcohol is preferably a compound represented by $C(R^1)(R^2)(R^3)OH$.

$R^1$ to $R^3$ each independently represent a monovalent organic group.

The monovalent organic group is not particularly limited, but is preferably an alkyl group (linear or branched), a cycloalkyl group (monocyclic or polycyclic), an alkenyl group (linear or branched), or an aryl group (monocyclic or polycyclic) in view of a better hydrophobization property after capping. The alkyl group, the cycloalkyl group, the alkenyl group, and the aryl group may further have a substituent. The substituent is, for example, a fluorine atom, an iodine atom, an alkyl group, a cycloalkyl group, an alkenyl group, or an aryl group.

The alkyl group may be linear or branched, and is preferably an alkyl group having 1 to 20 carbon atoms, more preferably an alkyl group having 1 to 15 carbon atoms, still more preferably an alkyl group having 1 to 10 carbon atoms.

The alkyl group may have, as a substituent, a fluorine atom, an iodine atom, a cycloalkyl group, an alkenyl group, an aryl group, or the like. Specific examples of the cycloalkyl group, the alkenyl group, and the aryl group serving as the substituent that the alkyl group may have include the same cycloalkyl group, alkenyl group, and aryl group as those represented by $R^1$ to R3.

The cycloalkyl group is preferably a cycloalkyl group having 3 to 20 carbon atoms, more preferably a cycloalkyl group having 3 to 15 carbon atoms, still more preferably a cycloalkyl group having 3 to 10 carbon atoms.

The cycloalkyl group may have, as a substituent, a fluorine atom, an iodine atom, an alkyl group, an alkenyl group, an aryl group, or the like. Specific examples of the alkyl group, the alkenyl group, and the aryl group serving as the substituent that the cycloalkyl group may have include the same alkyl group, alkenyl group, and aryl group as those represented by $R^1$ to R3.

The alkenyl group may be linear or branched and is preferably an alkenyl group having 2 to 20 carbon atoms, more preferably an alkenyl group having 2 to 15 carbon atoms, still more preferably an alkenyl group having 2 to 10 carbon atoms.

The alkenyl group may have, as a substituent, a fluorine atom, an iodine atom, an alkyl group, a cycloalkyl group, an aryl group, or the like. Specific examples of the alkyl group, the cycloalkyl group, and the aryl group serving as the substituent that the alkenyl group may have include the same alkyl group, cycloalkyl group, and aryl group as those represented by $R^1$ to $R^3$.

The aryl group may be monocyclic or polycyclic, and is preferably an aryl group having 6 to 20 carbon atoms, more preferably an aryl group having 6 to 15 carbon atoms, still more preferably an aryl group having 6 to 10 carbon atoms.

The aryl group may have, as a substituent, a fluorine atom, an iodine atom, an alkyl group, a cycloalkyl group, an alkenyl group, or the like. Specific examples of the alkyl group, the cycloalkyl group, and the alkenyl group serving as the substituent that the aryl group may have include the same alkyl group, cycloalkyl group, and alkenyl group as those represented by $R^1$ to R3.

The tertiary ether is preferably a compound represented by $C(R^4)(R^5)(R^6)\text{-}O\text{-}R^7$. $R^4$ to $R^7$ each independently represent a monovalent organic group.

Examples of the monovalent organic group represented by $R^4$ to $R^7$ include, but are not particularly limited to, those specifically described as the groups $R^1$ to $R^3$ of the tertiary alcohol.

The epoxide is preferably a compound represented by $R^8$-X.

$R^8$ represents a monovalent organic group.

Examples of the monovalent organic group represented by $R^8$ include, but are not particularly limited to, those specifically described as the groups $R^1$ to $R^3$ of the tertiary alcohol.

X represents an oxiranyl group.

The vinyl ether is a compound represented by $CH_2CH\text{-}O\text{-}CHCH_2$. A hydrogen atom in the vinyl ether may be substituted with a fluorine atom or an iodine atom.

The olefin is not particularly limited, and may be, for example, an unsaturated hydrocarbon compound having 2 to 10 carbon atoms, and specific examples thereof include ethylene, propylene, butylene, butadiene, and pentene. A hydrogen atom in the olefin may have a substituent. The substituent may be, for example, a fluorine atom, an iodine atom, an alkyl group, a cycloalkyl group, an alkenyl group, or an aryl group. Specific examples of the alkyl group, the cycloalkyl group, the alkenyl group, and the aryl group serving as the substituent that the olefin may have include the same alkyl group, cycloalkyl group, alkenyl group, and aryl group as those represented by $R^1$ to $R^3$.

The benzyl ether is preferably a compound represented by $R^8\text{-}O\text{-}CH_2\text{-}ph$. ph represents a phenyl group that may have a substituent (such as an alkyl group having 1 to 4 carbon atoms, a hydroxy group, or an alkoxy group having

1 to 4 carbon atoms).

$R^8$ represents a monovalent organic group.

Examples of the monovalent organic group represented by $R^8$ include, but are not particularly limited to, those specifically described as the groups $R^1$ to $R^3$ of the tertiary alcohol.

One form of the benzyl ether may be a compound having a benzyl ether group as a substituent.

The benzyl ether group is preferably a group formed by removing one of hydrogen atoms on a ring member atom of ph of the compound represented by $R^8$-O-$CH_2$-ph.

The compound having a benzyl ether group as a substituent may be, for example, a compound in which a benzyl ether group is substituted on a polycyclic aromatic ring (such as a 9H-fluorene ring).

Benzyl alcohol is represented by ph-$CH_2$-OH. ph represents a phenyl group.

The carboxylic acid is preferably a compound represented by $R^9$-COOH.

$R^9$ represents a monovalent organic group.

Examples of the monovalent organic group represented by $R^9$ include, but are not particularly limited to, those specifically described as the groups $R^1$ to $R^3$ of the tertiary alcohol.

Whether or not the polarity of the polar group in the resin X1 has decreased after capping with the capping agent can be determined by determining logP (octanol/water partition coefficient) based on the chemical structures of the polar group before and after being subjected to action of exposure, acid, base, or heating, and determining whether or not there is an increase in logP after reaction with the capping agent. The logP can be calculated using, for example, ChemBioDraw Ultra (Version16.0.14).

When the resist composition includes a capping agent, the content of the capping agent (total content in the case where a plurality of capping agents are present) is preferably 5 mass% or more, more preferably 10 mass% or more relative to the total solid content of the composition. The upper limit value is not particularly limited, but is preferably 80 mass% or less, more preferably 60 mass% or less, still more preferably 40 mass% or less.

In the resist composition, such capping agents may be used alone or in combination of two or more thereof.

Crosslinking Agent (Compound Including Reactive Group B That Reacts with Reactive Group A)

The crosslinking agent may be a low-molecular-weight compound or a high-molecular-weight compound. Note that the low-molecular-weight compound means a compound having a molecular weight of 2,000 or less, and the high-molecular-weight compound means a compound having a molecular weight of more than 2,000.

Note that, when the molecular weight of the crosslinking agent is polydisperse, whether the crosslinking agent is a low-molecular-weight compound or a high-molecular-weight compound is determined depending on whether the weight-average molecular weight is 2,000 or less or more than 2,000.

The crosslinking agent may be a polymer including a predetermined repeating unit.

The type of the reactive group B included in the crosslinking agent is not particularly limited as long as it is a group that reacts with the reactive group A. Examples thereof include the above-described groups, specifically, a hydroxy group, an isocyanate group, a carboxylic group, an epoxy group, a carboxylic anhydride group, an amino group, a vinyl ether group, a sulfonic group, and a group represented by General formula (A) above.

The number of reactive groups in the crosslinking agent is not particularly limited, but is usually 2 or more, preferably 2 to 8, more preferably 2 to 4 from the viewpoint of reactivity.

A preferred embodiment of the crosslinking agent is, for example, a compound represented by General formula (E).

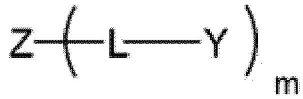

General formula (E)

In General formula (E), Y represents a reactive group B. L represents a single bond or a divalent linking group.

The structure of the divalent linking group represented by L is not particularly limited, but may be, for example, a divalent hydrocarbon group (which may be a divalent saturated hydrocarbon group, a divalent aromatic hydrocarbon group, or a combination thereof, where the divalent saturated hydrocarbon group may be linear, branched, or cyclic, preferably has 1 to 20 carbon atoms, and may be, for example, an alkylene group, and the divalent aromatic hydrocarbon group preferably has 5 to 20 carbon atoms, and may be, for example, a phenylene group, or which may be an alkenylene group or an alkynylene group), a divalent heterocyclic group, -O-, -S-, -$SO_2$-, -$NR_c$-, -CO-, -COO-, -$SO_3$-, or a group provided by combining two or more of these. $R_c$ represents a hydrogen atom or an alkyl group (preferably having 1 to 10 carbon atoms).

Z represents an m-valent linking group. Examples of the m-valent linking group include a carbon atom, a silicon

atom, an oxygen atom, a nitrogen atom, an m-valent aliphatic hydrocarbon group, an m-valent aromatic hydrocarbon group, and an m-valent heterocyclic group.

Examples of the m-valent aromatic hydrocarbon group include divalent to hexavalent aromatic hydrocarbon groups, such as a group represented by General formula (L1). In General formula (L1), * represents a bonding site, Y-L-groups are bonded to two to six *'s among six *'s, and a hydrogen atom or an organic group is bonded to the remaining *'s. For example, in the case of a valence of 3, Y-L-groups are bonded to three *'s, and a hydrogen atom or an organic group is bonded to each of the remaining three *'s. The type of the organic group is not particularly limited, and the organic group may be a publicly known group (such as an alkyl group).

Examples of the m-valent heterocyclic group include groups represented by General formula (L2) to General formula (L4).

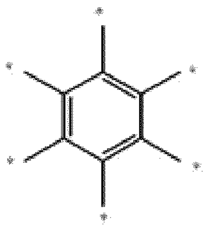
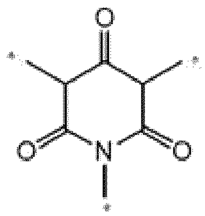
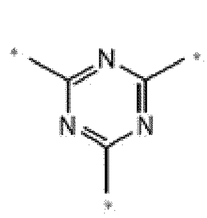
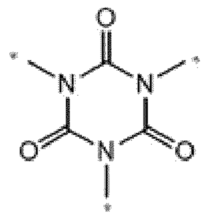

General formula (L1) General formula (L2) General formula (L3) General formula (L4)

When the crosslinking agent is a polymer, the polymer preferably has a repeating unit having the functional group B.

Such crosslinking agents may be used alone or in combination of two or more thereof. The content of the crosslinking agent is preferably 2 to 50 mass%, more preferably 5 to 40 mass% relative to the total solid content of the composition.

The mixing mass ratio of the resin including the reactive group A to the crosslinking agent (mass of resin including reactive group A/mass of crosslinking agent) is not particularly limited, but is preferably 0.1 to 10, more preferably 0.2 to 4 from the viewpoint of providing a better effect of the present invention.

Hydrophobic Resin

The resist composition may further include a hydrophobic resin different from the resin described above.

The hydrophobic resin is preferably designed so as to be localized in the surface of a resist film. However, unlike surfactants, the hydrophobic resin does not necessarily need to have a hydrophilic group in the molecule, and does not necessarily contribute to homogeneous mixing of a polar substance and a nonpolar substance.

Advantages due to the addition of the hydrophobic resin are, for example, the control of static and dynamic contact angles at the surface of the resist film for water, and the suppression of outgassing.

From the viewpoint of localization in the surface layer of the film, the hydrophobic resin preferably has one or more, more preferably two or more selected from the group consisting of a fluorine atom, a silicon atom, and a $CH_3$ moiety included in a side chain moiety of the resin. The hydrophobic resin preferably has a hydrocarbon group having 5 or more carbon atoms. The resin may have such a group in the main chain or, as a substituent, in a side chain.

Examples of the hydrophobic resin include compounds described in paragraphs [0275] to [0279] of WO2020/004306A.

When the resist composition includes a hydrophobic resin, the content of the hydrophobic resin is preferably 0.01 to 20 mass%, more preferably 0.1 to 15 mass% relative to the total solid content of the resist composition.

Surfactant

The resist composition may include a surfactant. The resist composition including a surfactant enables the formation of a pattern having higher adhesiveness and less development defects.

The surfactant is preferably a fluorine-based and/or silicon-based surfactant.

Examples of the fluorine-based and/or silicon-based surfactant include surfactants disclosed in paragraphs [0218] and [0219] of WO2018/193954A.

Such surfactants may be used alone or in combination of two or more thereof.

When the resist composition includes a surfactant, the content of the surfactant is preferably 0.0001 to 2 mass%, more preferably 0.0005 to 1 mass% relative to the total solid content of the resist composition.

Solvent

The resist composition may include a solvent.

The solvent preferably includes at least one of (M1) a propylene glycol monoalkyl ether carboxylate or (M2) at least one selected from the group consisting of a propylene glycol monoalkyl ether, a lactate, an acetate, an alkoxypropionate, a chain ketone, a cyclic ketone, a lactone, and an alkylene carbonate. The solvent may further include a component other than the components (M1) and (M2).

The inventors of the present invention have found that, in the case of using such a solvent and the above-described resin in combination, coatability of the resulting composition is improved, and a pattern having a smaller number of development defects can be formed. The reason for this is not necessarily clear; however, the inventors of the present invention consider that this is due to the fact that such solvents are well-balanced in terms of solubility of the resin described above, boiling point, and viscosity, and thus, for example, unevenness of the film thickness of the composition film and the generation of precipitates during spin coating can be suppressed.

Details of the component (M1) and the component (M2) are described in paragraphs [0218] to [0226] of WO2020/004306A.

When the solvent further includes a component other than the components (M1) and (M2), the content of the component other than the components (M1) and (M2) is preferably 5 to 30 mass% relative to the total amount of the solvent.

In the resist composition, the content of the solvent is determined such that the concentration of solid content becomes preferably 0.5 to 30 mass%, more preferably 1 to 20 mass%. In such a case, the resist composition has further improved coatability.

Other Additives

The resist composition may further include a dissolution-inhibiting compound, a dye, a plasticizer, a photosensitizer, a light absorbent, and/or a compound that improves solubility in developers (for example, a phenolic compound having a molecular weight of 1,000 or less or an alicyclic or aliphatic compound including a carboxylic group).

The resist composition may further include a dissolution-inhibiting compound. Herein, the "dissolution-inhibiting compound" refers to a compound that has a molecular weight of 3,000 or less and that is decomposed due to action of acid to undergo a decrease in the degree of solubility in organic-based developers.

The resist composition is suitably used as a photosensitive composition for EUV light.

The EUV light has a wavelength of 13.5 nm, which is shorter than the wavelength of ArF (wavelength 193 nm) light and the like, and thus provides a smaller number of incident photons when exposure is performed with the same sensitivity. Therefore, "photon shot noise", which is stochastic variations in the number of photons, exerts a great influence, resulting in degradation of LER and bridge defects. In order to reduce the photon shot noise, a method of increasing the exposure dose to increase the number of incident photons may be employed; however, this method is a trade-off with the demand for higher sensitivity.

When a value A determined by Expression (1) below is large, a resist film formed from the resist composition has high absorption efficiency for EUV light and electron beams, which is effective to reduce the photon shot noise. The value A represents the absorption efficiency of the resist film for EUV light and electron beams based on mass proportions.

$$A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127) \qquad \text{Expression (1):}$$

The value A is preferably 0.120 or more. The upper limit is not particularly limited; however, if the value A is excessively large, the transmittances of the resist film for EUV light and electron beams decrease, the optical image profile in the resist film deteriorates, and as a result, a good pattern shape is less likely to be obtained. Thus, the value A is preferably 0.240 or less, more preferably 0.220 or less.

In Expression (1), [H] represents the molar ratio of hydrogen atoms derived from the whole solid content in the actinic ray-sensitive or radiation-sensitive resin composition relative to all the atoms of the whole solid content, [C] represents the molar ratio of carbon atoms derived from the whole solid content in the actinic ray-sensitive or radiation-sensitive resin composition relative to all the atoms of the whole solid content, [N] represents the molar ratio of nitrogen atoms derived from the whole solid content in the actinic ray-sensitive or radiation-sensitive resin composition relative to all the atoms of the whole solid content, [O] represents the molar ratio of oxygen atoms derived from the whole solid content in the actinic ray-sensitive or radiation-sensitive resin composition relative to all the atoms of the whole solid content, [F] represents the molar ratio of fluorine atoms derived from the whole solid content in the actinic ray-sensitive or radiation-sensitive resin composition relative to all the atoms of the whole solid content, [S] represents the molar ratio of sulfur atoms derived from the whole solid content in the actinic ray-sensitive or radiation-sensitive resin composition

relative to all the atoms of the whole solid content, and [I] represents the molar ratio of iodine atoms derived from the whole solid content in the actinic ray-sensitive or radiation-sensitive resin composition relative to all the atoms of the whole solid content.

For example, when the resist composition includes a resin X1, a photoacid generator, an acid diffusion control agent, and a solvent, the resin X1, the photoacid generator, and the acid diffusion control agent correspond to the solid content. That is, all the atoms of the whole solid content correspond to the total of all the atoms derived from the resin X1, all the atoms derived from the photoacid generator, and all the atoms derived from the acid diffusion control agent. For example, [H] represents the molar ratio of hydrogen atoms derived from the whole solid content relative to all the atoms of the whole solid content, and, in the description based on the above example, [H] represents the molar ratio of the total of the hydrogen atoms derived from the resin X1, the hydrogen atoms derived from the photoacid generator, and the hydrogen atoms derived from the acid diffusion control agent relative to the total of all the atoms derived from the resin X1, all the atoms derived from the photoacid generator, and all the atoms derived from the acid diffusion control agent.

When the structures and contents of constituent components of the whole solid content in the resist composition are known, the value A can be determined by calculating the ratio of the numbers of atoms contained. Even when the constituent components are not known, for a resist film formed by evaporating the solvent component of the resist composition, the ratio of the numbers of constituent atoms can be calculated by an analytical method such as elemental analysis.

## Method for Producing Electronic Device

The present invention also relates to a method for producing an electronic device, the method including the above-described pattern forming method.

The electronic device is suitably mounted on electric or electronic devices (such as household appliances, OA (Office Automation), media-related devices, optical devices, and communication devices).

## EXAMPLES

Hereinafter, the present invention will be described in more detail with reference to Examples.

Materials, amounts used, ratios, details of processes, and procedures of processes described in the following Examples may be appropriately changed without departing from the spirit and scope of the present invention, and are not construed as being limited to the following Examples. "%" is based on mass, unless otherwise specified.

### Resist Composition

### Resin

Resins A-1 to A-46 will be described below.

The resins A-1 to A-46 were synthesized according to a method of synthesizing the resin A-32 described later or according to a publicly known method. The compositional ratio of repeating units (molar ratio %, corresponding to the order from the left), the weight-average molecular weight (Mw), and the dispersity (Mw/Mn) are shown in Table 1.

The weight-average molecular weight (Mw) and the dispersity (Mw/Mn) of each of the resins A-1 to A-46 are values in terms of polystyrene measured by GPC (carrier: tetrahydrofuran). The compositional ratio (molar ratio %) of the resin was measured by $^{13}C$-NMR (Nuclear Magnetic Resonance).

Table 1 is shown below.

"Presence or absence of polarity-decreasing group" of the remarks column in Table 1 represents the presence or absence of a polarity-decreasing group in the resin. The case where the resin includes a polarity-decreasing group is indicated by "A", and the case where the resin includes no polarity-decreasing group is indicated by "B".

"Presence or absence of interactive group" of the remarks column in Table 1 represents the presence or absence of an interactive group in the resin. The case where the resin includes an interactive group is indicated by "A", and the case where the resin includes no interactive group is indicated by "B". Note that even when the resin has, for example, a phenolic hydroxy group, which corresponds to an interactive group, the case where the resist composition does not include an interactive onium salt compound is denoted by "B".

In "Occurrence or nonoccurrence of decrease in molecular weight" of the remarks column in Table 1, the case where the resin has a repeating unit that undergoes a decrease in molecular weight caused by scission of the main chain due to action of exposure, acid, base, or heating is indicated by "A", and the case where the resin does not have such a repeating unit is denoted by "B".

Table 1

| Table 1 | Repeating units molar ratio % | | | Mw | Mw/Mn | Remarks | | |
|---|---|---|---|---|---|---|---|---|
| | | | | | | Presence or absence of polarity-decreasing group | Presence or absence of interactive group | Occurrence or nonoccurrence of decrease in molecular weight |
| Resin A-1 | 50 | 50 | | 15000 | 1.6 | B | A | A |
| Resin A-2 | 40 | 60 | | 25000 | 1.7 | B | A | A |
| Resin A-3 | 30 | 70 | | 62000 | 1.8 | B | A | A |
| Resin A-4 | 45 | 55 | | 10000 | 1.6 | B | A | A |
| Resin A-5 | 30 | 20 | 50 | 6000 | 1.4 | B | A | A |
| Resin A-6 | 20 | 80 | | 2500 | 1.2 | B | A | A |
| Resin A-7 | 45 | 55 | | 18000 | 1.7 | B | A | A |
| Resin A-8 | 50 | 50 | | 4500 | 1.3 | B | A | A |
| Resin A-9 | 35 | 65 | | 9000 | 1.5 | B | A | A |
| Resin A-10 | 50 | 50 | | 31000 | 1.7 | B | A | A |
| Resin A-11 | 100 | | | 22000 | 1.9 | B | A | A |
| Resin A-12 | 100 | | | 15000 | 1.6 | B | A | A |
| Resin A-13 | 50 | 50 | | 6000 | 1.5 | A | B | A |
| Resin A-14 | 40 | 60 | | 100000 | 2.0 | A | B | A |
| Resin A-15 | 50 | 50 | | 28000 | 1.9 | A | B | A |
| Resin A-16 | 35 | 65 | | 15000 | 1.7 | A | B | A |
| Resin A-17 | 50 | 50 | | 14000 | 1.6 | A | B | A |

(continued)

| Table 1 | Repeating units molar ratio % | | | Mw | Mw/Mn | Remarks | | |
|---|---|---|---|---|---|---|---|---|
| | | | | | | Presence or absence of polarity-decreasing group | Presence or absence of interactive group | Occurrence or nonoccurrence of decrease in molecular weight |
| Resin A-18 | 45 | 55 | | 8500 | 1.5 | A | B | A |
| Resin A-19 | 40 | 60 | | 15000 | 1.6 | A | B | A |
| Resin A-20 | 30 | 70 | | 7000 | 1.4 | A | A | A |
| Resin A-21 | 50 | 50 | | 8000 | 1.5 | A | A | A |
| Resin A-22 | 40 | 30 | 30 | 6000 | 1.4 | B | A | A |
| Resin A-23 | 30 | 30 | 40 | 13000 | 1.6 | A | A | A |
| Resin A-24 | 20 | 20 | 60 | 15000 | 1.6 | A | A | A |
| Resin A-25 | 50 | 50 | | 16000 | 1.6 | A | A | A |
| Resin A-26 | 50 | 50 | | 6000 | 1.5 | A | A | A |
| Resin A-27 | 20 | 30 | 50 | 4000 | 1.3 | A | B | A |
| Resin A-28 | 50 | 50 | | 3000 | 1.4 | A | B | A |
| Resin A-29 | 60 | 40 | | 50000 | 1.9 | A | A | A |
| Resin A-30 | 50 | 50 | | 4800 | 1.5 | A | A | A |
| Resin A-31 | 45 | 55 | | 25000 | 1.8 | A | B | A |
| Resin A-32 | 30 | 70 | | 8000 | 1.6 | A | B | B |
| Resin A-33 | 20 | 80 | | 6500 | 1.5 | A | B | B |
| Resin A-34 | 30 | 30 | 40 | 5500 | 1.4 | A | B | B |

(continued)

| Table 1 | Repeating units molar ratio % | | | Mw | Mw/Mn | Remarks | | |
|---|---|---|---|---|---|---|---|---|
| | | | | | | Presence or absence of polarity-decreasing group | Presence or absence of interactive group | Occurrence or nonoccurrence of decrease in molecular weight |
| Resin A-35 | 50 | 50 | | 6000 | 1.5 | A | A | B |
| Resin A-36 | 60 | 40 | | 8000 | 1.6 | A | A | B |
| Resin A-37 | 20 | 80 | | 12000 | 1.5 | A | B | B |
| Resin A-38 | 80 | 20 | | 10000 | 1.6 | A | B | A |
| Resin A-39 | 50 | 50 | | 35000 | 1.8 | A | B | A |
| Resin A-40 | 50 | 50 | | 20000 | 1.7 | A | A | A |
| Resin A-41 | 50 | 35 | 15 | 15000 | 1.7 | A | A | A |
| Resin A-42 | 30 | 20 | 50 | 6000 | 1.5 | A | A | B |
| Resin A-43 | 50 | 50 | | 30000 | 1.8 | B | B | A |
| Resin A-44 | 50 | 25 | 25 | 4800 | 1.5 | B | A | B |
| Resin A-45 | 100 | | | 3000 | 1.4 | B | A | B |
| Resin A-46 | 50 | 50 | | 25000 | 1.8 | B | A | A |

Synthesis of Resin A-32

In a nitrogen stream, cyclohexanone (194.3 g) was placed in a three-necked flask and heated to 80°C. Subsequently, a solution prepared by dissolving, sequentially from the left, 12.0 g and 40.7 g of monomers corresponding to the repeating units shown in Table 1 and a polymerization initiator V-601 (3.17 g, manufactured by FUJIFILM Wako Pure Chemical Corporation) in cyclohexanone (105 g) was added dropwise over six hours. After completion of the dropwise addition, the resulting reaction solution was further reacted at 80°C for two hours. The obtained reaction solution

was left to cool and then added dropwise to a liquid mixture of methanol and water over 20 minutes. Subsequently, a powder precipitated by the dropwise addition was collected by filtration and dried to obtain the resin A-32 (31.6 g).

The structural formulae of the resins A-1 to A-46 are as follows.

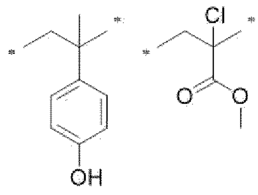
A-1

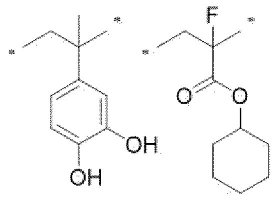
A-2

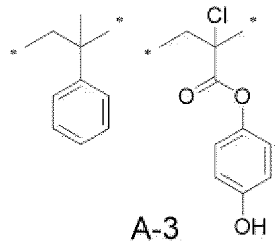
A-3

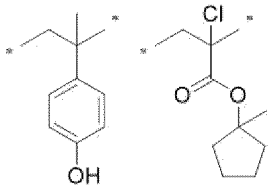
A-4

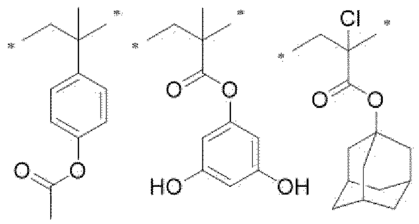
A-5

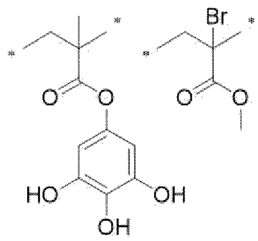
A-6

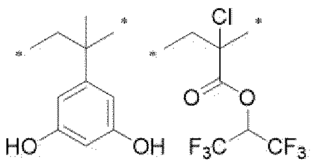
A-7

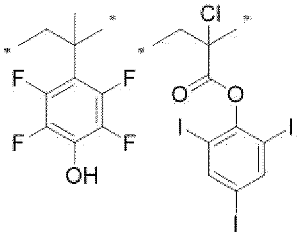
A-8

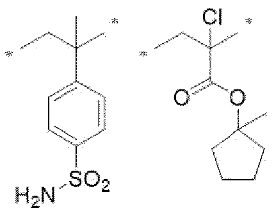
A-9

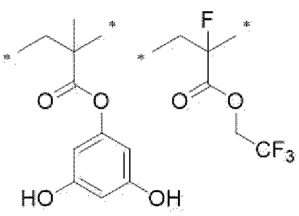
A-10

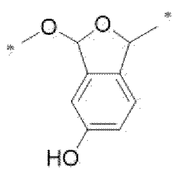
A-11

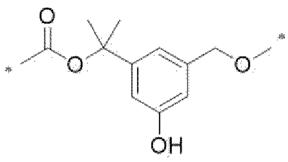
A-12

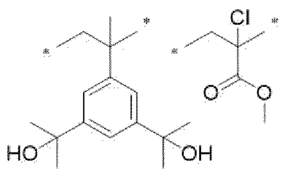
A-13

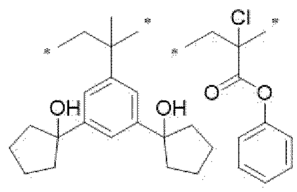
A-14

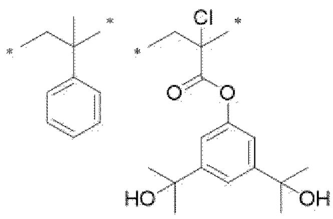
A-15

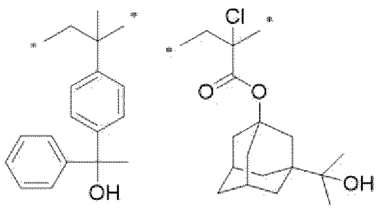

A-16

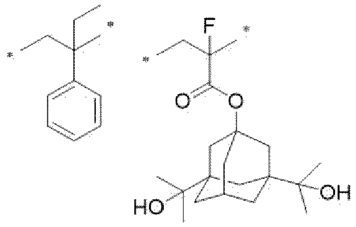

A-17

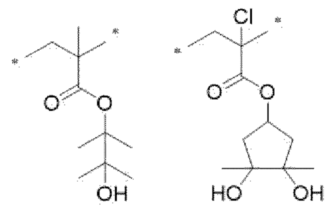

A-18

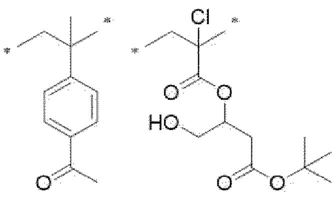

A-19

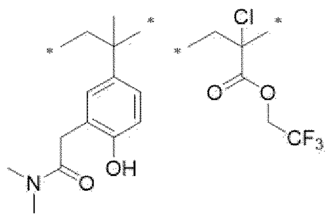

A-20

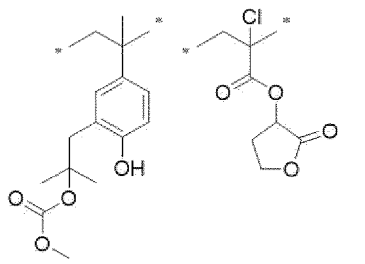

A-21

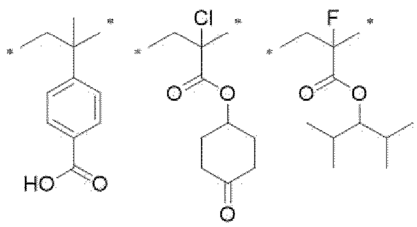

A-22

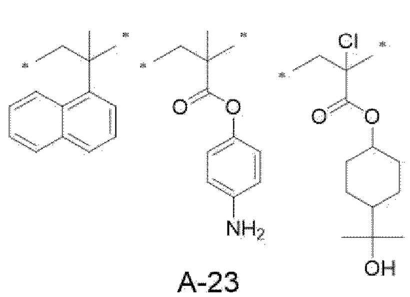

A-23

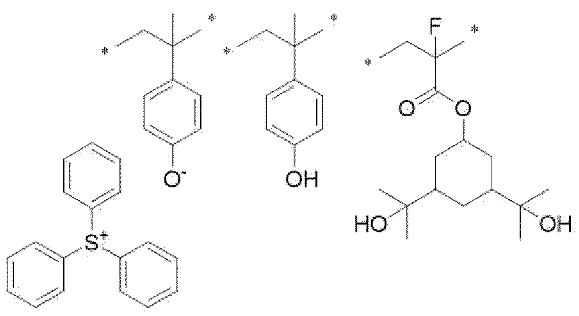

A-24

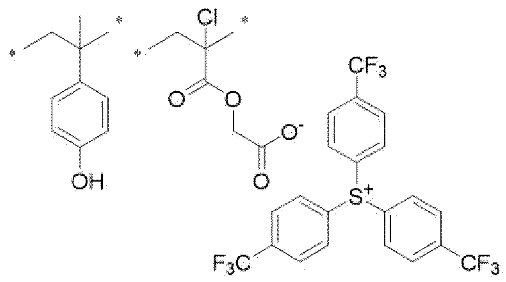

A-25

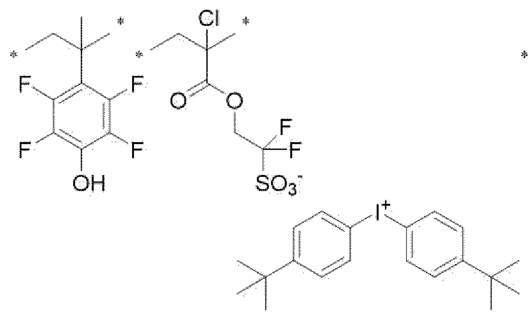

A-26

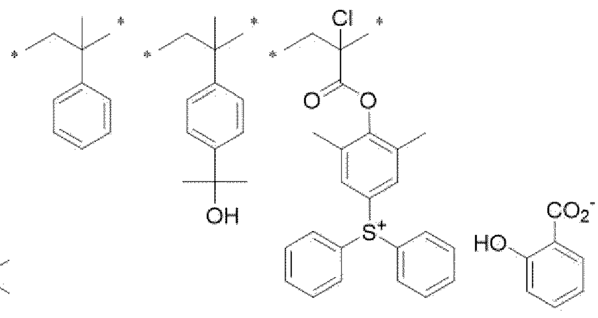

A-27

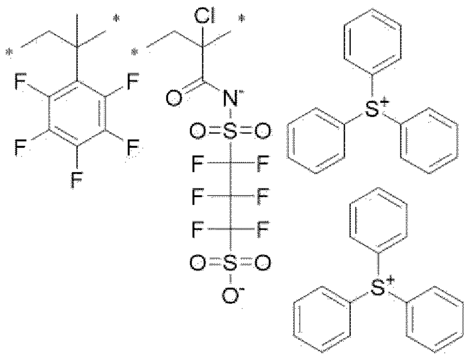

A-28

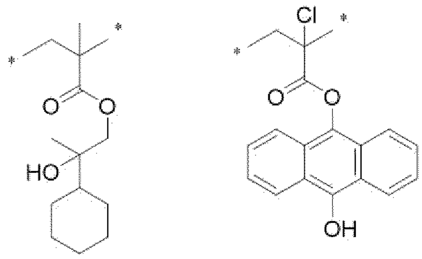

A-29

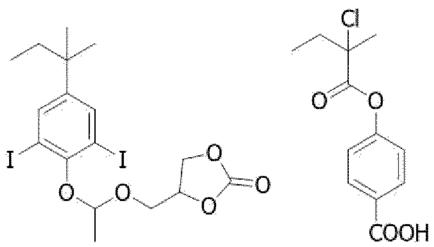

A-30

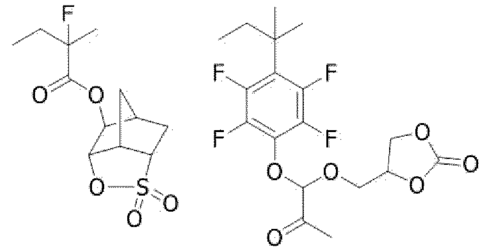

A-31

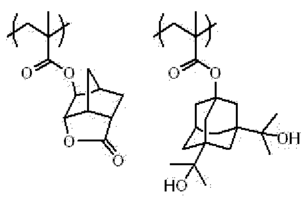

A-32

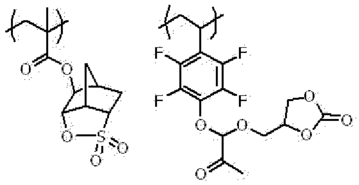

A-33

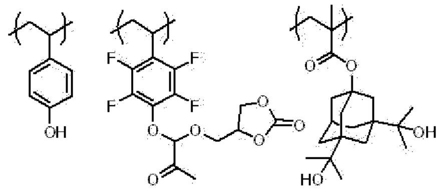

A-34

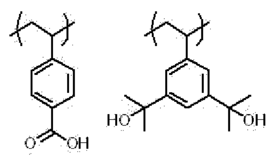

A-35

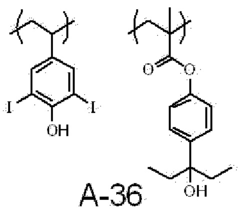

A-36

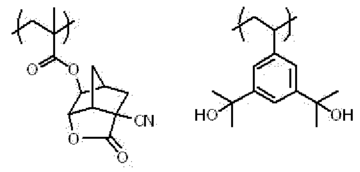

A-37

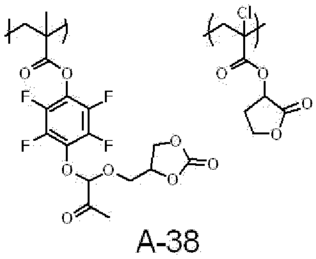

A-38

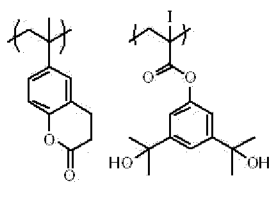

A-39

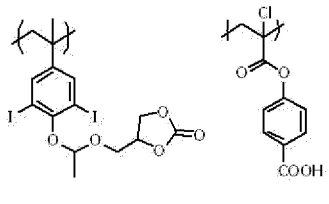

A-40

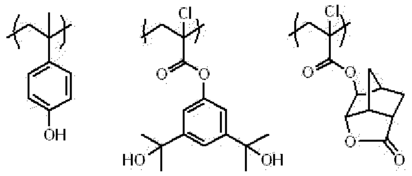

A-41

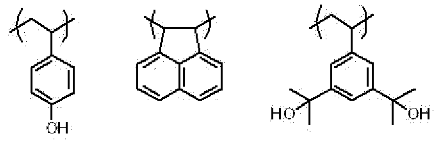

A-42

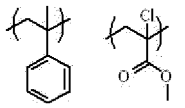

A-43

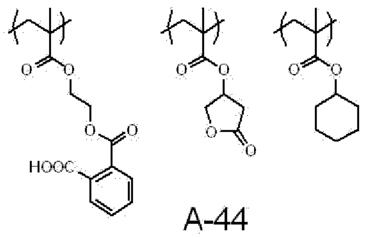

A-44

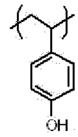

A-45

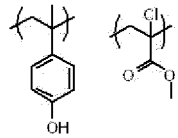

A-46

Photoacid Generator

The structures of photoacid generators PAG-1 to PAG-7 are as follows.

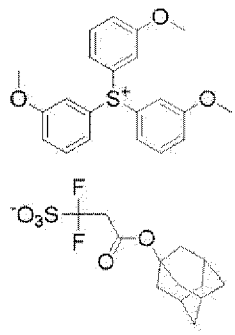

PAG-1

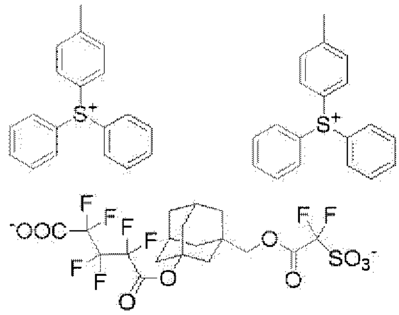

PAG-2

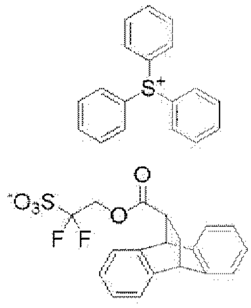

PAG-3

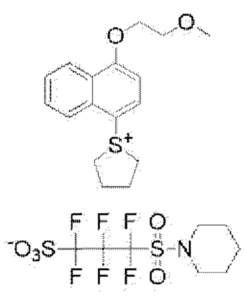

PAG-4

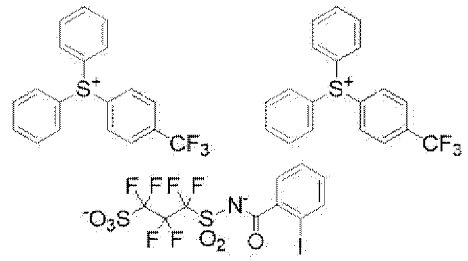

PAG-5

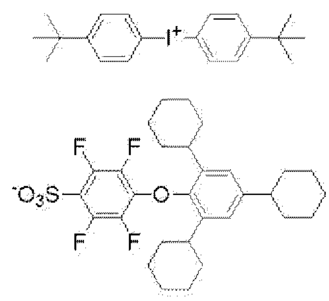

PAG-6

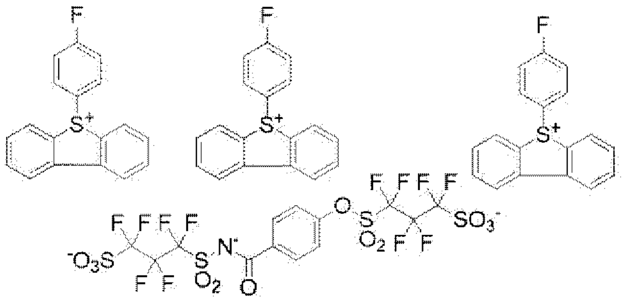

PAG-7

Acid Diffusion Control Agent

The structures of acid diffusion control agents Q-1 to Q-5 are as follows.

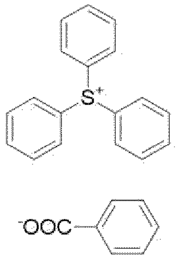

Q-1

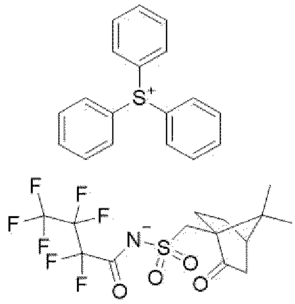

Q-2

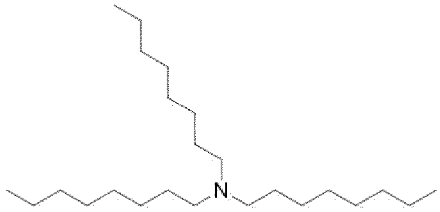

Q-3

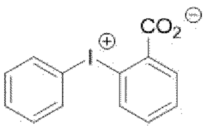

Q-4

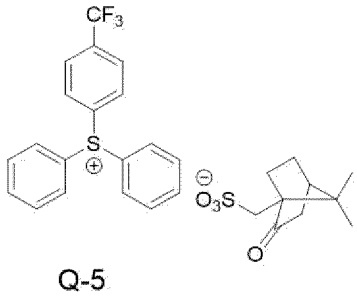

Q-5

Crosslinking Agent

The structure of a crosslinking agent X-1 is as follows.

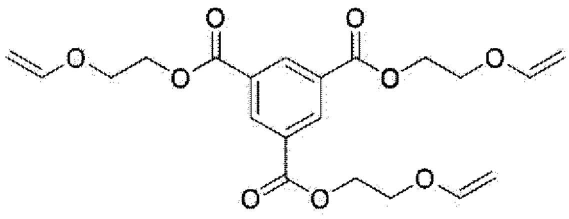

X-1

Capping Agent

The structure of a capping agent Y-1 is as follows.

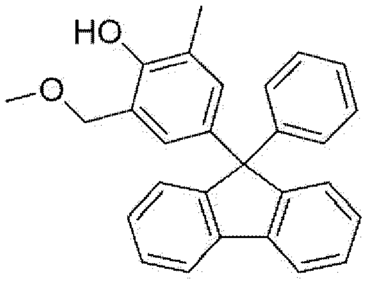

Y-1

Surfactant

Surfactants are as follows.

W-1: MEGAFACE F176 (manufactured by DIC Corporation, fluorine-based)
W-2: MEGAFACE R08 (manufactured by DIC Corporation, fluorine-based and silicon-based)

Solvent

Solvents are as follows.

SL-1: Propylene glycol monomethyl ether acetate (PGMEA)
SL-2: Propylene glycol monomethyl ether (PGME)
SL-3: Cyclohexanone
SL-4: γ-Butyrolactone
SL-5: Ethyl lactate
SL-6: Diacetone alcohol

Developer and Rinsing Liquid

D-1: Butyl acetate
D-2: Isoamyl acetate
D-3: n-Octane
D-4: n-Nonane
D-5: n-Decane
D-6: n-Undecane
D-7: n-Dodecane
D-8: 2.38 mass% Tetramethylammonium hydroxide aqueous solution
D-9: Pure water

The components shown in Tables 2 and 3 below were mixed to prepare liquid mixtures. Subsequently, the resulting liquid mixtures were each filtered through a polyethylene filter having a pore size of 0.03 μm to prepare resist compositions. The concentration of solid content of each resist composition was appropriately adjusted such that the resist composition could be applied in a film thickness shown in tables below. The solid content means components excluding solvents (organic solvent and water) in the resist composition, and a component other than the solvents is regarded as the solid content even when the component is a liquid component.

Table 2

| Resist composition | Resin (A) | | | | Photoacid generator | | Acid diffusion control agent | | Crosslinking agent | | Capping agent | | Surfactant | | Solvent (mass ratio) |
|---|---|---|---|---|---|---|---|---|---|---|---|---|---|---|---|
| | Type | Content (parts by mass) | Type | Content (parts by mass) | Type | Content (parts by mass) | Type | Content (parts by mass) | Type | Content (parts by mass) | Type | Content (parts by mass) | Type | Content (parts by mass) | |
| R-1 | A-1 | 80.0 | - | - | PAG-1 | 15.0 | Q-1 | 5.0 | - | - | - | - | - | - | SL-1/SL-2/SL-3=60/20/20 |
| R-2 | A-2 | 87.6 | - | - | PAG-2 | 12.0 | - | - | - | - | - | - | W-1 | 0.4 | SL-1/SL-3=60/40 |
| R-3 | A-3 | 72.0 | - | - | PAG-3 | 16.0 | Q-1 | 12.0 | - | - | - | - | - | - | SL-1/SL-2=60/40 |
| R-4 | A-4 | 69.0 | - | - | PAG-4 | 22.0 | Q-5 | 9.0 | - | - | - | - | - | - | SL-2/SL-4=70/30 |
| R-5 | A-5 | 86.0 | - | - | PAG-5 | 10.0 | Q-1 | 4.0 | - | - | - | - | - | - | SL-1/SL-2/SL-5=20/20/60 |
| R-6 | A-6 | 67.0 | - | - | PAG-1/PAG-2 | 12.0/16.0 | Q-4 | 5.0 | - | - | - | - | - | - | SL-1/SL-3=60/40 |
| R-7 | A-7 | 77.0 | - | - | PAG-6 | 15.0 | Q-2 | 8.0 | - | - | - | - | - | - | SL-1=100 |
| R-8 | A-8 | 75.8 | - | - | PAG-7 | 24.0 | - | - | - | - | - | - | W-2 | 0.2 | SL-1/SL-2/SL-4=80/15/5 |
| R-9 | A-9 | 60.8 | - | - | PAG-2/PAG-7 | 10.0/22.0 | Q-3 | 7.0 | - | - | - | - | W-1 | 0.2 | SL-1/SL-6=20/80 |
| R-10 | A-10 | 75.0 | - | - | PAG-4 | 25.0 | - | - | - | - | - | - | - | - | SL-1/SL-2=60/40 |
| R-11 | A-11 | 67.0 | - | - | PAG-2 | 20.0 | Q-1 | 13.0 | - | - | - | - | - | - | SL-1/SL-2/SL-3=60/20/20 |
| R-12 | A-12 | 82.0 | - | - | PAG-1 | 18.0 | - | - | - | - | - | - | - | - | SL-1/SL-3=60/40 |

(continued)

| Resist composition | Resin (A) | | | | Photoacid generator | | Acid diffusion control agent | | Crosslinking agent | | Capping agent | | Surfactant | | Solvent (mass ratio) |
|---|---|---|---|---|---|---|---|---|---|---|---|---|---|---|---|
| | Type | Content (parts by mass) | Type | Content (parts by mass) | Type | Content (parts by mass) | Type | Content (parts by mass) | Type | Content (parts by mass) | Type | Content (parts by mass) | Type | Content (parts by mass) | |
| R-13 | A-13 | 73.0 | - | - | PAG-3 | 19.0 | Q-1 | 8.0 | - | - | - | - | - | - | SL-1/SL-2=60/40 |
| R-14 | A-14 | 85.7 | - | - | PAG-1 | 14.0 | - | - | - | - | - | - | W-1 | 0.3 | SL-1/SL-2/SL-5=20/20/60 |
| R-15 | A-15 | 79.0 | - | - | PAG-5 | 17.0 | Q-1 | 4.0 | - | - | - | - | - | - | SL-1/SL-2/SL-3=60/20/20 |
| R-16 | A-16 | 78.0 | - | - | PAG-2 | 22.0 | - | - | - | - | - | - | - | - | SL-1/SL-3=60/40 |
| R-17 | A-17 | 72.7 | - | - | PAG-7 | 18.0 | Q-4 | 9.0 | - | - | - | - | W-2 | 0.3 | SL-1/SL-2=60/40 |
| R-18 | A-18 | 60.0 | - | - | PAG-5 | 27.0 | Q-1 | 13.0 | - | - | - | - | - | - | SL-2/SL-4=70/30 |
| R-19 | A-19 | 67.0 | - | - | PAG-6 | 23.0 | Q-4 | 10.0 | - | - | - | - | - | - | SL-1/SL-2/SL-5=20/20/60 |
| R-20 | A-20 | 84.8 | - | - | PAG-4 | 11.0 | Q-1 | 4.0 | - | - | - | - | W-1 | 0.2 | SL-3=100 |
| R-21 | A-21 | 56.0 | - | - | PAG-3 | 28.0 | Q-2 | 16.0 | - | - | - | - | - | - | SL-1/SL-2=60/40 |
| R-22 | A-22 | 83.0 | - | - | PAG-2 | 17.0 | - | - | - | - | - | - | - | - | SL-1/SL-2/SL-4=80/15/5 |
| R-23 | A-23 | 60.7 | - | - | PAG-3 | 25.0 | Q-3 | 14.0 | - | - | - | - | W-1 | 0.3 | SL-1/SL-2=60/40 |
| R-24 | A-24 | 78.0 | - | - | PAG-4 | 22.0 | - | - | - | - | - | - | - | - | SL-1/SL-2=60/40 |

(continued)

| Resist composition | Resin (A) | | | | Photoacid generator | | Acid diffusion control agent | | Crosslinking agent | | Capping agent | | Surfactant | | Solvent (mass ratio) |
|---|---|---|---|---|---|---|---|---|---|---|---|---|---|---|---|
| | Type | Content (parts by mass) | Type | Content (parts by mass) | Type | Content (parts by mass) | Type | Content (parts by mass) | Type | Content (parts by mass) | Type | Content (parts by mass) | Type | Content (parts by mass) | |
| R-25 | A-25 | 65.0 | - | - | PAG-3 | 23.0 | Q-5 | 12.0 | - | - | - | - | - | - | SL-1/SL-2/SL-3=60/20/20 |

Table 3

| Resist composition | Resin (A) | | | | Photoacid generator | | Acid diffusion control agent | | Crosslinking agent | | Capping agent | | Surfactant | | Solvent (mass ratio) |
|---|---|---|---|---|---|---|---|---|---|---|---|---|---|---|---|
| | Type | Content (parts by mass) | Type | Content (parts by mass) | Type | Content (parts by mass) | Type | Content (parts by mass) | Type | Content (parts by mass) | Type | Content (parts by mass) | Type | Content (parts by mass) | |
| R-26 | A-26 | 84.0 | - | - | PAG-6 | 16.0 | - | - | - | - | - | - | - | - | SL-1/SL-3=60/40 |
| R-27 | A-27 | 75.0 | - | - | PAG-2 | 18.0 | Q-1 | 7.0 | - | - | - | - | - | - | SL-1/SL-2=60/40 |
| R-28 | A-28 | 88.8 | - | - | PAG-6 | 11.0 | - | - | - | - | - | - | W-2 | 0.2 | SL-1/SL-2/SL-5=20/20/60 |
| R-29 | A-29 | 73.0 | - | - | PAG-6 | 27.0 | - | - | - | - | - | - | - | - | SL-1/SL-3=60/40 |
| R-30 | A-30 | 60.0 | - | - | PAG-5 | 23.0 | Q-1 | 17.0 | - | - | - | - | - | - | SL-1/SL-2=60/40 |
| R-31 | A-31 | 81.0 | - | - | PAG-1 | 19.0 | - | - | - | - | - | - | - | - | SL-1/SL-2/SL-5=20/20/60 |
| R-32 | A-32 | 75.0 | - | - | PAG-1 | 20.0 | Q-1 | 5.0 | - | - | - | - | - | - | SL-1/SL-2/SL-3=60/20/20 |
| R-33 | A-33 | 80.0 | - | - | PAG-2 | 20.0 | - | - | - | - | - | - | - | - | SL-1/SL-3=60/40 |
| R-34 | A-34 | 70.0 | - | - | PAG-3 | 15.0 | Q-1 | 15.0 | - | - | - | - | - | - | SL-1/SL-2=60/40 |
| R-35 | A-35 | 64.7 | - | - | PAG-7 | 25.0 | Q-1 | 10.0 | - | - | - | - | W-1 | 0.3 | SL-2/SL-4=70/30 |
| R-36 | A-36 | 39.8 | A-45 | 30 | PAG-1 | 20.0 | Q-1 | 10.0 | - | - | - | - | W-2 | 0.2 | SL-1/SL-2/SL-5=20/20/60 |

(continued)

| Resist composition | Resin (A) | | | | Photoacid generator | | Acid diffusion control agent | | Crosslinking agent | | Capping agent | | Surfactant | | Solvent (mass ratio) |
|---|---|---|---|---|---|---|---|---|---|---|---|---|---|---|---|
| | Type | Content (parts by mass) | Type | Content (parts by mass) | Type | Content (parts by mass) | Type | Content (parts by mass) | Type | Content (parts by mass) | Type | Content (parts by mass) | Type | Content (parts by mass) | |
| R-37 | A-37 | 29.7 | A-45 | 40 | PAG-1/PAG-2 | 10.0/15.0 | Q-1 | 5.0 | - | - | - | - | W-1 | 0.3 | SL-3=100 |
| R-38 | A-38 | 70.0 | - | - | PAG-4 | 20.0 | Q-2 | 10.0 | - | - | - | - | - | - | SL-1=100 |
| R-39 | A-39 | 60.0 | - | - | PAG-5/PAG-7 | 20.0/20.0 | - | - | - | - | - | - | - | - | SL-1/SL-2/SL-4=80/15/5 |
| R-40 | A-32 | 35.0 | A-43 | 40.0 | PAG-6 | 17.0 | Q-3 | 8.0 | - | - | - | - | - | - | SL-1/SL-6=20/80 |
| R-41 | A-33 | 55.0 | A-43 | 20.0 | PAG-5 | 25.0 | - | - | - | - | - | - | - | - | SL-1/SL-2=60/40 |
| R-42 | A-40 | 65.0 | - | - | PAG-3 | 23.0 | Q-1 | 12.0 | - | - | - | - | - | - | SL-1/SL-2/SL-3=60/20/20 |
| R-43 | A-41 | 80.0 | - | - | PAG-2 | 20.0 | - | - | - | - | - | - | - | - | SL-1/SL-3=60/40 |
| R-44 | A-34 | 55.0 | A-46 | 25.0 | PAG-4 | 13.0 | Q-1 | 7.0 | - | - | - | - | - | - | SL-1/SL-2=60/40 |
| R-45 | A-35 | 29.8 | A-46 | 50.0 | PAG-5 | 20.0 | - | - | - | - | - | - | W-2 | 0.2 | SL-1/SL-2/SL-5=20/20/60 |
| R-46 | A-42 | 75.0 | - | - | PAG-6 | 20.0 | Q-3 | 5.0 | - | - | - | - | - | - | SL-1/SL-2=80/20 |
| R-47 | A-43 | 99.7 | - | - | - | - | - | - | - | - | - | - | W-1 | 0.3 | SL-2/SL-4=70/30 |
| R-48 | A-44 | 55.0 | - | - | PAG-1 | 10.0 | Q-2 | 5.0 | X-1 | 30.0 | - | - | - | - | SL-1/SL-2=80/20 |

(continued)

| Resist composition | Resin (A) | | | | Photoacid generator | | Acid diffusion control agent | | Crosslinking agent | | Capping agent | | Surfactant | | Solvent (mass ratio) |
|---|---|---|---|---|---|---|---|---|---|---|---|---|---|---|---|
| | Type | Content (parts by mass) | Type | Content (parts by mass) | Type | Content (parts by mass) | Type | Content (parts by mass) | Type | Content (parts by mass) | Type | Content (parts by mass) | Type | Content (parts by mass) | |
| R-49 | A-45 | 85.0 | - | - | - | - | Q-1 | 15.0 | - | - | - | - | - | - | SL-1/SL-2=80/20 |
| R-50 | A-45 | 70.0 | - | - | PAG-1 | 10.0 | - | - | - | - | Y-1 | 20.0 | - | - | SL-1/SL-2=80/20 |

Pattern Formation by EUV Exposure: Examples 1 to 49 and 66 and Comparative Examples 1 to 4

Pattern Formation

An underlayer film-forming composition SHB-A940 (manufactured by Shin-Etsu Chemical Co., Ltd.) was applied onto a 12-inch silicon wafer and baked at 205°C for 60 seconds to form an underlayer film having a film thickness of 20 nm. A resist film was formed thereon under predetermined conditions (film thickness and PreBake) using the resist composition shown in the tables below. Thus, a silicon wafer having a resist film was produced.

The silicon wafer having the resulting resist film was subjected to pattern irradiation using an EUV exposure apparatus (manufactured by Exitech Ltd., Micro Exposure Tool, NA 0.3, Quadrupol, outer sigma 0.68, inner sigma 0.36). A photo mask having a line size of 14 to 20 nm and line: space =1:1 was used as a reticle. Subsequently, baking (PEB: Post Exposure Bake) was performed as needed as described in the tables below, development was then performed with a developer by puddling for 30 seconds, rinsing was performed as needed by pouring a rinsing liquid for 10 seconds while the wafer was rotated at a rotational speed of 1,000 rpm, and the wafer was then rotated at a rotational speed of 4,000 rpm for 30 seconds to obtain a line-and-space pattern with a pitch of 28 to 40 nm.

Optimum Exposure Dose

An exposure dose at which a pattern having a line size of 14 to 20 nm and line: space = 1: 1 was reproduced was defined as an optimum exposure dose (unit: $mJ/cm^2$) for each line size. Evaluation of Resolution

A limit resolving power (the minimum line width at which a line and a space are separately resolved, limit resolution) at the optimum exposure dose was defined as a resolution (unit: nm). The evaluation criteria are as follows. Practically, the evaluation result is preferably "D" or higher.

"A": The resolution is 14 nm or less.
"B": The resolution is more than 14 nm and 15 nm or less.
"C": The resolution is more than 15 nm and 16 nm or less.
"D": The resolution is more than 16 nm and 18 nm or less.
"E": The resolution is more than 18 nm and 20 nm or less.
"F": The resolution is more than 20 nm.

Evaluation of Evenness (Variation in Pattern Shape)

The evenness was evaluated by determining the difference between a line width of the pattern in a central portion of the obtained resist film and a line width of the pattern in an outer peripheral portion of the obtained resist film.

Wafer processing was performed by the method described in the above Pattern Formation, except that the exposure was performed with the exposure dose being fixed to the optimum exposure dose. The line width of the line-and-space pattern in a central portion of the resist film was measured at 10 points, and the average value thereof was defined as CD1. The central portion of the resist film is a region within 100 mm from the central point of the resist film.

In addition, the line width of the line-and-space pattern in an outer peripheral portion of the resist film was measured at 10 points, and the average value thereof was defined as CD2. The outer peripheral portion of the resist film is a region of the resist film other than the central portion of the resist film.

The difference (ΔCD) between CD1 in the central portion of the resist film and CD2 in the outer peripheral portion of the resist film was calculated by the following formula. A smaller ΔCD indicates a better performance.

$$\Delta CD\ (nm) = |CD1\ (nm) - CD2\ (nm)|$$

"A": ΔCD is 2.0 nm or less.
"B": ΔCD is more than 2.0 nm.

In the tables below, the notations indicate the following.

The "PEB" column indicates each processing condition of baking (PEB: Post Exposure Bake).

The "Developer" and "Rinsing liquid" columns indicate the compositions of the developer and the rinsing liquid, respectively. Specifically, in the case of the developer "D-1/D-4 = 80/20" described in Example 1, it is indicated that the developer includes the organic solvent D-1 and the organic solvent D-4, the content of the organic solvent D-1 is 80 mass% relative to the total mass of the developer, and the content of the organic solvent D-4 is 20 mass% relative to the total mass of the developer.

Table 4

| | Resist application conditions | | | PEB·Development conditions | | | Performance evaluation | | |
|---|---|---|---|---|---|---|---|---|---|
| | Resist composition | Film thickness (nm) | Pre Bake | PEB | Developer | Rinsing liquid | Pattern | Resolution (nm) | ΔCD (nm) |
| Example 1 | R-1 | 30 | 100°C/ 60 see | 100°C/ 60 see | D-1/D-4=80/20 | - | Positive | B | A |
| Example 2 | R-2 | 25 | 100°C/ 60 see | 100°C/ 60 see | D-1/D-5=90/10 | - | Positive | B | A |
| Example 3 | R-3 | 30 | 120°C/ 60 see | 120°C/ 60 sec | D-1/D-6=90/10 | - | Positive | B | A |
| Example 4 | R-4 | 30 | 120°C/ 60 see | 100°C/ 50 sec | D-1/D-7=90/10 | D-5=100 | Positive | C | A |
| Example 5 | R-5 | 30 | 100°C/ 60 see | 110°C/ 60 sec | D-1/D-3=95/5 | - | Positive | C | A |
| Example 6 | R-6 | 40 | 100°C/ 60 see | 100°C/ 60 see | D-1/D-5=80/20 | - | Positive | B | A |
| Example 7 | R-7 | 30 | 90°C/60 see | 100°C/ 60 sec | D-1/D-6=85/15 | D-6=100 | Positive | B | A |
| Example 8 | R-8 | 30 | 120°C/ 60 see | 120°C/ 60 sec | D-1/D-6=75/25 | - | Positive | B | A |
| Example 9 | R-9 | 30 | 100°C/ 60 see | 100°C/ 60 see | D-1/D-7=90/10 | - | Positive | C | A |
| Example 10 | R-10 | 35 | 100°C/ 60 see | 100°C/ 60 sec | D-1/D-3=90/10 | D-6=100 | Positive | C | A |
| Example 11 | R-11 | 30 | 90°C/60 see | 100°C/ 60 sec | D-1/D-6=95/5 | - | Positive | B | A |
| Example 12 | R-12 | 30 | 100°C/ 60 see | 100°C/ 60 sec | D-1/D-6=90/10 | D-7=100 | Positive | B | A |
| Example 13 | R-13 | 35 | 100°C/ 60 see | 100°C/ 60 sec | D-1/D-7=95/5 | - | Positive | C | A |
| Example 14 | R-14 | 30 | 100°C/ 60 see | 100°C/ 60 see | D-1/D-3=90/10 | - | Positive | C | A |
| Example 15 | R-15 | 30 | 120°C/ 60 see | 100°C/ 60 sec | D-1/D-4=90/10 | - | Positive | B | A |
| Example 16 | R-16 | 30 | 100°C/ 60 see | 100°C/ 60 see | D-1/D-5=90/10 | - | Positive | B | A |
| Example 17 | R-17 | 30 | 100°C/ 60 see | 100°C/ 60 sec | D-1/D-6=75/25 | - | Positive | B | A |
| Example 18 | R-18 | 30 | 100°C/ 60 see | 110°C/ 60 sec | D-1/D-5=90/10 | D-7=100 | Positive | B | A |
| Example 19 | R-19 | 30 | 100°C/ 60 see | 100°C/ 50 see | D-1/D-3=90/10 | - | Positive | C | A |
| Example 20 | R-20 | 30 | 100°C/ 60 see | 100°C/ 50 sec | D-1/D-6=90/10 | - | Positive | A | A |

(continued)

| | Resist application conditions | | | PEB·Development conditions | | | Performance evaluation | | |
|---|---|---|---|---|---|---|---|---|---|
| | Resist composition | Film thickness (nm) | Pre Bake | PEB | Developer | Rinsing liquid | Pattern | Resolution (nm) | ΔCD (nm) |
| Example 21 | R-21 | 30 | 100°C/ 60 see | 100°C/ 60 see | D-1/D-5=90/10 | - | Positive | A | A |
| Example 22 | R-22 | 30 | 100°C/ 60 see | 100°C/ 60 sec | D-1/D-4=80/20 | - | Positive | B | A |
| Example 23 | R-23 | 30 | 100°C/ 60 see | 120°C/ 60 sec | D-1/D-6=85/15 | - | Positive | A | A |
| Example 24 | R-24 | 30 | 100°C/ 60 see | 100°C/ 60 see | D-1/D-7=90/10 | - | Positive | B | A |
| Example 25 | R-25 | 30 | 100°C/ 60 see | 100°C/ 60 sec | D-1/D-6=80/20 | - | Positive | A | A |
| Example 26 | R-26 | 25 | 90°C/60 see | 100°C/ 60 see | D-1/D-7=90/10 | - | Positive | B | A |
| Example 27 | R-27 | 35 | 100°C/ 60 see | 100°C/ 60 sec | D-1/D-6=90/10 | - | Positive | B | A |
| Example 28 | R-28 | 30 | 120°C/ 60 see | 100°C/ 60 sec | D-1/D-5=90/10 | D-6=100 | Positive | B | A |

Table 5

| | Resist application conditions | | | PEB·Development conditions | | | Performance evaluation | | |
|---|---|---|---|---|---|---|---|---|---|
| | Resist composition | Film thickness (nm) | Pre Bake | PEB | Developer | Rinsing liquid | Pattern | Resolution (nm) | ΔCD (nm) |
| Example 29 | R-29 | 30 | 100°C/ 60 sec | 110°C/ 60 sec | D-1/D-6=90/10 | - | Positive | A | A |
| Example 30 | R-30 | 30 | 100°C/ 60 sec | 100°C/ 60 sec | D-1/D-7=80/20 | - | Positive | B | A |
| Example 31 | R-31 | 30 | 100°C/ 60 sec | 100°C/ 60 sec | D-1/D-5=85/15 | - | Positive | B | A |
| Example 32 | R-32 | 30 | 100°C/ 60 sec | 120°C/ 60 see | D-1/D-6=90/10 | - | Positive | C | A |
| Example 33 | R-3 3 | 45 | 120°C/ 60 sec | - | D-1/D-6=85/15 | - | Positive | C | A |
| Example 34 | R-34 | 25 | 100°C/ 60 sec | 90°C/ 60 sec | D-1/D-7=90/10 | - | Positive | D | A |
| Example 35 | R-3 5 | 30 | 90°C/ 60 sec | 105°C/ 60 sec | D-1/D-6=85/15 | - | Positive | B | A |
| Example 36 | R-36 | 35 | 100°C/ 60 see | 100°C/ 50 sec | D-1/D-5=75/25 | - | Positive | B | A |
| Example 37 | R-37 | 30 | 100°C/ 60 sec | 100°C/ 50 sec | D-1/D-6=90/10 | - | Positive | C | A |

(continued)

| | Resist application conditions | | | PEB·Development conditions | | | Performance evaluation | | |
|---|---|---|---|---|---|---|---|---|---|
| | Resist composition | Film thickness (nm) | Pre Bake | PEB | Developer | Rinsing liquid | Pattern | Resolution (nm) | ΔCD (nm) |
| Example 38 | R-38 | 35 | 120°C/ 60 sec | 80°C/ 60 sec | D-1/D-5=85/15 | - | Positive | B | A |
| Example 39 | R-3 9 | 45 | 100°C/ 60 sec | 110°C/ 60 sec | D-1/D-6=90/10 | - | Positive | B | A |
| Example 40 | R-40 | 35 | 90°C/ 60 see | 100°C/ 60 sec | D-1/D-4=90/10 | D-7=100 | Positive | C | A |
| Example 41 | R-41 | 35 | 100°C/ 60 see | 120°C/ 60 sec | D-1/D-5=85/15 | - | Positive | C | A |
| Example 42 | R-42 | 30 | 100°C/ 60 see | 110°C/ 60 see | D-1/D-5=90/10 | - | Positive | A | A |
| Example 43 | R-43 | 35 | 120°C/ 60 see | 100°C/ 60 sec | D-1/D-6=85/15 | - | Positive | A | A |
| Example 44 | R-44 | 30 | 100°C/ 60 see | 120°C/ 60 see | D-1/D-7=90/10 | - | Positive | D | A |
| Example 45 | R-45 | 40 | 90°C/ 60 see | 90°C/ 60 sec | D-1/D-6=90/10 | - | Positive | B | A |
| Example 46 | R-46 | 30 | 120°C/ 60 see | 100°C/ 60 see | D-1/D-6=90/10 | - | Positive | B | A |
| Example 47 | R-47 | 35 | 90°C/ 60 see | 90°C/ 60 sec | D-1/D-6=80/20 | - | Positive | C | A |
| Example 48 | R-48 | 40 | 100°C/ 60 see | 90°C/ 60 see | D-1/D-5=90/10 | - | Positive | C | A |
| Example 49 | R-49 | 35 | 100°C/ 60 see | 110°C/ 60 sec | D-1/D-6=75/25 | - | Positive | C | A |
| Example 66 | R-50 | 35 | 100°C/ 60 see | 110°C/ 60 see | D-1/D-6=90/10 | - | Positive | B | A |
| Comparative Example 1 | R-46 | 30 | 120°C/ 60 see | 100°C/ 60 sec | D-8=100 | D-9=100 | Negative | F | A |
| Comparative Example 2 | R-47 | 35 | 90°C/ 60 see | 90°C/ 60 see | D-1=100 | - | Positive | E | A |
| Comparative Example 3 | R-48 | 40 | 100°C/ 60 see | 90°C/ 60 see | D-1=100 | - | Positive | E | A |
| Comparative Example 4 | R-49 | 35 | 100°C/ 60 see | 110°C/ 60 sec | D-2/D-6=75/25 | - | Positive | C | B |

From the results shown in the above tables, it was confirmed that the pattern forming method according to the present invention was excellent in resolution and evenness.

It was confirmed that when the hydrocarbon-based solvent had 9 to 11 carbon atoms, higher resolution was achieved (for example, comparison of Examples 1 to 12). In addition, from the similar comparison, it was confirmed that when the hydrocarbon-based solvent included at least one selected from the group consisting of nonane, decane, and undecane, higher resolution was achieved.

It was confirmed that when the resin included two or more selected from the group (preferably three or more selected from the group, more preferably three selected from the group) consisting of a polarity-decreasing group, an

interactive group, a polar group, a reactive group A, a reactive group B, and a block or repeating unit that undergoes a decrease in molecular weight caused by the scission of the main chain due to action of exposure, acid, base, or heating, higher resolution was achieved (for example, comparison of Examples 1 to 3, Examples 20 to 23 and 25).

EB Exposure: Examples 50 to 65 and Comparative Examples 5 to 8

An antireflection film-forming composition DUV44 (manufactured by Brewer Science, Inc.) was applied onto a mask blank having an outermost surface made of Cr and a size of 152 mm square using ACTM (manufactured by Tokyo Electron Ltd.) and baked at 205°C for 60 seconds to form an underlayer film having a film thickness of 60 nm. A resist film was formed thereon under predetermined conditions (film thickness and PreBake) using the resist composition shown in the table below. Thus, a mask blank having a resist film was formed.

The mask blank having the resist film obtained by the above procedure was subjected to pattern irradiation using an electron beam exposure apparatus (manufactured by NuFlare Technology, Inc., EBM-9000, accelerating voltage: 50 kV). At this time, patterning was performed so as to form a 1:1 line-and-space having a line size of 14 to 20 nm. Subsequently, baking (PEB: Post Exposure Bake) was performed under predetermined conditions as needed as described in the table below, development was then performed with a developer by puddling for 30 seconds, rinsing was performed as needed by pouring a rinsing liquid for 10 seconds while the wafer was rotated at a rotational speed of 1,000 rpm, and the wafer was then rotated at a rotational speed of 4,000 rpm for 30 seconds to obtain a line-and-space pattern with a pitch of 28 to 40 nm.

Evaluation of Optimum Exposure Dose

An exposure dose at which a pattern having a line size of 20 to 14 nm and line:space = 1: 1 was reproduced was defined as an optimum exposure dose (unit: $mJ/cm^2$) for each line size. Evaluation of Resolution

A limit resolving power (the minimum line width at which a line and a space are separately resolved) at the optimum exposure dose was defined as a resolution (unit: nm). The evaluation criteria were set as follows. Practically, the evaluation result is preferably "D" or higher.

"A": The resolution is 14 nm or less.
"B": The resolution is more than 14 nm and 15 nm or less.
"C": The resolution is more than 15 nm and 16 nm or less.
"D": The resolution is more than 16 nm and 18 nm or less.
"E": The resolution is more than 18 nm and 20 nm or less.
"F": The resolution is more than 20 nm.

Evaluation of Evenness (Variation in Pattern Shape)

Wafer processing was performed by the method described in the above method of Pattern Formation, except that the exposure was performed with the exposure dose being fixed to the optimum exposure dose. The line width of the line-and-space pattern in a central portion of the resist film was measured at 10 points, and the average value thereof was defined as CD1. The central portion of the resist film is a region within 100 mm from the central point of the resist film.

In addition, the line width of the line-and-space pattern in an outer peripheral portion of the resist film was measured at 10 points, and the average value thereof was defined as CD2. The outer peripheral portion of the resist film is a region of the resist film other than the central portion of the resist film.

The difference (ΔCD) between CD1 in the central portion of the resist film and CD2 in the outer peripheral portion of the resist film was calculated by the following formula. A smaller ΔCD indicates a better performance.

$$\Delta CD\ (nm) = |CD1\ (nm) - CD2\ (nm)|$$

"A": ΔCD is 2.0 nm or less.
"B": ΔCD is more than 2.0 nm.

Table 6

| | Resist application conditions | | | PEB·Development conditions | | | Performance evaluation | | |
|---|---|---|---|---|---|---|---|---|---|
| | Resist | Film thickness (nm) | Pre Bake | PEB | Developer | Rinsing liquid | Pattern | Resolution (nm) | ΔCD (nm) |
| Example 50 | R-1 | 30 | 100°C/ 60 sec | 100°C160 sec | D-1/D-4 =80/20 | - | Positive | B | A |
| Example 51 | R-2 | 25 | 100°C/ 60 sec | 100°C/60 sec | D-1/D-5 =90/10 | - | Positive | B | A |
| Example 52 | R-3 | 30 | 120°C/ 60 sec | 120°C/60 sec | D-1/D-6 =90/10 | - | Positive | B | A |
| Example 53 | R-4 | 30 | 120°C/ 60 sec | 100°C/50 sec | D-1/D-7 =90/10 | D-5=100 | Positive | C | A |
| Example 54 | R-5 | 30 | 100°C/ 60 sec | 110°C/60 sec | D-1/D-3=95/5 | - | Positive | C | A |
| Example 55 | R-32 | 30 | 100°C/ 60 sec | 120°C/60 sec | D-1/D-6 =90/10 | - | Positive | C | A |
| Example 56 | R-33 | 45 | 120°C/ 60 sec | - | D-1/D-6 =85/15 | - | Positive | C | A |
| Example 57 | R-34 | 25 | 100°C/ 60 sec | 90°C/60 sec | D-1/D-7 =90/10 | - | Positive | D | A |
| Example 58 | R-35 | 30 | 90°C/60 sec | 105°C/60 sec | D-1/D-6 =85/15 | - | Positive | B | A |
| Example 59 | R-36 | 35 | 100°C/ 60 sec | 100°C/50 sec | D-1/D-5 =75/25 | - | Positive | B | A |
| Example 60 | R-42 | 30 | 100°C/ 60 sec | 110°C/60 sec | D-1/D-5 =90/10 | - | Positive | A | A |
| Example 61 | R-43 | 35 | 120°C/ 60 sec | 100°C/60 sec | D-1/D-6 =85/15 | - | Positive | A | A |
| Example 62 | R-46 | 30 | 120°C/ 60 sec | 100°C/60 sec | D-1/D-6 =90/10 | - | Positive | B | A |
| Example 63 | R-47 | 35 | 90°C/60 sec | 90°C/60 se c | D-1/D-6 =80/20 | - | Positive | C | A |
| Example 64 | R-48 | 40 | 100°C/ 60 sec | 90°C/60 sec | D-1/D-5 =90/10 | - | Positive | C | A |
| Example 65 | R-49 | 35 | 100°C/ 60 sec | 110°C/60 sec | D-1/D-6 =75/25 | - | Positive | C | A |
| Comparative Example 5 | R-46 | 30 | 120°C/ 60 sec | 100°C/60 sec | D-8=100 | D-9=100 | Negative | F | A |
| Comparative Example 6 | R-47 | 35 | 90°C/60 sec | 90°C/60 sec | D-1=100 | - | Positive | E | A |
| Comparative Example 7 | R-48 | 40 | 100°C/ 60 sec | 90°C/60 se c | D-1=100 | - | Positive | E | A |
| Comparative Example 8 | R-49 | 35 | 100°C/ 60 sec | 110°C/60 sec | D-2/D-6 =75/25 | - | Positive | C | B |

From the results shown in the above table, it was confirmed that the pattern forming method according to the

present invention was excellent in resolution and evenness.

It was confirmed that when the hydrocarbon-based solvent had 9 to 11 carbon atoms, higher resolution was achieved (for example, comparison of Examples 50 to 54). In addition, from the similar comparison, it was confirmed that when the hydrocarbon-based solvent included at least one selected from the group consisting of nonane, decane, and undecane, higher resolution was achieved.

It was confirmed that when the resin included two or more selected from the group (preferably three or more selected from the group, more preferably three selected from the group) consisting of a polarity-decreasing group, an interactive group, a polar group, a reactive group A, a reactive group B, and a block or repeating unit that undergoes a decrease in molecular weight caused by the scission of the main chain due to action of exposure, acid, base, or heating, higher resolution was achieved (for example, comparison of Examples 50 to 52, 60, and 61).

The same procedure and evaluations as those of Example 65 were conducted except that, instead of butyl acetate (D-1) in Example 65, an ester-based solvent having 6 or less carbon atoms other than butyl acetate (specifically, an ester-based solvent of any one of isobutyl acetate, methyl acetate, ethyl acetate, propyl acetate, isopropyl acetate, propylene glycol monomethyl ether acetate, ethylene glycol monoethyl ether acetate, methyl formate, ethyl formate, butyl formate, propyl formate, ethyl lactate, butyl lactate, propyl lactate, methyl 2-hydroxyisobutyrate, ethyl butyrate, and ethyl propionate) was used. In any of the ester-based solvents, results equivalent to those in Example 65 were obtained.

## Claims

**1.** A pattern forming method comprising:

a resist film-forming step of forming a resist film using an actinic ray-sensitive or radiation-sensitive resin composition that undergoes an increase in a degree of solubility in an organic solvent due to action of exposure, acid, base, or heating;
an exposure step of exposing the resist film; and
a developing step of developing the exposed resist film with a developer including an organic solvent,
wherein the organic solvent includes an ester-based solvent having 6 or less carbon atoms and a hydrocarbon-based solvent.

**2.** The pattern forming method according to claim 1, wherein the hydrocarbon-based solvent has 9 to 11 carbon atoms.

**3.** The pattern forming method according to claim 1 or 2, wherein the hydrocarbon-based solvent includes at least one selected from the group consisting of nonane, decane, and undecane.

**4.** The pattern forming method according to claim 1 or 2, wherein the composition satisfies a requirement C1 or a requirement C2 below:

Requirement C1: the composition includes a resin Z1 having a group that decreases polarity due to action of exposure, acid, base, or heating,
Requirement C2: the composition includes a resin Z2 having a polar group, and a compound that reacts with the polar group due to action of exposure, acid, base, or heating.

**5.** The pattern forming method according to claim 1 or 2, wherein the composition satisfies a requirement X or a requirement Y below:

Requirement X: the composition includes a resin X1 that undergoes a decrease in molecular weight caused by scission of a main chain due to action of exposure, acid, base, or heating and satisfies at least one of requirements A1 to A3 below:

Requirement A1: the resin X1 has a group that decreases polarity due to action of exposure, acid, base, or heating,
Requirement A2: the resin X1 has an interactive group that forms an interaction with an onium salt compound and that is released from the interaction due to action of exposure, acid, base, or heating, and the composition further includes an onium salt compound,
Requirement A3: the resin X1 has a polar group, and the composition further includes a compound that reacts with the polar group due to action of exposure, acid, base, or heating,

Requirement Y: the composition includes a resin Y1 that undergoes a decrease in molecular weight caused by scission of a main chain due to action of exposure, acid, base, or heating and a resin Y2 other than the resin Y1 and satisfies at least one of requirements B1 to B3 below:

Requirement B1: the resin Y2 has a group that decreases polarity due to action of exposure, acid, base, or heating,
Requirement B2: the resin Y2 has an interactive group that forms an interaction with an onium salt compound and that is released from the interaction due to action of exposure, acid, base, or heating, and the composition further includes an onium salt compound,
Requirement B3: the resin Y2 has a polar group, and the composition further includes a compound that reacts with the polar group due to action of exposure, acid, base, or heating.

6. The pattern forming method according to claim 5, wherein the group that decreases polarity is a group that decreases polarity due to action of acid.

7. The pattern forming method according to claim 6, wherein the group that decreases polarity is a functional group represented by Formula (KD1) below, a monovalent functional group formed by removing one hydrogen atom that one or more of $R^{d5}$ to $R^{d10}$ in a compound represented by Formula (KD2) below have, or a monovalent functional group formed by removing one hydrogen atom that a ring member atom has in any of a ring formed by bonding $R^{d6}$ and $R^{d7}$ together and a ring formed by bonding $R^{d8}$ and $R^{d9}$ together in the compound represented by Formula (KD2) below,

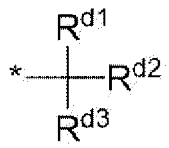
(KD1)

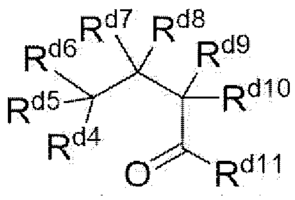
(KD2)

in Formula (KD1) above, $R^{d1}$ and $R^{d2}$ represent an organic group including a hydrogen atom; $R^{d1}$ and $R^{d2}$ may be bonded together to form an alicyclic ring; $R^{d3}$ represents a group that can leave as $R^{d3}H$ upon addition of a hydrogen atom due to action of acid; and * represents a bonding site, and
in Formula (KD2) above, $R^{d4}$ represents $-OR^T$, $-NR^TR^U$, or $-SR^T$; where $R^T$ represents a hydrogen atom or an organic group that leaves due to action of acid, and $R^U$ represents a hydrogen atom or an organic group; $R^{d11}$ represents a group that can leave as $R^{d11}H$ upon addition of a hydrogen atom; $R^{d5}$ to $R^{d10}$ each independently represent a hydrogen atom or a substituent; $R^{d6}$ and $R^{d7}$, and $R^{d8}$ and $R^{d9}$ may be bonded together to form a ring; when $R^{d6}$ and $R^{d7}$ are bonded together to form an aromatic ring, $R^{d5}$ and $R^{d8}$ each serve as a direct bond; and when $R^{d8}$ and $R^{d9}$ are bonded together to form an aromatic ring, $R^{d7}$ and $R^{d10}$ each serve as a direct bond, provided that, in the compound represented by Formula (KD2) above, at least one of $R^{d5}$ to $R^{d10}$ represents a hydrogen atom, or $R^{d6}$ and $R^{d7}$ are bonded together to form a ring or $R^{d8}$ and $R^{d7}$ are bonded together to form a ring, and an atom that constitutes the ring has one or more hydrogen atoms.

8. The pattern forming method according to claim 6, wherein the group that decreases polarity is an acid-decomposable group having a structure in which a polar group is protected with a protective group that leaves due to action of acid, and a logP of the acid-decomposable group is smaller than a logP of the polar group.

9. The pattern forming method according to claim 5, wherein the interactive group is one or more functional groups selected from the group consisting of a phenolic hydroxy group, a carboxyl group, a sulfonic group, an amide group, and a sulfonamide group.

10. The pattern forming method according to claim 5, wherein the polar group is one or more functional groups selected

from the group consisting of an alcoholic hydroxy group, a phenolic hydroxy group, and a carboxyl group.

**11.** The pattern forming method according to claim 10, wherein the compound that reacts with the polar group is a compound selected from the group consisting of a tertiary alcohol, a tertiary ether, an epoxide, a vinyl ether, an olefin, a benzyl ether, benzyl alcohol, and a carboxylic acid.

**12.** The pattern forming method according to claim 5, wherein the group that decreases polarity is an onium salt group that is decomposed due to action of exposure, the onium salt group being selected from the group consisting of a group represented by Formula (O1) below and a group represented by Formula (O2) below,

$*\text{-}X_A^{n-}\ nMa^+$ Formula (O1)

$*\text{-}M_B^+\ X_B^-$ Formula (O2)

in Formula (O1), $X_A^{n-}$ represents a monovalent anionic group having a charge number of n, $Ma^+$ represents an organic cation; n represents 1 or 2; and * represents a bonding site, and
in Formula (O2), $M_B^+$ represents a monovalent organic cationic group; $X_B^-$ represents an organic anion; and * represents a bonding site.

**13.** The pattern forming method according to claim 5, wherein the resin X1 includes a repeating unit represented by Formula (XP) below and a repeating unit represented by Formula (XQ) below,

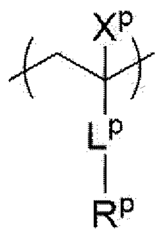
(XP)

in Formula (XP), $X^p$ represents a halogen atom; $L^p$ represents a single bond or a divalent linking group; and $R^p$ represents a substituent, and

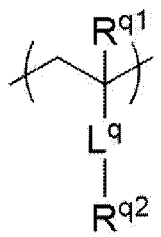
(XQ)

in Formula (XQ), $R^{q1}$ represents an alkyl group that may have a substituent; $L^q$ represents a single bond or a divalent linking group; and $R^{q2}$ represents a substituent,
provided that at least one of the substituent represented by $R^p$ in Formula (XP) or the substituent represented by $R^{q2}$ in Formula (XQ) has one or more groups selected from the group consisting of the group that decreases polarity, the interactive group, and the polar group.

**14.** The pattern forming method according to claim 5, wherein the resin X1 includes a moiety represented by Formula (XRO) below in a main chain structure,

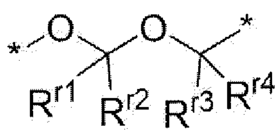
(XR0)

in Formula (XR0), $R^{r1}$ to $R^{r4}$ each independently represent a hydrogen atom or a substituent; $R^{r2}$ and $R^{r3}$ may be bonded together to form a ring; and * represents a bonding site, provided that at least one or more of $R^{r1}$ to $R^{r4}$ in Formula (XRO) represent substituents and at least one or more of the substituents have one or more groups selected from the group consisting of the group that decreases polarity, the interactive group, and the polar group, or $R^{r2}$ and $R^{r3}$ in Formula (XRO) are bonded together to form a ring and at least one or more of substituents on the ring have one or more groups selected from the group consisting of the group that decreases polarity, the interactive group, and the polar group.

**15.** The pattern forming method according to claim 14, wherein the resin X1 includes a repeating unit represented by Formula (XR) below,

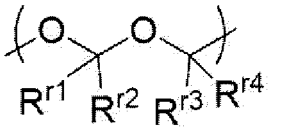
(XR)

in Formula (XR), $R^{r1}$ to $R^{r4}$ each independently represent a hydrogen atom or a substituent; and $R^{r2}$ and $R^{r3}$ may be bonded together to form a ring,
provided that at least one or more of $R^{r1}$ to $R^{r4}$ in Formula (XR) represent substituents and at least one or more of the substituents have one or more groups selected from the group consisting of the group that decreases polarity, the interactive group, and the polar group, or $R^{r2}$ and $R^{r3}$ in Formula (XR) are bonded together to form a ring and at least one or more of substituents on the ring have one or more groups selected from the group consisting of the group that decreases polarity, the interactive group, and the polar group.

**16.** The pattern forming method according to claim 5, wherein the resin X1 includes a repeating unit represented by Formula (XS) below,

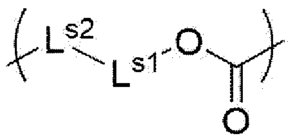
(XS)

in Formula (XS), $L^{s1}$ represents a linking group represented by *-C($R^{s1}$)($R^{s2}$)-*, where $R^{s1}$ and $R^{s2}$ each independently represent a hydrogen atom or a monovalent organic group, and * represents a bonding site, provided that at least one of $R^{s1}$ or $R^{s2}$ represents a monovalent organic group, and $L^{s2}$ represents a single bond or a divalent linking group, provided that at least one or more of the monovalent organic group represented by $R^{s1}$ and $R^{s2}$ or the divalent linking group represented by $L^{s2}$ in Formula (XS) have one or more groups selected from the group consisting of the group that decreases polarity, the interactive group, and the polar group.

**17.** A method for producing an electronic device, the method comprising the pattern forming method according to claim 1 or 2.

## INTERNATIONAL SEARCH REPORT

International application No.
**PCT/JP2022/027257**

**A. CLASSIFICATION OF SUBJECT MATTER**

***C08F 12/02***(2006.01)i; ***C08F 20/18***(2006.01)i; ***G03F 7/038***(2006.01)i; ***G03F 7/039***(2006.01)i; ***G03F 7/20***(2006.01)i
FI: G03F7/038 601; G03F7/039 601; G03F7/20 501; G03F7/20 521; C08F12/02; C08F20/18

According to International Patent Classification (IPC) or to both national classification and IPC

**B. FIELDS SEARCHED**

Minimum documentation searched (classification system followed by classification symbols)

C08F12/02; C08F20/18; G03F7/038; G03F7/039; G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2017-146521 A (SHIN-ETSU CHEMICAL CO., LTD.) 24 August 2017 (2017-08-24) examples | 1-4, 17<br>5-16 |
| X<br>A | WO 2017/002737 A1 (FUJIFILM CORPORATION) 05 January 2017 (2017-01-05) examples | 1-4, 17<br>5-16 |
| X<br>A | JP 2018-081307 A (FUJIFILM CORPORATION) 24 May 2018 (2018-05-24) examples | 1-3, 17<br>4-16 |

☐ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 September 2022** | **27 September 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (January 2015)

**INTERNATIONAL SEARCH REPORT**
**Information on patent family members**

International application No.
**PCT/JP2022/027257**

| Patent document cited in search report | Publication date (day/month/year) | Patent family member(s) | Publication date (day/month/year) |
|---|---|---|---|
| JP 2017-146521 A | 24 August 2017 | US 2017/0242339 A1<br>examples<br>KR 10-2017-0098186 A<br>TW 201731888 A | |
| WO 2017/002737 A1 | 05 January 2017 | US 2018/0120705 A1<br>examples<br>KR 10-2018-0014011 A<br>TW 201708977 A | |
| JP 2018-081307 A | 24 May 2018 | TW 201821605 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017002737 A
- JP 2014059543 A
- JP 2013061648 A
- JP 2009267112 A
- WO 2018193954 A
- WO 2020066824 A
- WO 2017154345 A
- US 20160070167 A1
- US 20150004544 A1
- US 20160237190 A1
- US 20160274458 A1
- WO 2020004306 A


### Non-patent literature cited in the description


- *Proceedings of International Society for Optics and Photonics (Proc. of SPIE),* 2008, vol. 6924, 692420
- Chapter 4 Etching'' of ''Semiconductor Process Textbook. SEMI Japan, 2007
- *Materials Letters,* 2008, vol. 62, 3152
- Prediction of polymer properties. Marcel Dekker Inc, 1993